(19) Europäisches Patentamt
European Patent Office
Office européen des brevets

(11) EP 3 306 694 B1

(12) **EUROPEAN PATENT SPECIFICATION**

(45) Date of publication and mention of the grant of the patent:
**12.08.2020 Bulletin 2020/33**

(21) Application number: **16803130.0**

(22) Date of filing: **24.05.2016**

(51) Int Cl.:
***H01L 51/50*** *(2006.01)*
***C08G 61/10*** *(2006.01)*
***C09K 11/06*** *(2006.01)*
***H05B 33/10*** *(2006.01)*
***H05B 33/26*** *(2006.01)*

(86) International application number:
**PCT/JP2016/065248**

(87) International publication number:
**WO 2016/194695 (08.12.2016 Gazette 2016/49)**

(54) **LIGHT-EMITTING ELEMENT AND METHOD FOR MANUFACTURING SAME**

LICHTEMITTIERENDES ELEMENT UND VERFAHREN ZUR HERSTELLUNG DAVON

ÉLÉMENT ÉLECTROLUMINESCENT ET SON PROCÉDÉ DE FABRICATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.05.2015 JP 2015109512**

(43) Date of publication of application:
**11.04.2018 Bulletin 2018/15**

(73) Proprietor: **Sumitomo Chemical Company, Ltd.**
**Chuo-ku**
**Tokyo 104-8260 (JP)**

(72) Inventors:
- **IIJIMA, Takayuki**
**Tsukuba-shi**
**Ibaraki 300-3294 (JP)**
- **TANAKA, Masanobu**
**Tsukuba-shi**
**Ibaraki 300-3294 (JP)**
- **YAMAMOTO, Kyoko**
**Tsukuba-shi**
**Ibaraki 300-3294 (JP)**

(74) Representative: **J A Kemp LLP**
**14 South Square**
**Gray's Inn**
**London WC1R 5JJ (GB)**

(56) References cited:
**EP-A1- 2 592 671**
**JP-A- 2006 173 588**
**JP-A- 2006 173 588**
**JP-A- 2012 033 845**
**JP-A- 2012 033 918**
**US-B1- 6 653 438**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 306 694 B1

## Description

### Technical Field

The present invention relates to a light emitting device such as an organic electroluminescent device.

### Background Art

For improving the property of a light emitting device, there are investigations on insertion of various layers between a light emitting layer and an electrode. For example, a light emitting device comprising a single-layered electron transporting layer between a light emitting layer and an electrode is known (Patent document 1).
Patent document 2 describes organic electroluminescent devices that have a plurality of organic compound layers between a pair of electrodes, the plurality of organic compound layers comprising: (a) a luminescent layer that includes a luminescent material and a host material; and (b) hole-transporting layers that are made up of two or more layers, including a layer adjacent to the luminescent layer. The luminescent material contains a metal complex having tri- or higher-dentate ligands as a luminescent material. The ionization potential of the luminescent layer is greater than the ionization potentials of the hole-transporting layers, and the ionization potential of the hole-transporting layer in the n-th position as counted from the luminescent layer side decreases as n increases.
Patent document 3 describes an organic electroluminescence element that comprises, in this order: an anode; a luminescent layer containing a luminescent material and a charge transport material; two or more electron transport layers; and a cathode. At least one of the two or more electron transport layers adjoins the luminescent layer, and the electron transport layer which adjoins the luminescent layer contains a charge transport material. There is a particular relationship between: (i) an electron affinity of the charge transport material which serves to transport electrons, among the charge transport materials contained in the luminescent layer; and (ii) an electron affinity of the charge transport material which is the highest in an absolute value of electron affinity, among the charge transport materials contained in the electron transport layer that adjoins the luminescent layer. There is also a particular relationship between: (i) an electron affinity of the charge transport material which is the highest in an absolute value of electron affinity, among the charge transport materials contained in the electron transport layer located on the most cathode side among the two or more electron transport layers; and (ii) a work function of the cathode.

[Prior Art Document]

[Patent Document]

[Patent document 1] Japanese Translation of PCT International Application Publication No. 2003-530676
[Patent document 2] JP 2006 173588 A
[Patent document 3] EP 2 592 671 A1

### Summary of the Invention

### Problem to be Solved by the Invention

However, the luminance of the above-described light emitting device is not sufficient.
Then, the present invention has an object of providing a light emitting device capable of emitting light at high luminance.

### Means for Solving the Problem

The present invention provides the following [1] to [12].

[1] A light emitting device comprising
an anode,
a cathode,
a phosphorescent light emitting layer disposed between the anode and the cathode,
an electron transporting layer (B) disposed between the cathode and the light emitting layer and adjacent to the cathode, and

an electron transporting layer (A) disposed between the light emitting layer and the electron transporting layer (B), wherein

the electron transporting layer (B) comprises an organic compound,

the cathode contains a metal material in an amount of 1% by weight or more, wherein said metal material is Al, Au, Ag, Cu, ZnO, ITO or IZO,

at least one of a compound contained in an amount of 5% by weight or more in the electron transporting layer (A) and a compound contained in an amount of 5% by weight or more in the electron transporting layer (B) is:

(a) an aromatic polymer compound comprising a constitutional unit represented by the following formula (ET-1); or

(b)a compound having an aromatic heterocyclic ring represented by the following formula (H-1);

P (eV) which is the smallest work function of the metal material contained in an amount of 1% by weight or more in the cathode satisfies the formula (1A),

Q (eV) which is the smallest electron affinity of the compound contained in an amount of 5% by weight or more in the light emitting layer satisfies the formula (2A),

P (eV), Q (eV), RA (eV) which is the smallest electron affinity of the compound contained in an amount of 5% by weight or more in the electron transporting layer (A) and RB (eV) which is the smallest electron affinity of the compound contained in an amount of 5% by weight or more in the electron transporting layer (B) satisfy the formula (3A) and the formula (4A),

wherein the electron affinity of a compound is determined by subtracting the value of energy (eV) of the absorption edge at the longer wavelength side of the absorption wavelength of the compound from the value of ionization potential (eV) of the compound,

the absorption wavelength of a compound is obtained by measuring with an ultraviolet·visible·near infrared spectrometer,

the ionization potential (eV) of a compound is measured by a photoelectron spectrometer in the air, and the work function of a metal is measured by a photoelectron spectrometer in the air, and

the phosphorescent light emitting layer comprises an iridium complex represented by the formula Ir-1, Ir-2, Ir-3, Ir-4 or Ir-5:

$$P > 3.5 \qquad (1A)$$

$$Q < 2.7 \qquad (2A)$$

$$P > RB > Q \qquad (3A)$$

$$RB > RA \qquad (4A):$$

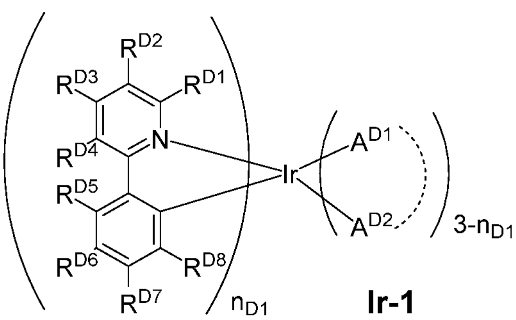

Ir-1

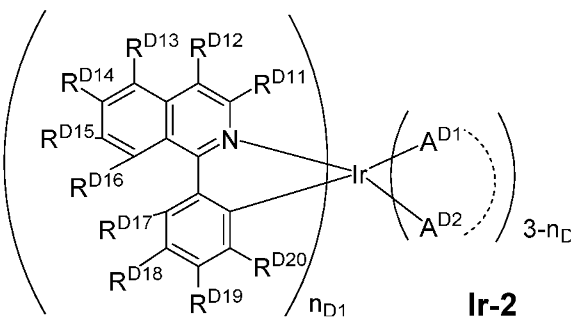

Ir-2

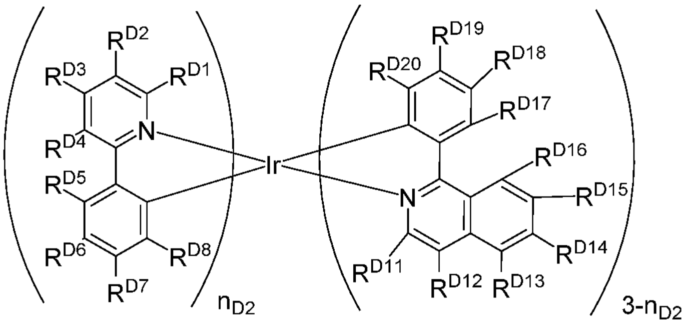

**Ir-3**

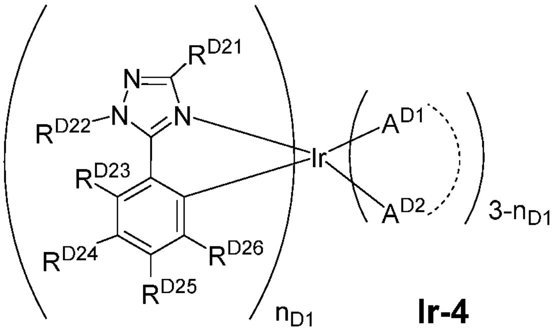

**Ir-4**

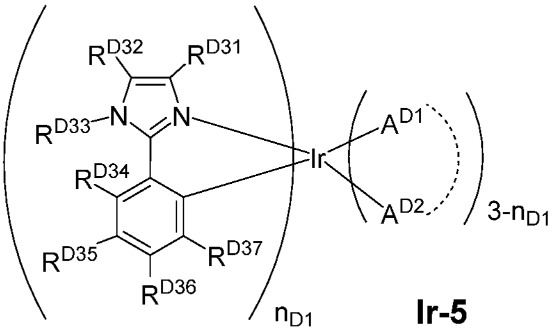

**Ir-5**

wherein

$R^{D1}$ to $R^{D8}$, $R^{D11}$ to $R^{D20}$, $R^{D21}$ to $R^{D26}$ and $R^{D31}$ to $R^{D37}$ each independently represent a hydrogen atom, an alkyl group, a cycloalkyl group, an alkoxy group, a cycloalkoxy group, an aryl group, an aryloxy group, a monovalent heterocyclic group or a halogen atom and these groups each optionally have a substituent, and when a plurality of $R^{D1}$ to $R^{D8}$, $R^{D11}$ to $R^{D20}$, $R^{D21}$ to $R^{D26}$ and $R^{D31}$ to $R^{D37}$ are present, they may be the same or different at each occurrence,

$-A^{D1}$---$A^{D2}$ - represents an anionic bidentate ligand, and $A^{D1}$ and $A^{D2}$ each independently represent a carbon atom, an oxygen atom or a nitrogen atom linking to an iridium atom and these atoms each may be an atom consisting a ring, and when a plurality of $-A^{D1}$---$A^{D2}$- are present, they may be the same or different,

$n_{D1}$ represents 1, 2 or 3, and $n_{D2}$ represents 1 or 2, and

provided that at least one of $R^{D1}$ to $R^{D8}$ in the formula Ir-1 is a group represented by the formula (D-A), at least one of $R^{D11}$ to $R^{D20}$ in the formula Ir-2 is a group represented by the formula (D-A), and at least one of $R^{D1}$ to $R^{D8}$ and $R^{D11}$ to $R^{D20}$ in the formula Ir-3 is a group represented by the formula (D-A) :

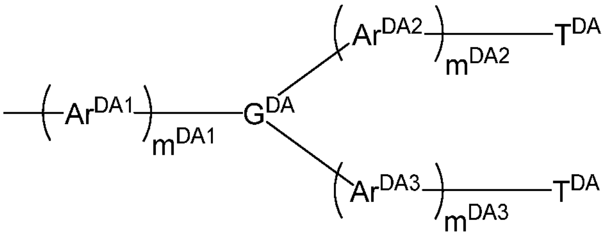

**(D-A)**

wherein

$m^{DA1}$, $m^{DA2}$ and $m^{DA3}$ each independently represent an integer of 0 or more,

$G^{DA}$ represents a nitrogen atom, an aromatic hydrocarbon group or a heterocyclic group and these groups each optionally have a substituent,

$Ar^{DA1}$, $Ar^{DA2}$ and $Ar^{DA3}$ each independently represent an arylene group or a divalent heterocyclic group and these groups each optionally have a substituent, and when a plurality of $Ar^{DA1}$, $Ar^{DA2}$ and $Ar^{DA3}$ are present, they may be the same or different at each occurrence, and

$T^{DA}$ represents an aryl group or a monovalent heterocyclic group and these groups each optionally have a substituent, and the plurality of $T^{DA}$ may be the same or different:

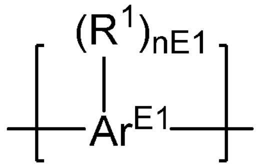

(ET-1)

wherein

$R^1$ represents a group represented by the formula (2), the formula (3) or the formula (4), and when a plurality of $R^1$ are present, they may be the same or different,
nE1 represents an integer of 1 or more,
$Ar^{E1}$ represents an aromatic hydrocarbon group or a heterocyclic group, and
the constitutional unit represented by the formula (ET-1) optionally has a substituent other than $R^1$:

$$-R^3-\{(Q^1)_{n1}-Y^1(M^1)_{a1}(Z^1)_{b1}\}_{m2} \qquad (2)$$

wherein

$R^3$ represents a single bond, a hydrocarbon group, a heterocyclic group or $-O-R^{3'}$, wherein $R^{3'}$ represents a hydrocarbon group or a heterocyclic group, and these groups each optionally have a substituent,
$Q^1$ represents an alkylene group, a cycloalkylene group, an arylene group, an oxygen atom or a sulfur atom and these groups each optionally have a substituent, and when a plurality of $Q^1$ are present, they may be the same or different,
$Y^1$ represents $-CO_2^-$, $-SO_3^-$, $-SO_2^-$ or $-PO_3^{2-}$, and when a plurality of $Y^1$ are present, they may be the same or different,
$M^1$ represents an alkali metal cation, an alkaline earth metal cation or an ammonium cation and this ammonium cation optionally has a substituent, and when a plurality of $M^1$ are present, they may be the same or different,
$Z^1$ represents $F^-$, $Cl^-$, $Br^-$, $I^-$, $OH^-$, $B(R^{aa})_4^-$, $R^{aa}SO_3^-$, $R^{aa}COO^-$, $NO_3^-$, $SO_4^{2-}$, $HSO_4^-$, $PO_4^{3-}$, $HPO_4^{2-}$, $H_2PO_4^-$, $BF_4^-$ or $PF_6^-$, and $R^{aa}$ represents an alkyl group, a cycloalkyl group or an aryl group and these groups each optionally have a substituent, and when a plurality of $Z^1$ are present, they may be the same or different, and
n1 represents an integer of 0 or more, a1 represents an integer of 1 or more, b1 represents an integer of 0 or more and m2 represents an integer of 1 or more, and when a plurality of n1, a1 and b1 are present, they may be the same or different at each occurrence, and m2 is 1 when $R^3$ is a single bond, and a1 and b1 are selected in such a manner that the electric charge of the group represented by the formula (2) is 0:

$$-R^4-\{(Q^2)_{n2}-Y^2(M^2)_{a2}(Z^2)_{b2}\}_{m3} \qquad (3)$$

wherein

$R^4$ represents a single bond, a hydrocarbon group, a heterocyclic group or $-O-R^{4'}$, wherein $R^{4'}$ represents a hydrocarbon group or a heterocyclic group, and these groups each optionally have a substituent,
$Q^2$ represents an alkylene group, a cycloalkylene group, an arylene group, an oxygen atom or a sulfur atom and these groups each optionally have a substituent, and when a plurality of $Q^2$ are present, they may be the same or different,
$Y^2$ represents $-C^+R^c2$, $-N^+R^c3$, $-P^+R^c3$, $-S^+R^c_2$ or $-I^+R^c_2$, and $R^c$ represents an alkyl group, a cycloalkyl group or an aryl group and these groups each optionally have a substituent, and the plurality of $R^c$ may be the same or different, and when a plurality of $Y^2$ are present, they may be the same or different,
$M^2$ represents $F^-$, $Cl^-$, $Br^-$, $I^-$, $OH^-$, $B(R^b)_4^-$, $R^bSO_3^-$, $R^bCOO^-$, $BF_4^-$, $SbCl_6^-$ or $SbF_6^-$, and $R^b$ represents an alkyl group, a cycloalkyl group or an aryl group and these groups optionally have a substituent, and when a plurality of $R^b$ are present, they may be the same or different, and when a plurality of $M^2$ are present, they may be the same or different,

$Z^2$ represents an alkali metal cation or an alkaline earth metal cation, and when a plurality of $Z^2$ are present, they may be the same or different, and
n2 represents an integer of 0 or more, a2 represents an integer of 1 or more, b2 represents an integer of 0 or more and m3 represents an integer of 1 or more, and when a plurality of n2, a2 and b2 are present, they may be the same or different at each occurrence, and m3 is 1 when $R^4$ is a single bond, and a2 and b2 are selected in such a manner that the electric charge of the group represented by the formula (3) is 0:

$$-R^5-\{(Q^3)_{n3}-Y^3\}_{m4} \qquad (4)$$

wherein

$R^5$ represents a single bond, a hydrocarbon group, a heterocyclic group or $-O-R^{5'}$, wherein $R^{5'}$ represents a hydrocarbon group or a heterocyclic group, and these groups each optionally have a substituent,
$Q^3$ represents an alkylene group, a cycloalkylene group, an arylene group, an oxygen atom or a sulfur atom and these groups each optionally have a substituent, and when a plurality of $Q^3$ are present, they may be the same or different,
$Y^3$ represents a group represented by the formula (5) or the formula (6), and when a plurality of $Y^3$ are present, they may be the same or different, and
n3 represents an integer of 0 or more, and m4 represents an integer of 1 or more, and when a plurality of n3 are present, they may be the same or different, and when $R^5$ is a single bond, m4 is 1:

$$-O-(R'O)_3-R'' \qquad (5)$$

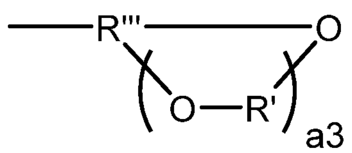

(6)

wherein

R' represents an alkylene group, a cycloalkylene group or an arylene group and these groups each optionally have a substituent, and when a plurality of R' are present, they may be the same or different,
R" represents a hydrogen atom, an alkyl group, a cycloalkyl group or an aryl group and these groups each optionally have a substituent,
R"' represents a hydrocarbon group and this hydrocarbon group optionally has a substituent, and
a3 represents an integer of 1 or more:

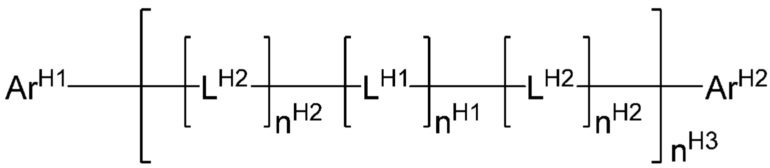

**(H-1)**

wherein

$A_r^{H1}$ and $Ar^{H2}$ each independently represent an aryl group or a monovalent heterocyclic group and these groups each optionally have a substituent,
$n^{H1}$ and $n^{H2}$ each independently represent 0 or 1, and when a plurality of $n^{H1}$ are present, they may be the same or different, and the plurality of $n^{H2}$ may be the same or different,

$n^{H3}$ represents an integer of 0 or more,
$L^{H1}$ represents an arylene group, a divalent heterocyclic group or a group represented by $-[C(R^{H11})_2]n^{H11}-$ and these groups each optionally have a substituent, and when a plurality of $L^{H1}$ are present, they may be the same or different,
$n^{H11}$ represents an integer of 1 or more and 10 or less, and $R^{H11}$ represents a hydrogen atom, an alkyl group, a cycloalkyl group, an alkoxy group, a cycloalkoxy group, an aryl group or a monovalent heterocyclic group and these groups each optionally have a substituent, and the plurality of $R^{H11}$ may be the same or different and may be combined together to form a ring together with the carbon atoms to which they are attached,
$L^{H2}$ represents a group represented by $-N(-L^{H21}-R^{H21})-$, and when a plurality of $L^{H2}$ are present, they may be the same or different, and
$L^{H21}$ represents a single bond, an arylene group or a divalent heterocyclic group and these groups each optionally have a substituent, and $R^{H21}$ represents a hydrogen atom, an alkyl group, a cycloalkyl group, an aryl group or a monovalent heterocyclic group and these groups each optionally have a substituent.

[2] The light emitting device according to [1], wherein RB (eV) and RA (eV) satisfy the following formula (5A):

$$RB - RA \geq 0.2 \qquad (5A).$$

[3] The light emitting device according to [1] or [2], wherein Q (eV) and RA (eV) satisfy the following formula (6A) :

$$RA - Q \geq 0.2 \qquad (6A).$$

[4] The light emitting device according to [1], wherein the group represented by the formula (2) is a group represented by the formula (2'):

$$\begin{array}{l} -R^{6}-\{(Q^{1})_{n1}-Y^{1}(M^{1})_{a1}(Z^{1})_{b1}\}_{m2} \\ \quad | \\ \{(Q^{3})_{n3}-Y^{3}\}_{m4} \end{array} \qquad (2')$$

[wherein,

$R^6$ represents an aromatic hydrocarbon group or a heterocyclic group, and these groups each optionally have a substituent.
n1, a1, b1, m2, $Q^1$, $Y^1$, $M^1$, $Z^1$, n3, m4, $Q^3$ and $Y^3$ represent the same meaning as described above.].

[5] The light emitting device according to [1], wherein the group represented by the formula (3) is a group represented by the formula (3'):

$$\begin{array}{l} -R^{7}-\{(Q^{2})_{n2}-Y^{2}(M^{2})_{a2}(Z^{2})_{b2}\}_{m3} \\ \quad | \\ \{(Q^{3})_{n3}-Y^{3}\}_{m4} \end{array} \qquad (3')$$

[wherein,

$R^7$ represents an aromatic hydrocarbon group or a heterocyclic group, and these groups optionally have a substituent.
n2, a2, b2, m3, $Q^2$, $Y^2$, $M^2$, $Z^2$, n3, m4, $Q^3$ and $Y^3$ represent the same meaning as described above.].

[6] The light emitting device according to [1], wherein the compound represented by the formula (H-1) is a compound represented by the formula (H-2):

$$Ar^{H1}\text{—}\left[L^{H1}\right]_{n^{H3}}\text{—}Ar^{H2} \qquad \textbf{(H-2)}$$

[wherein, $Ar^{H1}$, $Ar^{H2}$, $n^{H3}$ and $L^{H1}$ represent the same meaning as described above.].

[7] A production method of the light emitting device according to [1], comprising a step of forming at least one selected from the group consisting of an electron transporting layer (A), an electron transporting layer (B) and a cathode by application.

Effect of the Invention

The light emitting device of the present invention is capable of emitting light at high luminance.

Modes for Carrying Out the Invention

Suitable embodiments of the present invention will be illustrated in detail below.

<Explanation of common term>

Terms commonly used in the present specification have the following meanings unless otherwise stated.

Me represents a methyl group, Et represents an ethyl group, Bu represents a butyl group, i-Pr represents an isopropyl group, and t-Bu represents a tert-butyl group.

A hydrogen atom may be a heavy hydrogen atom or a light hydrogen atom.

A solid line representing a bond to a central metal in a formula representing a metal complex denotes a covalent bond or a coordinate bond.

"Polymer compound" denotes a polymer having molecular weight distribution and having a polystyrene-equivalent number average molecular weight of $1\times10^3$ to $1\times10^8$.

A polymer compound may be any of a block copolymer, a random copolymer, an alternating copolymer and a graft copolymer, and may also be another embodiment.

An end group of a polymer compound is preferably a stable group because if a polymerization active group remains intact at the end, when the polymer compound is used for fabrication of a light emitting device, the light emitting property or luminance life possibly becomes lower. This end group is preferably a group having a conjugated bond to the main chain, and includes, for example, groups bonding to an aryl group or a monovalent heterocyclic group via a carbon-carbon bond.

"Low molecular weight compound" denotes a compound having no molecular weight distribution and having a molecular weight of $1\times10^4$ or less.

"Constitutional unit" denotes a unit structure found once or more in a polymer compound.

"Alkyl group" may be any of linear or branched. The numb er of carbon atoms of the linear alkyl group is, not includi ng the number of carbon atoms of a substituent, usually 1 to 50, preferably 3 to 30, more preferably 4 to 20. The number of carbon atoms of the branched alkyl groups is, not includi ng the number of carbon atoms of a substituent, usually 3 to 50, preferably 3 to 30, more preferably 4 to 20.

The alkyl group optionally has a substituent, and exampl es thereof include a methyl group, an ethyl group, a propyl group, an isopropyl group, a butyl group, a 2-butyl group, a n isobutyl group, a tert-butyl group, a pentyl group, an iso amyl group, a 2-ethylbutyl group, a hexyl group, a heptyl gr oup, an octyl group, a 2-ethylhexyl group, a 3-propylheptyl group, a decyl group, a 3,7-dimethyloctyl group, a 2-ethyloc tyl group, a 2-hexyldecyl group and a dodecyl group, and gro ups obtained by substituting a hydrogen atom in these groups with a cycloalkyl group, an alkoxy group, a cycloalkoxy gro up, an aryl group, a fluorine atom or the like, and the alkyl group having a substituent includes, for example, a trifluo romethyl group, a pentafluoroethyl group, a perfluorobutyl g roup, a perfluorohexyl group, a perfluorooctyl group, a 3-ph enylpropyl group, a 3-(4-methylphenyl)propyl group, a 3-(3,5 -di- hexylphenyl) propyl group and a 6-ethyloxyhexyl group.

The number of carbon atoms of "Cycloalkyl group" is, not including the number of carbon atoms of a substituent, usual ly 3 to 50, preferably 3 to 30, more preferably 4 to 20.

The cycloalkyl group optionally has a substituent, and e xamples thereof include a cyclohexyl group, a cyclohexylmeth yl group and a cyclohexylethyl group.

"Aryl group" denotes an atomic group remaining after rem oving from an aromatic hydrocarbon one hydrogen atom linked directly to a carbon atom constituting the ring. The number of carbon atoms of the aryl group is, not including the numb er of carbon atoms of a substituent, usually 6 to 60, prefer ably 6 to 20, more preferably 6 to 10.

The aryl group optionally has a substituent, and example s thereof include a phenyl group, a 1-naphthyl group, a 2-na phthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group , a 4-fluorenyl group, a 2-phenylphenyl group, a 3-phenylphe nyl group, a 4-phenylphenyl group, and groups obtained by su bstituting a hydrogen atom in these groups with an alkyl gro up, a cycloalkyl group, an alkoxy group, a cycloalkoxy group , an aryl group, a fluorine atom or the like.

"Alkoxy group" may be any of linear or branched. The num ber of carbon atoms of the linear alkoxy group is, not inclu ding the number of carbon atoms of a substituent, usually 1 to 40, preferably 4 to 10. The number of carbon atoms of the branched alkoxy group is, not including the number of carbo n atoms of a substituent, usually 3 to 40, preferably 4 to 10.

The alkoxy group optionally has a substituent, and examp les thereof include a methoxy group, an ethoxy group, a prop yloxy group, an isopropyloxy group, a butyloxy group, an iso butyloxy group, a tert-butyloxy group, a pentyloxy group, a hexyloxy group, a heptyloxy group, an octyloxy group, a 2-et hylhexyloxy group, a nonyloxy group, a decyloxy group, a 3,7 -dimethyloctyloxy group and a lauryloxy group, and groups ob tained by substituting a hydrogen atom in these groups with a cycloalkyl group, an alkoxy group, a cycloalkoxy group, an aryl group, a fluorine atom or the like.

The number of carbon atoms of "Cycloalkoxy group" is, not including the number of carbon atoms of a substituent, usua lly 3 to 40, preferably 4 to 10.

The cycloalkoxy group optionally has a substituent, and examples thereof include a cyclohexyloxy group.

The number of carbon atoms of "Aryloxy group" is, not inc luding the number of carbon atoms of a substituent, usually 6 to 60, preferably 7 to 48.

The aryloxy group optionally has a substituent, and exam ples thereof include a phenoxy group, a 1-naphthyloxy group, a 2-naphthyloxy group, a 1-anthracenyloxy group, a 9-anthra cenyloxy group, a 1-pyrenyloxy group, and groups obtained by substituting a hydrogen atom in these groups with an alkyl group, a cycloalkyl group, an alkoxy group, a cycloalkoxy gr oup, a fluorine atom or the like.

"p-Valent heterocyclic group" (p represents an integer ○ f 1 or more) denotes an atomic group remaining after removin g from a heterocyclic compound p hydrogen atoms among hydrog en atoms directly linked to a carbon atom or a hetero atom co nstituting the ring. Of p-valent heterocyclic groups, "p-va lent aromatic heterocyclic groups" as an atomic group remain ing after removing from an aromatic heterocyclic compound p hydrogen atoms among hydrogen atoms directly linked to a car bon atom or a hetero atom constituting the ring are preferab le.

"Aromatic heterocyclic compound" denotes a compound in w hich the heterocyclic ring itself shows aromaticity such as oxadiazole, thiadiazole, thiazole, oxazole, thiophene, pyrr ole, phosphole, furan, pyridine, pyrazine, pyrimidine, triaz ine, pyridazine, quinoline, isoquinoline, carbazole and dibe nzophosphole, and a compound in which an aromatic ring is co ndensed to the heterocyclic ring even if the heterocyclic ri ng itself shows no aromaticity such as phenoxazine, phenothi azine, dibenzoborole, dibenzosilole and benzopyran.

The number of carbon atoms of the monovalent heterocycli c group is, not including the number of carbon atoms of a sub stituent, usually 2 to 60, preferably 4 to 20.

The monovalent heterocyclic group optionally has a subst ituent, and examples thereof include a thienyl group, a pyrr olyl group, a furyl group, a pyridyl group, a piperidyl grou p, a quinolinyl group, an isoquinolinyl group, a pyrimidinyl group, a triazinyl group, and groups obtained by substituti ng a hydrogen atom in these groups with an alkyl group, a cyc loalkyl group, an alkoxy group, a cycloalkoxy group or the 1 ike.

"Halogen atom" denotes a fluorine atom, a chlorine atom, a bromine atom or an iodine atom.

"Amino group" optionally has a substituent, and a substi tuted amino group is preferable. The substituent which an a mino group has is preferably an alkyl group, a cycloalkyl gr oup, an aryl group or a monovalent heterocyclic group.

The substituted amino group includes, for example, a dia lkylamino group, a dicycloalkylamino group and a diarylamino group.

The amino group includes, for example, a dimethylamino g roup, a diethylamino group, a diphenylamino group, a bis(4-m ethylphenyl) amino group, a bis(4-tert-butylphenyl)amino gro up and a bis(3,5-di-tert-butylphenyl)amino group.

"Alkenyl group" may be any of linear or branched. The nu mber of carbon atoms of the linear alkenyl group, not includ ing the number of carbon atoms of the substituent, is usuall y 2 to 30, preferably 3 to 20. The number of carbon atoms of the branched alkenyl group, not including the number of car bon atoms of the substituent, is usually 3 to 30, preferably 4 to 20.

The number of carbon atoms of "Cycloalkenyl group", not i ncluding the number of carbon atoms of the substituent, is u sually 3 to 30, preferably 4 to 20.

The alkenyl group and cycloalkenyl group each optionally have a substituent, and examples thereof include a vinyl gr oup, a 1-propenyl group, a 2-propenyl group, a 2-butenyl gro up, a 3-butenyl group, a 3-pentenyl group, a 4-pentenyl grou p, a 1-hexenyl group, a 5-hexenyl group, a 7-octenyl group, and these groups having a substituent.

"Alkynyl group" may be any of linear or branched. The nu mber of carbon atoms of the alkynyl group, not including the number of carbon atoms of the substituent, is usually 2 to 2 0, preferably 3 to 20. The number of carbon atoms of the bra nched alkynyl group, not including the number of carbon atom s of the substituent, is usually 4 to 30, preferably 4 to 20.

The number of carbon atoms of "Cycloalkynyl group", not i ncluding the number of carbon atoms of the substituent, is u sually 4 to 30, preferably 4 to 20.

The alkynyl group and cycloalkynyl group each optionally have a substituent, and examples thereof include an ethynyl group, a 1-propynyl group, a 2-propynyl group, a 2-butynyl group, a 3-butynyl group, a 3-pentynyl group, a 4-pentynyl g roup, a 1-hexynyl group, a 5-hexynyl group, and these groups having a substituent.

"Arylene group" denotes an atomic group remaining after removing from an aromatic hydrocarbon two hydrogen atoms lin ked directly to carbon atoms constituting the ring. The num ber of carbon atoms of the arylene group is, not including t he number of carbon atoms of a substituent, usually 6 to 60, preferably 6 to 30, more preferably 6 to 18.

The arylene group optionally has a substituent, and exam ples thereof include a phenylene group, a naphthalenediyl gr oup, an anthracenediyl group, a phenanthrenediyl group, a di hydrophenanthrenediyl group, a naphthacenediyl group, a fluo renediyl group, a pyrenediyl group, a perylenediyl group, a chrysenediyl group, and these groups having a substituent, p referably, groups represented by the formulae (A-1) to (A-20 ). The arylene group includes groups obtained by linking a plurality of these groups.

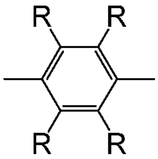
(A-1)

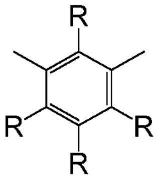
(A-2)

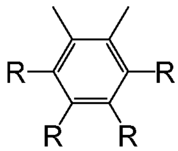
(A-3)

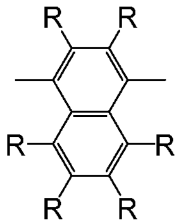
(A-4)

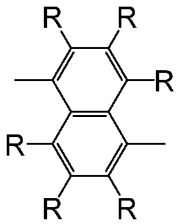
(A-5)

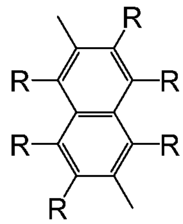
(A-6)

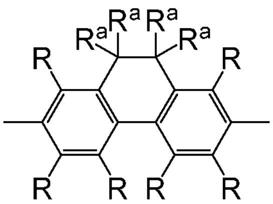
(A-7)

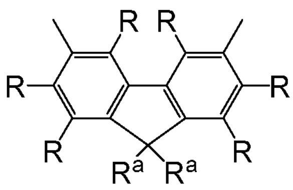
(A-8)

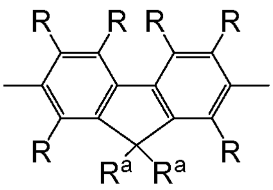
(A-9)

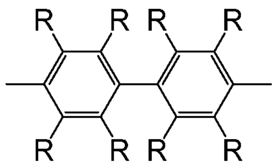
(A-10)

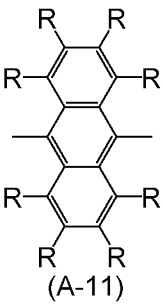
(A-11)

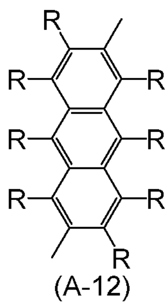
(A-12)

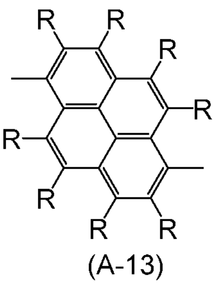
(A-13)

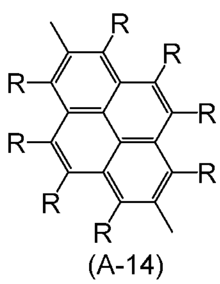
(A-14)

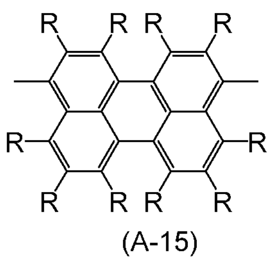
(A-15)

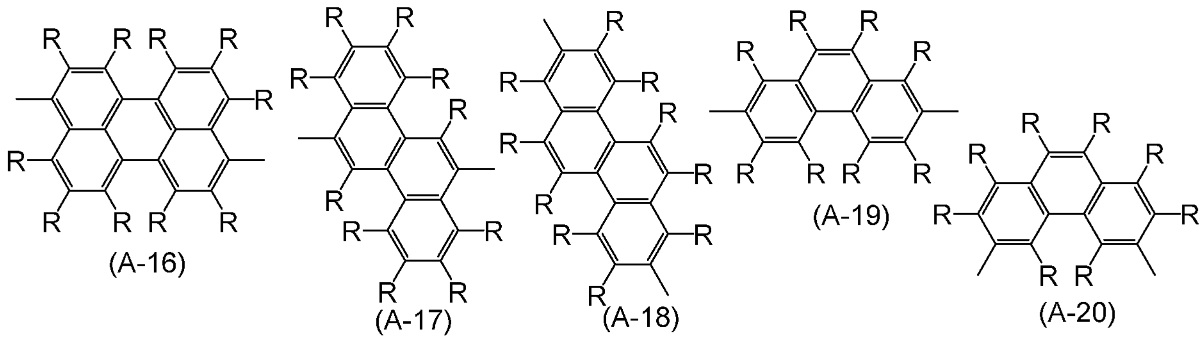

(A-16) (A-17) (A-18) (A-19) (A-20)

[wherein, R and $R^a$ each independently represent a hydrogen atom, an alkyl group, a cycloalkyl group, an aryl group or a monovalent heterocyclic group. The plurality of R and $R^a$ each may be the same or different, and groups $R^a$ may be combined together to form a ring together with the atoms to which they are attached.]

The number of carbon atoms of the divalent heterocyclic group is, not including the number of carbon atoms of a subs tituent, usually 2 to 60, preferably 3 to 20, more preferabl y 4 to 15.

The divalent heterocyclic group optionally has a substit uent, and examples thereof include divalent groups obtained by removing from pyridine, diazabenzene, triazine, azanaphth alene, diazanaphthalene, carbazole, dibenzofuran, dibenzoth iophene, dibenzosilole, phenoxazine, phenothiazine, acridin e, dihydroacridine, furan, thiophene, azole, diazole and tri azole two hydrogen atoms among hydrogen atoms linking direct ly to a carbon atom or a hetero atom constituting the ring, p referably groups represented by the formulae (AA-1) to (AA-3 4). The divalent heterocyclic group includes groups obtaine d by linking a plurality of these groups.

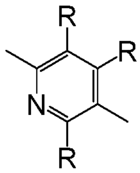
(AA-1)
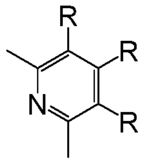
(AA-2)
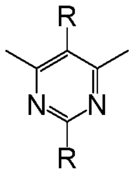
(AA-3)
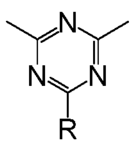
(AA-4)
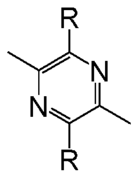
(AA-5)
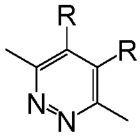
(AA-6)
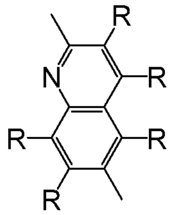
(AA-7)

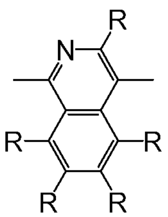
(AA-8)
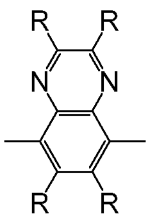
(AA-9)
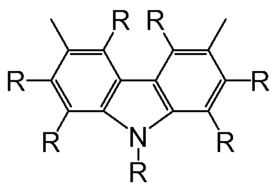
(AA-10)
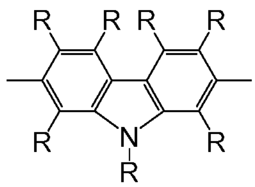
(AA-11)
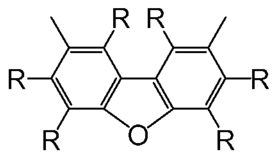
(AA-12)

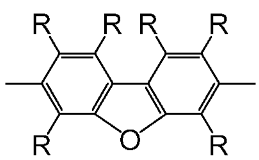
(AA-13)
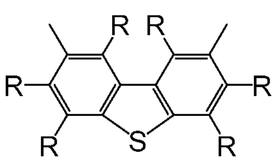
(AA-14)
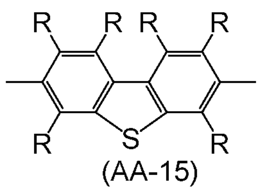
(AA-15)
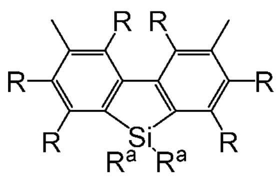
(AA-16)

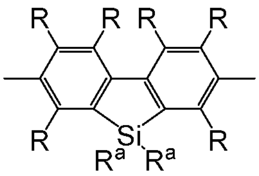
(AA-17)
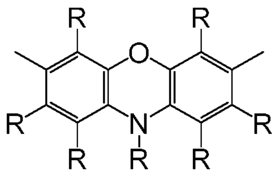
(AA-18)
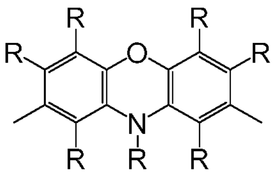
(AA-19)
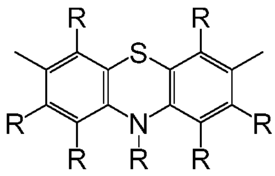
(AA-20)

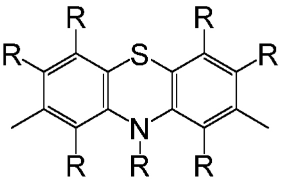
(AA-21)
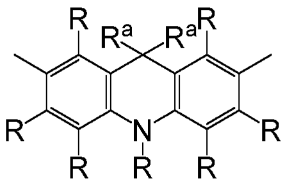
(AA-22)
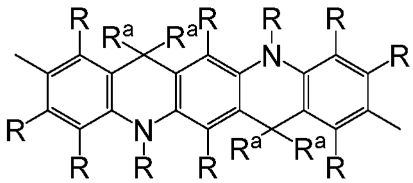
(AA-23)
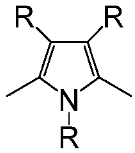
(AA-24)

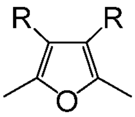
(AA-25)
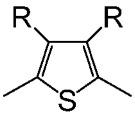
(AA-26)
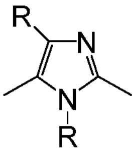
(AA-27)
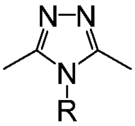
(AA-28)
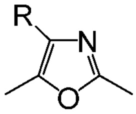
(AA-29)
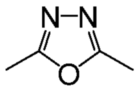
(AA-30)
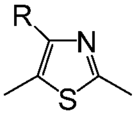
(AA-31)
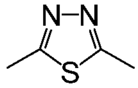
(AA-32)

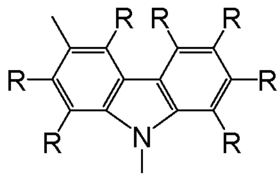
(AA-33)
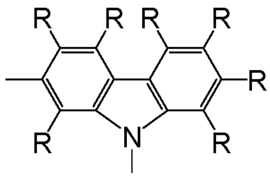
(AA-34)

[wherein, R and $R^a$ represent the same meaning as described above.]

"Crosslinkable group" is a group capable of forming a new bond by being subjected to heating, ultraviolet irradiation, near ultraviolet irradiation, visible light irradiation, infrared irradiation, a radical reaction and the like, and the crosslinkable group is preferably a group represented by any one of the formulae (B-1) to (B-17). These groups each optionally have a substituent.

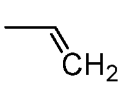
(B-1)
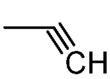
(B-2)
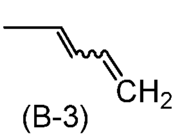
(B-3)
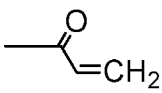
(B-4)
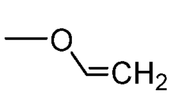
(B-5)
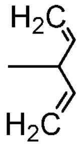
(B-6)
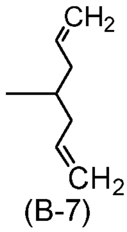
(B-7)
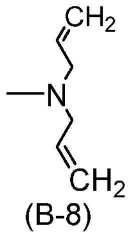
(B-8)

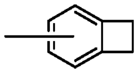
(B-9)
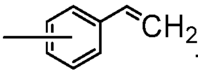
(B-10)
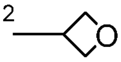
(B-11)
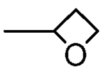
(B-12)
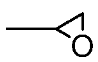
(B-13)
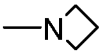
(B-14)
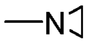
(B-15)
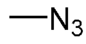
(B-16)
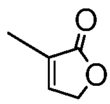
(B-17)

"Substituent" represents a halogen atom, a cyano group, an alkyl group, a cylcoalkyl group, an aryl group, a monovalent heterocyclic group, an alkoxy group, a cycloalkoxy group, an aryloxy group, an amino group, a substituted amino group, an alkenyl group, a cycloalkenyl group, an alkynyl group or a cycloalkynyl group. The substutuent may be

a crosslinkable group.

<Light emitting device>

In the light emitting device of the present invention, P (eV) satisfies the formula (1A), Q (eV) satisfies the formula (2A), and P (eV), Q (eV), RA (eV) and RB (eV) satisfy the formula (3A) and the formula (4A), as described above.

P (eV) is preferably 3.6 or more, more preferably 4.0 or more, particularly preferably 4.3 or more because the cathode is excellent in stability. The upper limit of P (eV) is usually 5.5, preferably 5.0.

Q (eV) is preferably 2.5 or less, more preferably 2.4 eV, further preferably 2.3 or less, particularly preferably 2.0 or less because the phosphorescent light emitting layer is excellent in emission luminance. The lower limit of Q (eV) is usually 1.5.

It is preferable that RA (eV) and RB (eV) satisfy the formula (5A) because the light emitting device is excellent in emission luminance.

It is preferable that RA (eV) and Q (eV) satisfy the formula (6A) because the light emitting device is excellent in emission luminance.

Preferable embodiments of the light emitting device of the present invention include

a light emitting device in which an anode is provided on a substrate, a light emitting layer is laminated on its upper layer, a layer comprising a polymer compound comprising a constitutional unit represented by the formula (ET-1) or a compound represented by the formula (H-1) is laminated on its upper layer, a layer comprising a polymer compound comprising a constitutional unit represented by the formula (ET-1) or a compound represented by the formula (H-1) is laminated on its upper layer, and further, a cathode is laminated on its upper layer, and

a light emitting device in which a cathode is provided on a substrate, a layer comprising a polymer compound comprising a constitutional unit represented by the formula (ET-1) or a compound represented by the formula (H-1) is laminated on its upper layer, a layer comprising a polymer compound comprising a constitutional unit represented by the formula (ET-1) or a compound represented by the formula (H-1) is laminated on its upper layer, a light emitting layer is laminated on its upper layer, and further, an anode is laminated on its upper layer.

In these embodiments, layers having other functions such as a protective layer, a buffer layer, a reflection layer and an insulation layer (insulation film, insulation substrate or the like) may be further provided. The layer comprising a polymer compound comprising a constitutional unit represented by the formula (ET-1) or a compound represented by the formula (H-1) may be a single-layered layer or a multi-layered layer.

The light emitting device of the present invention may be any of bottom emission type, top emission type and double-sided lighting type.

It is preferable for the light emitting device of the present invention to comprise at least one of a hole injection layer and a hole transporting layer between an anode and a light emitting layer, from the stand point of hole injectability and hole transportability.

The material of an electron transporting layer includes electron transporting materials in addition to the polymer compound comprising a constitutional unit represented by the formula (ET-1) or the compound represented by the formula (H-1).

The materials of a hole transporting layer, a hole injection layer and a light emitting layer include hole transporting materials, hole injection materials and light emitting materials, respectively.

When a hole transporting material, a hole injection material, an electron transporting material and a light emitting material are dissolvable in solvents used in forming layers adjacent to a hole transporting layer, an electron transporting layer and a light emitting layer in fabrication of a light emitting device, it is preferable that the material has a crosslinkable group for avoiding dissolution of the material in the solvent. After forming each layer using the material having a crosslinkable group, the crosslinkable group can be cross-linked to insolubilize the layer.

Methods of forming layers such as a light emitting layer, a hole transporting layer, an electron transporting layer and a hole injection layer in the light emitting device of the present invention include, for example, a method of vacuum vapor deposition from a powder and a method by film formation from a solution or melted state in the case of use of a low molecular weight compound, and, for example, a method by film formation from a solution or melted state in the case of use of a polymer compound. Of them, a method by film formation from a solution (the solution herein used is generally referred to as "ink" in some cases.) is preferable as the method of forming the layer.

The order, the number and the thickness of layers to be laminated may be adjusted in view of light emission efficiency and device life.

The solvent used for film formation from a solution is a solvent capable dissolving or uniformly dispersing a material used in formation of each layer. The solvent includes, for example, chlorine-based solvents such as 1,2-dichloroethane, 1,1,2-trichloroethane, chlorobenzene and o-dichlorobenzene; ether solvents such as THF, dioxane, anisole and 4-methylanisole; aromatic hydrocarbon solvents such as toluene, xylene, mesitylene, ethylbenzene, pentylbenzene, hexylbenzene, heptylbenzene, octylbenzene, nonylbenzene, decylbenzene, undecylbenzene, dodecylbenzene, cyclohexylbenzene, trimethylbenzene and 3-phenoxytoluene; aliphatic hydrocarbon solvents such as cyclohexane, methylcyclohexane, n-pentane, n-hexane, n-heptane, n-octane, n-nonane, n-decane, n-dodecane and bicyclohexyl; ketone solvents such as acetone, methyl ethyl ketone, cyclohexanone and acetophenone; ester solvents such as ethyl acetate, butyl acetate, ethyl cellosolve acetate, methyl benzoate and phenyl acetate; polyhydric alcohol solvents such as ethylene glycol, glycerin and 1,2-hexanediol; alcohol solvents such as methanol, ethanol, isopropyl alcohol, 1-butanol, tert-butyl alcohol and cyclohexanol; sulfoxide solvents such as dimethyl sulfoxide; amide solvents such as N-methyl-2-pyrrolidone and N,N-dimethylformamide; fluorinated alcohol solvents such as 2,2,3,3-tetrafluoropropanol, 1,1,1-trifluoro-2-propanol, 1,1,1,3,3,3-hexafluoro-2-propanol, 2,2,3,3,4,4-hexafluorobutanol, 2,2,3,3,4,4,4-heptafluoro-1-butanol, 2,2,3,3,3-pentafluoro-1-propanol, 3,3,4,4,5,5,5-heptafluoro-2-pentanol, 2,2,3,3,4,4,5,5-octafluoro-1-pentanol, 3,3,4,4,5,5,6,6,6-nonafluoro-1-hexanol and 2,2,3,3,4,4,5,5,6,6,7,7-dodecafluoroheptanol;, and water. The solvents may be used each singly or two or more kinds of the solvents may be used in combination.

When two or more kinds of the solvents are used in combination, the following combinations are listed. 4-methylanisole/3-phenoxytoluene, 4-methylanisole/dodecylbenzene, 4-methylanisole/decylbenzene, anisole/3-phenoxytoluene, anisole/dodecylbenzene, anisole/decylbenzene, toluene/3-phenoxytoluene, toluene/dodecylbenzene, toluene/decylbenzene, xylene/3-phenoxytoluene, xylene/dodecylbenzene, xylene/decylbenzene, trimethylbenzene/3-phenoxytoluene, trimethylbenzene/dodecylbenzene, trimethylbenzene/decylbenzene, cyclohexylbenzene/3-phenoxytoluene, cyclohexylbenzene/dodecylbenzene, cyclohexylbenzene/decylbenzene, 4-methylanisole/hexylbenzene, 4-methylanisole/heptylbenzene, 4-methylanisole/octylbenzene, 4-methylanisole/nonylbenzene, 4-methylanisole/undecylbenzene, anisole/hexylbenzene, anisole/heptylbenzene, anisole/octylbenzene, anisole/nonylbenzene, anisole/undecylbenzene, toluene/hexylbenzene, toluene/heptylbenzene, toluene/octylbenzene, toluene/nonylbenzene, toluene/undecylbenzene, xylene/hexylbenzene, xylene/heptylbenzene, xylene/octylbenzene, xylene/nonylbenzene, xylene/undecylbenzene, trimethylbenzene/hexylbenzene, trimethylbenzene/heptylbenzene, trimethylbenzene/octylbenzene, trimethylbenzene/nonylbenzene, trimethylbenzene/undecylbenzene, cyclohexylbenzene/hexylbenzene, cyclohexylbenzene/heptylbenzene, cyclohexylbenzene/octylbenzene, cyclohexylbenzene/nonylbenzene, cyclohexylbenzene/undecylbenzene, 4-methylanisole/cyclohexylbenzene/decylbenzene, 4-methylanisole/cyclohexylbenzene/dodecylbenzene, 4-methylanisole/3-phenoxytoluene/decylbenzene, anisole/cyclohexylbenzene/decylbenzene, anisole/cyclohexylbenzene/dodecylbenzene, anisole/3-phenoxytoluene/decylbenzene, toluene/cyclohexylbenzene/decylbenzene, toluene/cyclohexylbenzene/dodecylbenzene, toluene/3-phenoxytoluene/decylbenzene, xylene/cyclohexylbenzene/decylbenzene, xylene/cyclohexylbenzene/dodecylbenzene, xylene/3-phenoxytoluene/decylbenzene, trimethylbenzene/cyclohexylbenzene/decylbenzene, trimethylbenzene/cyclohexylbenzene/dodecylbenzene, trimethylbenzene/3-phenoxytoluene/decylbenzene, 4-methylanisole/pentylbenzene/decylbenzene, 4-methylanisole/pentylbenzene/dodecylbenzene, 4-methylanisole/hexylbenzene/decylbenzene, 4-methylanisole/hexylbenzene/dodecylbenzene, 4-methylanisole/heptylbenzene/decylbenzene, 4-methylanisole/heptylbenzene/dodecylbenzene, 4-methylanisole/cyclohexylbenzene/hexylbenzene, 4-methylanisole/3-phenoxytoluene/hexylbenzene, 4-methylanisole/cyclohexylbenzene/heptylbenzene, 4-methylanisole/3-phenoxytoluene/heptylbenzene, 4-methylanisole/cyclohexylbenzene/octylbenzene, 4-methylanisole/3-phenoxytoluene/octylbenzene, 4-methylanisole/cyclohexylbenzene/nonylbenzene, 4-methylanisole/3-phenoxytoluene/nonylbenzene, 4-methylanisole/cyclohexylbenzene/undecylbenzene, 4-methylanisole/3-phenoxytoluene/undecylbenzene, 4-methylanisole/pentylbenzene/hexylbenzene, 4-methylanisole/pentylbenzene/heptylbenzene, 4-methylanisole/pentylbenzene/octylbenzene, 4-methylanisole/pentylbenzene/nonylbenzene, 4-methylanisole/pentylbenzene/undecylbenzene, 4-methylanisole/hexylbenzene/heptylbenzene, 4-methylanisole/hexylbenzene/octylbenzene, 4-methylanisole/hexylbenzene/nonylbenzene, 4-methylanisole/hexylbenzene/undecylbenzene, 4-methylanisole/heptylbenzene/octylbenzene, 4-methylanisole/heptylbenzene/nonylbenzene, 4-methylanisole/heptylbenzene/undecylbenzene, anisole/pentylbenzene/decylbenzene, anisole/pentylbenzene/dodecylbenzene, anisole/hexylbenzene/decylbenzene, anisole/hexylbenzene/dodecylbenzene, anisole/heptylbenzene/decylbenzene, anisole/heptylbenzene/dodecylbenzene, anisole/cyclohexylbenzene/hexylbenzene, anisole/3-phenoxytoluene/hexylbenzene, anisole/cyclohexylbenzene/heptylbenzene, anisole/3-phenoxytoluene/heptylbenzene, anisole/cyclohexylbenzene/octylbenzene, anisole/3-phenoxytoluene/octylbenzene, anisole/cyclohexylbenzene/nonylbenzene, anisole/3-phenoxytoluene/nonylbenzene, anisole/cyclohexylbenzene/undecylbenzene, anisole/3-phenoxytoluene/undecylbenzene, anisole/pentylbenzene/hexylbenzene, anisole/pentylbenzene/heptylbenzene, anisole/pentylbenzene/octylbenzene, anisole/pentylbenzene/nonylbenzene, anisole/pentylbenzene/undecylbenzene, anisole/hexylbenzene/heptylbenzene, anisole/hexylbenzene/octylbenzene, anisole/hexylbenzene/nonylbenzene, anisole/hexylbenzene/undecylbenzene, anisole/heptylbenzene/octylbenzene, anisole/heptylbenzene/nonylbenzene, anisole/heptylbenzene/undecylbenzene, toluene/pentylbenzene/decylbenzene, toluene/pentylbenzene/dodecylbenzene, toluene/hexylbenzene/decylbenzene, toluene/hexylbenzene/dodecylbenzene, toluene/heptylbenzene/decylbenzene, toluene/heptylbenzene/dodecylbenzene, toluene/cyclohexylbenzene/hexylbenzene, toluene/3-phenoxytoluene/hexylbenzene, toluene/cyclohexylbenzene/heptylbenzene, toluene/3-phenoxytoluene/heptylbenzene, toluene/cyclohexylbenzene/octylbenzene, toluene/3-phenoxytoluene/octylbenzene, toluene/cyclohexylbenzene/nonylbenzene, toluene/3-phenoxytoluene/nonylbenzene, toluene/cyclohexylbenzene/undecylbenzene, toluene/3-phenoxytoluene/undecylbenzene, toluene/pentylbenzene/hexylbenzene, toluene/pentylbenzene/heptylbenzene, toluene/pentylbenzene/octylbenzene, toluene/pentylbenzene/nonylbenzene, toluene/pentylbenzene/undecylbenzene, toluene/hexylbenzene/heptylbenzene, toluene/hexylbenzene/octylbenzene, toluene/hexylbenzene/nonylbenzene, toluene/hexylbenzene/undecylbenzene, toluene/heptylbenzene/octylbenzene, toluene/heptylbenzene/nonylbenzene, toluene/heptylbenzene/undecylbenzene, xylene/pentylbenzene/decylbenzene, xylene/pentylbenzene/dodecylbenzene, xylene/hexylbenzene/decylbenzene, xylene/hexylbenzene/dodecylbenzene, xylene/heptylbenzene/decylbenzene, xylene/heptylbenzene/dodecylbenzene, xylene/cyclohexylbenzene/hexylbenzene, xylene/3-phenoxytoluene/hexylbenzene, xylene/cyclohexylbenzene/heptylbenzene, xylene/3-phenoxytoluene/heptylbenzene, xylene/cyclohexylbenzene/octylbenzene, xylene/3-phenoxytoluene/octylbenzene, xylene/cyclohexylbenzene/nonylbenzene, xylene/3-phenoxytoluene/nonylbenzene, xylene/cyclohexylbenzene/undecylbenzene, xylene/3-phenoxytoluene/undecylbenzene, xylene/pentylbenzene/hexylbenzene, xylene/pentylbenzene/heptylbenzene, xylene/pentylbenzene/octylbenzene, xylene/pentylbenzene/nonylbenzene, xylene/pentylbenzene/undecylbenzene, xylene/hexylbenzene/heptylbenzene, xylene/hexylbenzene/octylbenzene, xylene/hexylbenzene/nonylbenzene, xylene/hexylbenzene/undecylbenzene, xylene/heptylbenzene/octylbenzene, xylene/heptylbenzene/nonylbenzene, xylene/heptylbenzene/undecylbenzene, trimethylbenzene/pentylbenzene/decylbenzene, trimethylbenzene/pentylbenzene/dodecylbenzene, trimethylbenzene/hexylbenzene/decylbenzene, trimethylbenzene/hexylbenzene/dodecylbenzene, trimethylbenzene/heptylbenzene/decylbenzene, trimethylbenzene/heptylbenzene/dodecylbenzene, trimethylbenzene/cyclohexylbenzene/hexylbenzene, trimethylbenzene/3-phenoxytoluene/hexylbenzene, trimethylbenzene/cyclohexylbenzene/heptylbenzene, trimethylbenzene/3-phenoxytoluene/heptylbenzene, trimethylbenzene/cyclohexylbenzene/octylbenzene, trimethylbenzene/3-phenoxytoluene/octylbenzene, trimethylbenzene/cyclohexylbenzene/nonylbenzene, trimethylbenzene/3-phenoxytoluene/nonylbenzene, trimethylbenzene/cyclohexylbenzene/undecylbenzene, trimethylbenzene/3-phenoxytoluene/undecylbenzene, trimethylbenzene/pentylbenzene/hexylbenzene, trimethylbenzene/pentylbenzene/heptylbenzene, trimethylbenzene/pentylbenzene/octylbenzene, trimethylbenzene/pentylbenzene/nonylbenzene, trimethylbenzene/pentylbenzene/undecylbenzene, trimethylbenzene/hexylbenzene/heptylbenzene, trimethylbenzene/hexylbenzene/octylbenzene, trimethylbenzene/hexylbenzene/nonylbenzene, trimethylbenzene/hexylbenzene/undecylbenzene, trimethylbenzene/heptylbenzene/octylbenzene, trimethylbenzene/heptylbenzene/nonylbenzene, trimethylbenzene/heptylbenzene/undecylbenzene.

The method of film formation from a solution includes application methods such as, for example, a spin coat method, a casting method, a microgravure printing method, a gravure printing method, a bar coat method, a roll coat method, a wire bar coat method, a dip coat method, a slit coat method, a cap coat method, a spray coat method, a screen printing method, a flexo printing method, an offset printing method, an inkjet printing method and a nozzle coat method.

In film formation from a solution, the viscosity of a solution may be controlled depending the kind of the printing method, and when applied to a printing method in which a solution passes through a discharge instrument such as an inkjet print method, the viscosity is preferably 1 to 20 mPa·s at 25°Cbecause clogging and flying curving in discharging hardly occur.

In the solution used for film formation from a solution, the blending amount of a solvent is usually 1000 to 100000 parts by weight, preferably 2000 to 20000 parts by weight with respect to 100 parts by weight of a material used in formation of each layer.

The preferable layer constitution of the light emitting device of the present invention includes, for example, the following constitutions.

(a) anode-light emitting layer-electron transporting layer (two layers)-cathode
(b) anode-hole injection layer-light emitting layer-electron transporting layer (two layers)-cathode
(c) anode-hole injection layer-hole transporting layer-light emitting layer-electron transporting layer (two layers)-cathode

In the light emitting device of the present invention, a thin buffer layer may be inserted into the interface of a hole transporting layer, an electron transporting layer or a light emitting layer, for improvement of close adherence of the interface, prevention of mixing and the like. The order and the number of layers to be laminated and the thickness of each layer may be adjusted in view of light emission efficiency and device life.

Next, the constitution of the light emitting device of the present invention will be illustrated in detail.

<Electron transporting layer>

It is preferable that at least one of the compound contained in an amount of 5% by weight or more in the electron transporting layer (A) and the compound contained in an amount of 5% by weight or more in the electron transporting layer (B) is an aromatic polymer compound because the light emitting device is excellent in emission luminance.

The aromatic polymer compound is preferably a polymer compound comprising a constitutional unit having a group comprising a hetero atom in the side chain, more preferably a polymer compound comprising a constitutional unit represented by the formula (ET-1) because the light emitting device is excellent in emission luminance. In particular, in one embodiment of the present invention, at least one of a compound contained in an amount of 5% by weight or more in the electron transporting layer (A) and a compound contained in an amount of 5% by weight or more in the electron transporting layer (B) is an aromatic polymer compound comprising a constitutional unit represented by the formula (ET-1).

<Constitutional unit represented by formula (ET-1)>

The substituent other than $R^1$ which the constitutional unit represented by the formula (ET-1) optionally has includes, for example, an alkyl group, a cycloalkyl group, an alkoxy group or an aryl group, and it is preferably an alkyl group, an alkoxy group or an aryl group, more preferably an alkyl group or an alkoxy group because synthesis of the polymer compound comprising a constitutional unit represented by the formula (ET-1) is easy.

The aromatic hydrocarbon group represented by $Ar^{E1}$ includes, for example, groups obtained by removing nE1 hydrogen atoms from the above-described arylene group, and preferable are groups obtained by removing nE1 hydrogen atoms from a phenylene group, groups obtained by removing nE1 hydrogen atoms from a naphthalenediyl group or groups obtained by removing nE1 hydrogen atoms from a fluorenediyl group, more preferable are groups obtained by removing nE1 hydrogen atoms from a fluorenediyl group.

The heterocyclic group represented by $Ar^{E1}$ includes, for example, groups obtained by removing nE1 hydrogen atoms from the above-described divalent heterocyclic group.

nE1 is usually an integer of 1 to 10, preferably an integer of 1 to 8, more preferably 1 or 2.

$R^1$ is preferably a group represented by the formula (2) or a group represented by the formula (3), more preferably a group represented by the formula (2).

[Group represented by formula (2)]

n1 is usually an integer of 0 to 10, and it is preferably an integer of 0 to 8, more preferably an integer of 0 to 2 because synthesis of the polymer compound comprising a constitutional unit represented by the formula (ET-1) is easy.

a1 is usually an integer of 1 to 10, and it is preferably an integer of 1 to 5, more preferably 1 or 2 because the polymer compound comprising a constitutional unit represented by the formula (ET-1) is excellent in electron transportability.

b1 is usually an integer of 0 to 10, and it is preferably an integer of 0 to 4, more preferably 0 or 1 because the light emitting device of the present invention is excellent in life.

a1 and b1 are selected in such a manner that the electric charge of the group represented by the formula (2) is 0.

m2 is usually an integer of 1 to 5, and it is preferably 1 or 2, more preferably 1 because synthesis of the polymer compound comprising a constitutional unit represented by the formula (ET-1) is easy. When $R^3$ is a single bond, m2 is 1.

When $R^3$ is $-O-R^{3'}$, the group represented by the formula (2) is a group represented by the following formula.

$$-O-R^{3'}-\{(Q^1)_{n1}-Y^1(M^1)_{a1}(Z^1)_{b1}\}m2$$

The number of carbon atoms of the hydrocarbon group represented by $R^3$ is usually 1 to 20, preferably 1 to 10, more preferably 1 to 6, not including the number of carbon atoms of the substituent.

The hydrocarbon group represented by $R^3$ may be an aliphatic hydrocarbon group or an aromatic hydrocarbon group, and it is preferably an aromatic hydrocarbon group because the polymer compound comprising a constitutional unit represented by the formula (ET-1) is excellent in electron transportability.

The hydrocarbon group represented by $R^3$ includes, for example, groups obtained by removing m2 hydrogen atoms bonding directly to carbon atoms from an alkyl group having a number of carbon atoms of 1 to 20 such as a methyl group, an ethyl group, a propyl group, an isopropyl group, a butyl group, a pentyl group, a hexyl group, a cyclohexyl group, a heptyl group, an octyl group, a nonyl group, a decyl group and a lauryl group; and groups obtained by removing m2 hydrogen atoms bonding directly to carbon atoms constituting the ring from an aryl group having a number of carbon atoms of 6 to 30 such as a phenyl group and a naphthyl group, and these groups each optionally have a substituent.

The number of carbon atoms of the heterocyclic group represented by $R^3$ is usually 2 to 60, preferably 3 to 20, more preferably 3 to 15, not including the number of carbon atoms of the substituent.

The heterocyclic group represented by $R^3$ is preferably an aromatic heterocyclic group because synthesis of the polymer compound comprising a constitutional unit represented by the formula (ET-1) is easy.

The heterocyclic group represented by $R^3$ includes, for example, groups obtained by removing m2 hydrogen atoms bonding directly to carbon atoms or hetero atoms constituting the ring from a monovalent heterocyclic group obtained by removing one hydrogen atom among hydrogen atoms bonding directly to carbon atoms or hetero atoms

constituting the ring from a heterocyclic compound having a number of carbon atoms of 2 to 13 such as pyridine, diazabenzene, triazine, azanaphthalene, diazanaphthalene, carbazole, dibenzofuran, dibenzothiophene, dibenzosilole, phenoxazine, phenothiazine, acridine, dihydroacridine, furan, thiophene, azole, diazole and triazole, and these groups each optionally have a substituent.

The number of carbon atoms of $-O-R^{3'}$ represented by $R^3$ is usually 1 to 20, preferably 1 to 12, more preferably 1 to 6, not including the number of carbon atoms of the substituent.

$R^{3'}$ is preferably a hydrocarbon group because synthesis of the polymer compound comprising a constitutional unit represented by the formula (ET-1) is easy. The hydrocarbon group represented by $R^{3'}$ may be an aliphatic hydrocarbon group or an aromatic hydrocarbon group, and it is preferably an aromatic hydrocarbon group because synthesis of the polymer compound comprising a constitutional unit represented by the formula (ET-1) is easy.

$-O-R^{3'}$ represented by $R^3$ includes, for example, groups obtained by removing m2 hydrogen atoms bonding directly to carbon atoms from an alkoxy group having a number of carbon atoms of 1 to 50 such as a methoxy group, an ethoxy group, a propyloxy group, a butyloxy group, a pentyloxy group, a hexyloxy group, a nonyloxy group, a dodecyloxy group and a cyclohexyloxy group; groups obtained by removing m2 hydrogen atoms bonding directly to carbon atoms constituting the ring from an aryloxy group having a number of carbon atoms of 6 to 48 such as a phenoxy group, a 1-naphthyloxy group, a 2-naphthyloxy group, a 1-anthracenyloxy group, a 9-anthracenyloxy group and a 1-pyrenyloxy group; and groups obtained by removing m2 hydrogen atoms bonding directly to carbon atoms constituting the ring from a heterocyclicoxy group having a number of carbon atoms of 2 to 60 such as a thienyloxy group, a pyrrolyloxy group, a furyloxy group, a pyridyloxy group, a piperidinyloxy group, a quinolinyloxy group, an isoquinolinyloxy group, a pyrimidinyloxy group and a triazinyloxy group, and these groups each optionally have a substituent.

$-O-R^{3'}$ represented by $R^3$ is preferably an alkoxy group or an aryloxy group, more preferably an alkoxy group because synthesis of the polymer compound comprising a constitutional unit represented by the formula (ET-1) is easy.

$R^3$ is preferably a hydrocarbon group or a heterocyclic group, more preferably a hydrocarbon group, further preferably an aromatic hydrocarbon group, particularly preferably a group obtained by removing m2 hydrogen atoms bonding directly to carbon atoms constituting the ring from a phenyl group because synthesis of the polymer compound comprising a constitutional unit represented by the formula (ET-1) is easy.

The number of carbon atoms of the alkylene group represented by $Q^1$ is usually 1 to 50, preferably 3 to 30, more preferably 4 to 20, not including the number of carbon atoms of the substituent.

The number of carbon atoms of the cycloalkylene group represented by $Q^1$ is usually 3 to 50, preferably 3 to 30, more preferably 4 to 20, not including the number of carbon atoms of the substituent.

The alkylene group or the cycloalkylene group represented by $Q^1$ includes, for example, a methylene group, an ethylene group, a 1,2-propylene group, a 1,3-propylene group, a 1, 2-butylene group, a 1, 3-butylene group, a 1, 4-butylene group, a 1,5-pentylene group, a 1,6-hexylene group, a 1,9-nonylene group, a 1,12-dodecylene group and a 1,4-cyclohexylene group, and these groups each optionally have a substituent.

The number of carbon atoms of the arylene group represented by $Q^1$ is usually 6 to 60, preferably 6 to 30, more preferably 6 to 18, not including the number of carbon atoms of the substituent.

The arylene group represented by $Q^1$ includes, for example, a 1,3-phenylene group, a 1,4-phenylene group, a 1,4-naphthylene group, a 1,5-naphthylene group, a 2,6-naphthylene group and a biphenyl-4,4'-diyl group, and these groups each optionally have a substituent.

$Q^1$ is preferably an alkylene group, an arylene group or an oxygen atom, more preferably an alkylene group or an oxygen atom because synthesis of the polymer compound comprising a constitutional unit represented by the formula (ET-1) is easy.

$Y^1$ is preferably $-CO_2^-$, $-SO_2^-$ or $-PO_3^{2-}$, more preferably $-CO_2-$ because the light emitting device of the present invention is excellent in life

The alkali metal cation represented by $M^1$ includes, for example, $Li^+$, $Na^+$, $K^+$, $Rb^+$ and $Cs^+$, and it is preferably $K^+$, $Rb^+$ or $Cs^+$, more preferably $Cs^+$ because the driving voltage of the light emitting device of the present invention lowers.

The alkaline earth metal cation represented by $M^1$ includes, for example, $Be^{2+}$, $Mg^{2+}$, $Ca^{2+}$, $Sr^{2+}$ and $Ba^{2+}$, and it is preferably $Mg^{2+}$, $Ca^{2+}$, $Sr^{2+}$ or $Ba^{2+}$, more preferably $Ba^{2+}$ because the driving voltage of the light emitting device of the present invention lowers.

The substituent which the ammonium cation represented by $M^1$ optionally has is preferably an alkyl group, a cycloalkyl group or an aryl group, more preferably an alkyl group.

$M^1$ is preferably an alkali metal cation or an alkaline earth metal cation, more preferably an alkali metal cation because the light emitting device of the present invention is excellent in life.

$R^{aa}$ in $B(R^{aa})_4^-$, $R^{aa}SO_3^-$ and $R^{aa}COO^-$ represented by $Z^1$ is preferably an alkyl group or an aryl group, more preferably an alkyl group because synthesis of the polymer compound comprising a constitutional unit represented by the formula (ET-1) is easy.

$Z^1$ is preferably $F^-$, $Cl^-$, $Br^-$, $I^-$, $OH^-$, $B(R^{aa})_4^-$, $R^{aa}SO_3^-$, $R^{aa}COO^-$ or $NO_3^-$, more preferably $F^-$, $Cl^-$, $Br^-$, $I^-$, $OH^-$, $R^{aa}SO_3^-$ or $R^{aa}COO^-$ because synthesis of the polymer compound comprising a constitutional unit represented by the

formula (ET-1) is easy.

The group represented by the formula (2) includes, for example, groups represented by the following formulae.

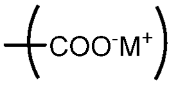

(2-1)

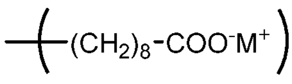

(2-2)

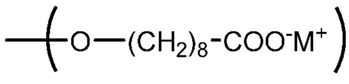

(2-3)

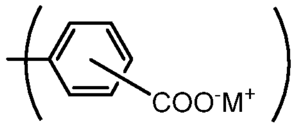

(2-4)

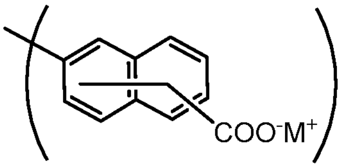

(2-5)

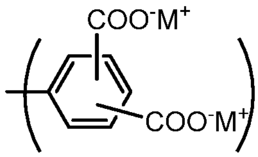

(2-6)

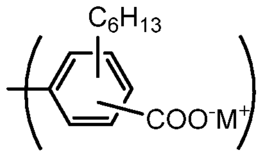

(2-7)

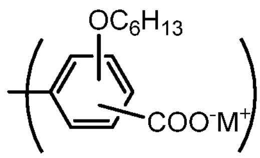

(2-8)

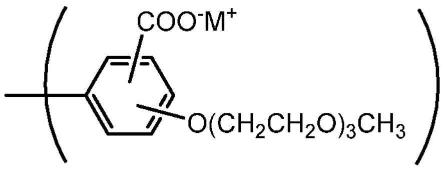

(2-9)

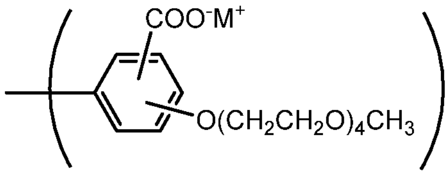

(2-10)

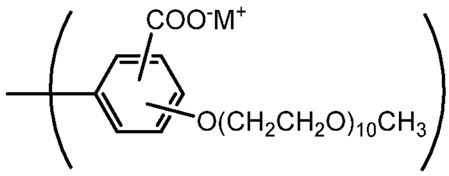

(2-11)

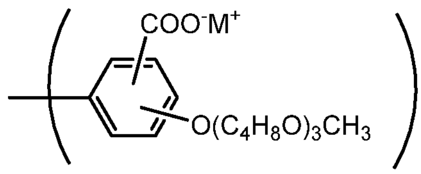

(2-12)

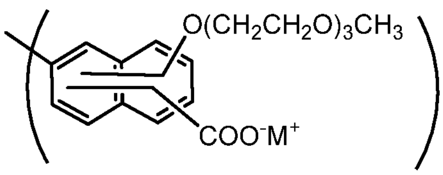

(2-13)

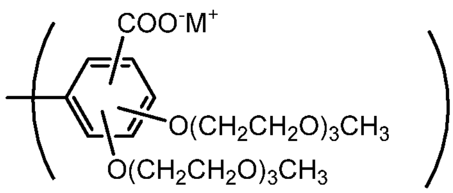

(2-14)

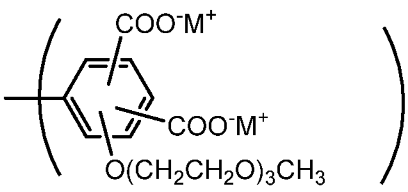

(2-15)

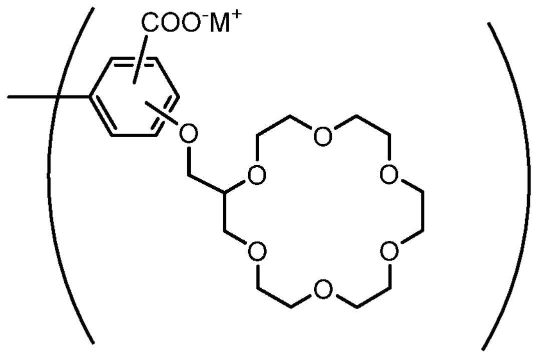

(2-16)

[wherein, $M^+$ represents $Li^+$, $Na^+$, $K^+$, $Rb^+$, $Cs^+$ or $N^+(CH_3)_4$. When a plurality of $M^+$ are present, they may be the same or different.]

[Group represented by formula (3)]

n2 is usually an integer of 0 to 10, and it is preferably an integer of 0 to 8, more preferably an integer of 0 to 2 because synthesis of the polymer compound comprising a constitutional unit represented by the formula (ET-1) is easy.

a2 is usually an integer of 1 to 10, and it is preferably an integer of 1 to 5, more preferably 1 or 2 because the light emitting device of the present invention is excellent in life.

b2 is usually an integer of 0 to 10, and it is preferably an integer of 0 to 4, more preferably 0 or 1 because the light emitting device of the present invention is excellent in life.

a2 and b2 are selected in such a manner that the electric charge of the group represented by the formula (3) is 0.

m3 is usually an integer of 1 to 5, and it is preferably 1 or 2, more preferably 1 because synthesis of the polymer compound comprising a constitutional unit represented by the formula (ET-1) is easy. When $R^4$ is a single bond, m3 is 1.

When $R^4$ is $-O-R^{4'}$, the group represented by the formula (3) is a group represented by the following formula.

$$-O-R^{4'}\{(Q^2)_{n2}-Y^2(M^2)_{a2}(Z^2)_{b2}\}_{m3}$$

The number of carbon atoms of the hydrocarbon group represented by $R^4$ is usually 1 to 20, preferably 1 to 10, more preferably 1 to 6, not including the number of carbon atoms of the substituent.

The hydrocarbon group represented by $R^4$ may be an aliphatic hydrocarbon group or an aromatic hydrocarbon group, and it is preferably an aromatic hydrocarbon group because synthesis of the polymer compound comprising a constitutional unit represented by the formula (ET-1) is easy.

Examples of the hydrocarbon group represented by $R^4$ are the same as examples of the hydrocarbon group represented by $R^3$.

The number of carbon atoms of the heterocyclic group represented by $R^4$ is usually 2 to 60, preferably 3 to 20, more preferably 3 to 15, not including the number of carbon atoms of the substituent.

The heterocyclic group represented by $R^4$ is preferably an aromatic heterocyclic group because synthesis of the polymer compound comprising a constitutional unit represented by the formula (ET-1) is easy.

Examples of the heterocyclic group represented by $R^4$ are the same as examples of the heterocyclic group represented by $R^3$.

The number of carbon atoms of $-O-R^{4'}$ represented by $R^4$ is usually 1 to 20, preferably 1 to 12, more preferably 1 to 6, not including the number of carbon atoms of the substituent.

$R^{4'}$ is preferably a hydrocarbon group because synthesis of the polymer compound comprising a constitutional unit represented by the formula (ET-1) is easy. The hydrocarbon group represented by $R^{4'}$ may be an aliphatic hydrocarbon group or an aromatic hydrocarbon group, and it is preferably an aromatic hydrocarbon group because synthesis of the polymer compound comprising a constitutional unit represented by the formula (ET-1) is easy.

Examples of $-O-R^{4'}$ represented by $R^4$ are the same as examples of $-O-R^{3'}$ represented by $R^3$.

$-O-R^{4'}$ represented by $R^4$ is preferably an alkoxy group or an aryloxy group, more preferably an alkoxy group because synthesis of the polymer compound comprising a constitutional unit represented by the formula (ET-1) is easy.

$R^4$ is preferably a hydrocarbon group or a heterocyclic group, more preferably a hydrocarbon group, further preferably an aromatic hydrocarbon group, particularly preferably a group obtained by removing m3 hydrogen atoms bonding directly to carbon atoms constituting the ring from a phenyl group because synthesis of the polymer compound

comprising a constitutional unit represented by the formula (ET-1) is easy.

The number of carbon atoms of the alkylene group represented by $Q^2$ is usually 1 to 50, preferably 3 to 30, more preferably 4 to 20, not including the number of carbon atoms of the substituent.

The number of carbon atoms of the cycloalkylene group represented by $Q^2$ is usually 3 to 50, preferably 3 to 30, more preferably 4 to 20, not including the number of carbon atoms of the substituent.

Examples of the alkylene group and the cycloalkylene group represented by $Q^2$ are the same as examples of the alkylene group and the cycloalkylene group represented by $Q^1$.

The number of carbon atoms of the arylene group represented by $Q^2$ is usually 6 to 60, preferably 6 to 30, more preferably 6 to 18, not including the number of carbon atoms of the substituent.

Examples of the arylene group represented by $Q^2$ are the same as examples of the arylene group represented by $Q^1$.

$Q^2$ is preferably an alkylene group, arylene group or an oxygen atom, more preferably an alkylene group or an oxygen atom because synthesis of the polymer compound comprising a constitutional unit represented by the formula (ET-1) is easy.

$R^c$ in $-C^+R^c_2$, $-N^+R^c_3$, $-P^+R^c_3$, $-S^+R^c_2$ and $-I+R^c_2$ represented by $Y^2$ is preferably a hydrogen atom, an alkyl group or an aryl group, more preferably a hydrogen atom or an alkyl group because synthesis of the polymer compound comprising a constitutional unit represented by the formula (ET-1) is easy.

$Y^2$ is preferably $-C^+R^c_2$, $-N^+R^c_3$, $-P^+R^c_3$ or $-S^+R^c_2$, more preferably $-N^+R^c_3$ because synthesis of the polymer compound comprising a constitutional unit represented by the formula (ET-1) is easy and the polymer compound comprising a constitutional unit represented by the formula (ET-1) is excellent in stability.

$R^b$ in $B(R^b)_4^-$, $R^bSO_3^-$ and $R^bCOO^-$ represented by $M^2$ is preferably an alkyl group or an aryl group, more preferably an alkyl group because synthesis of the polymer compound comprising a constitutional unit represented by the formula (ET-1) is easy.

$M^2$ is preferably $F^-$, $Cl^-$, $Br^-$, $I^-$, $B(R^b)_4^-$, $R^bSO_3^-$, $R^bCOO^-$, $BF_4^-$ or $SbF^{6-}$, more preferably $Br^-$, $I^-$, $B(R^b)_4^-$, $R^bCOO^-$ or $SbF^{6-}$ because the light emitting device of the present invention is excellent in life.

The alkali metal cation represented by $Z^2$ includes, for example, $Li^+$, $Na^+$, $K^+$, $Rb^+$ and $Cs^+$, and it is preferably $Li^+$, $Na^+$ or $K^+$ because synthesis of the polymer compound comprising a constitutional unit represented by the formula (ET-1) is easy.

The alkaline earth metal cation represented by $Z^2$ includes, for example, $Be^{2+}$, $Mg^{2+}$, $Ca^{2+}$, $Sr^{2+}$ and $Ba^{2+}$, and it is preferably $Mg^{2+}$ or $Ca^{2+}$ because synthesis of the polymer compound comprising a constitutional unit represented by the formula (ET-1) is easy.

$Z^2$ is preferably an alkali metal cation because synthesis of the polymer compound comprising a constitutional unit represented by the formula (ET-1) is easy.

The group represented by the formula (3) includes, for example, groups represented by the following formulae.

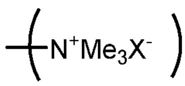
(3-1)

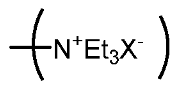
(3-2)

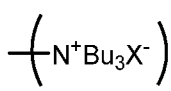
(3-3)

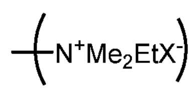
(3-4)

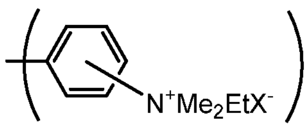
(3-5)

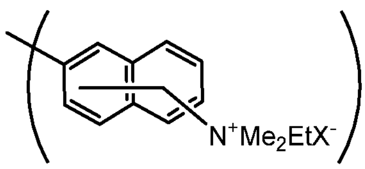
(3-6)

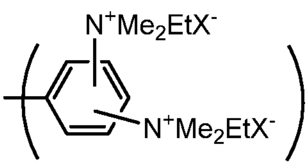
(3-7)

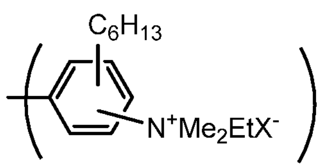
(3-8)

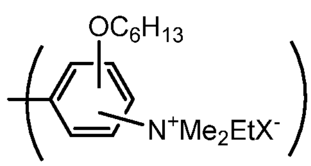
(3-9)

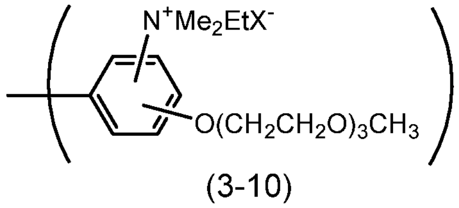

(3-10)

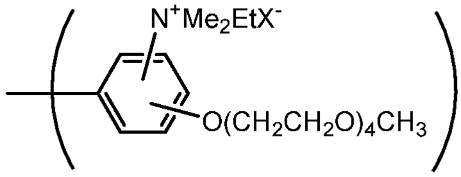

(3-11)

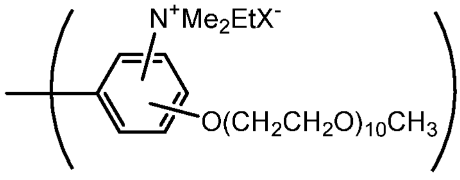

(3-12)

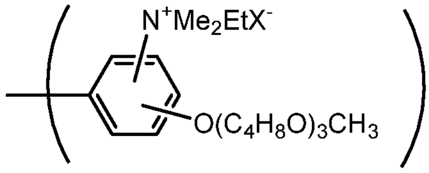

(3-13)

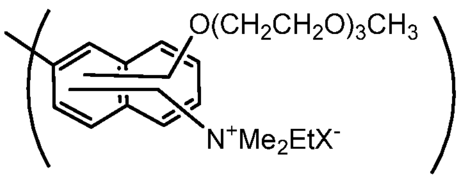

(3-14)

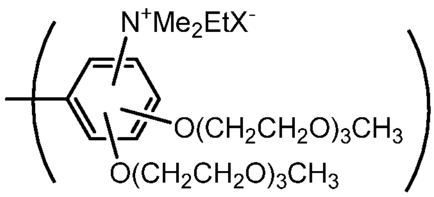

(3-15)

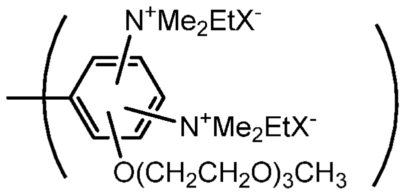

(3-16)

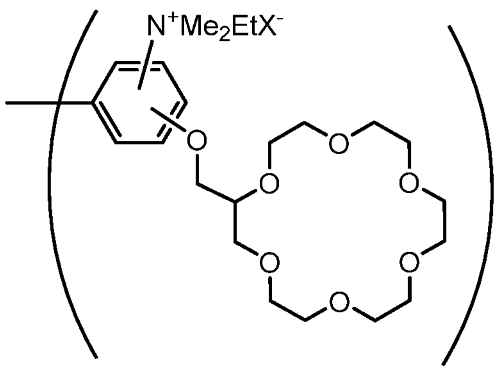

(3-17)

[wherein, $X^-$ represents $F^-$, $Cl^-$, $Br^-$ , $I^-$, $B^- (C_6H_5)_4$, $CH_3COO^-$ or $CF_3SO_3^-$.]

[Group represented by formula (4)]

n3 is usually an integer of 0 to 30, and it is preferably an integer of 0 to 20, more preferably an integer of 0 to 8 because synthesis of the polymer compound comprising a constitutional unit represented by the formula (ET-1) is easy.

m4 is usually an integer of 1 to 5, and it is preferably 1 or 2, more preferably 1 because synthesis of the polymer compound comprising a constitutional unit represented by the formula (ET-1) is easy. When $R^5$ is a single bond, m4 is 1.

The number of carbon atoms of the hydrocarbon group represented by $R^5$ is usually 1 to 20, preferably 1 to 10, more preferably 1 to 6, not including the number of carbon atoms of the substituent.

The hydrocarbon group represented by $R^5$ may be an aliphatic hydrocarbon group or an aromatic hydrocarbon group, and it is preferably an aromatic hydrocarbon group because the polymer compound of the present invention is excellent in electron transportability.

Examples of the hydrocarbon group represented by $R^5$ are the same as examples of the hydrocarbon group represented by $R^3$.

The number of carbon atoms of the heterocyclic group represented by $R^5$ is usually 2 to 60, preferably 3 to 20,

more preferably 3 to 15, not including the number of carbon atoms of the substituent.

The heterocyclic group represented by $R^5$ is preferably an aromatic heterocyclic group because the polymer compound of the present invention is excellent in electron transportability.

Examples of the heterocyclic group represented by $R^5$ are the same as examples of the heterocyclic group represented by $R^3$.

The number of carbon atoms of $-O-R^{5'}$ represented by $R^5$ is usually 1 to 20, preferably 1 to 12, more preferably 1 to 6, not including the number of carbon atoms of the substituent.

$R^{5'}$ is preferably a hydrocarbon group because synthesis of the polymer compound comprising a constitutional unit represented by the formula (ET-1) is easy. The hydrocarbon group represented by $R^{5'}$ may be an aliphatic hydrocarbon group or an aromatic hydrocarbon group, and it is preferably an aromatic hydrocarbon group because the polymer compound of the present invention is excellent in electron transportability.

Examples of $-O-R^{5'}$ represented by $R^5$ are the same as examples of $-O-R^{3'}$ represented by $R^3$.

$-O-R^{5'}$ represented by $R^5$ is preferably an alkoxy group or an aryloxy group, more preferably an alkoxy group.

$R^5$ is preferably a hydrocarbon group or a heterocyclic group, more preferably a hydrocarbon group, further preferably an aromatic hydrocarbon group, particularly preferably a group obtained by removing m4 hydrogen atoms bonding directly to carbon atoms constituting the ring from a phenyl group because synthesis of the polymer compound comprising a constitutional unit represented by the formula (ET-1) is easy.

The number of carbon atoms of the alkylene group represented by $Q^3$ is usually 1 to 50, preferably 3 to 30, more preferably 4 to 20, not including the number of carbon atoms of the substituent.

The number of carbon atoms of the cycloalkylene group represented by $Q^3$ is usually 3 to 50, preferably 3 to 30, more preferably 4 to 20, not including the number of carbon atoms of the substituent.

Examples of the alkylene group and the cycloalkylene group represented by $Q^3$ are the same as examples of the alkylene group and the cycloalkylene group represented by $Q^1$.

The number of carbon atoms of the arylene group represented by $Q^3$ is usually 6 to 60, preferably 6 to 30, more preferably 6 to 18, not including the number of carbon atoms of the substituent.

Examples of the arylene group represented by $Q^3$ are the same as examples of the arylene group represented by $Q^1$.

$Q^3$ is preferably an alkylene group, an arylene group or an oxygen atom, more preferably an alkylene group or an oxygen atom because synthesis of the polymer compound comprising a constitutional unit represented by the formula (ET-1) is easy.

[Group represented by formula (5) or formula (6)]

a3 is usually an integer of 1 to 20, and it is preferably an integer of 3 to 10, more preferably an integer of 5 to 10 because synthesis of the polymer compound comprising a constitutional unit represented by the formula (ET-1) is easy.

The number of carbon atoms of the alkylene group represented by R' is usually 1 to 10, preferably 2 to 10, more preferably 2 to 6, further preferably 2 to 4, not including the number of carbon atoms of the substituent.

The number of carbon atoms of the cycloalkylene group represented by R' is usually 3 to 50, preferably 3 to 30, more preferably 4 to 20, not including the number of carbon atoms of the substituent.

The alkylene group or the cycloalkylene group represented by R' includes, for example, a methylene group, an ethylene group, a 1,3-propylene group, a 1,2-butylene group, a 1,3-butylene group, a 1,4-butylene group and a 1,4-cyclohexylene group, and these groups each optionally have a substituent.

The number of carbon atoms of the arylene group represented by R' is usually 6 to 60, preferably 6 to 30, more preferably 6 to 18, not including the number of carbon atoms of the substituent.

The arylene group represented by R' includes, for example, a 1,3-phenylene group, a 1,4-phenylene group, a 1,4-naphthylene group and a 2,6-naphthylene group, and these groups each optionally have a substituent.

R' is preferably an alkylene group or an arylene group, more preferably an alkylene group because synthesis of the polymer compound comprising a constitutional unit represented by the formula (ET-1) is easy.

The number of carbon atoms of the alkyl group represented by R" is usually 1 to 50, preferably 1 to 10, more preferably 1 to 3, not including the number of carbon atoms of the substituent.

The alkyl group represented by R" includes, for example, a methyl group, an ethyl group, a propyl group, a butyl group and a cyclohexyl group, and these groups each optionally have a substituent.

The number of carbon atoms of the cycloalkyl group represented by R" is usually 3 to 50, preferably 3 to 30, more preferably 4 to 20, not including the number of carbon atoms of the substituent.

The cycloalkyl group represented by R" includes, for example, a cyclohexyl group, a cyclohexylmethyl group and a cyclohexylethyl group, and these groups each optionally have a substituent.

The number of carbon atoms of the aryl group represented by R" is usually 6 to 60, preferably 6 to 20, more preferably 6 to 10, not including the number of carbon atoms of the substituent.

The aryl group represented by R" includes, for example, a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group, a 4-phenylphenyl group, and groups obtained by substituting a hydrogen atom on these groups with an alkyl group, a cycloalkyl group, an alkoxy group, a cycloalkoxy group, an aryl group, a fluorine atom and the like, and these groups each optionally have a substituent.

R" is preferably an alkyl group or a cycloalkyl group, more preferably an alkyl group, further preferably a methyl group or an ethyl group because the polymer compound comprising a constitutional unit represented by the formula (ET-1) is excellent in solubility in an organic solvent.

The number of carbon atoms of the hydrocarbon group represented by R"' is usually 1 to 20, preferably 1 to 10, more preferably 2 to 10, not including the number of carbon atoms of the substituent.

The hydrocarbon group represented by R"' may be an aliphatic hydrocarbon group or an aromatic hydrocarbon group, and it is preferably an aliphatic hydrocarbon group because synthesis of the polymer compound comprising a constitutional unit represented by the formula (ET-1) is easy.

The hydrocarbon group represented by R"' includes, for example, alkanetriyl groups having a number of carbon atoms of 1 to 20 such as a methanetriyl group, an ethanetriyl group, a 1,2,3-propanetriyl group, a 1,2,4-butanetriyl group, a 1,2,5-pentanetriyl group, a 1,3,5-pentanetriyl group, a 1,2,6-hexanetriyl group and a 1,3,6-hexanetriyl group; arylenetriyl groups having a number of carbon atoms of 6 to 30 such as a 1,2,3-benzenetriyl group, a 1,2,4-benzenetriyl group and a 1,3,5-benzenetriyl group; etc., and it is preferably a methanetriyl group, an ethanetriyl group, a 1,2,4-benzenetriyl group or a 1,3,5-benzenetriyl group because the polymer compound comprising a constitutional unit represented by the formula (ET-1) is excellent in solubility in an organic solvent, and these groups each optionally have a substituent.

$Y^3$ is preferably a group represented by the formula (5) because synthesis of the polymer compound comprising a constitutional unit represented by the formula (ET-1) is easy.

The group represented by the formula (5) or the formula (6) represented by $Y^3$ includes, for example, groups represented by the following formulae.

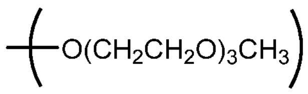
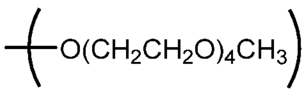
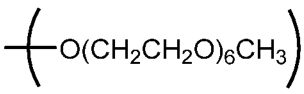
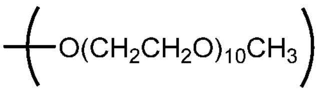
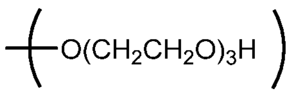
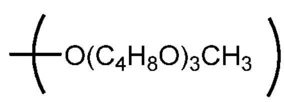
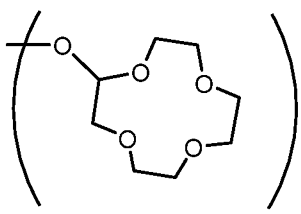
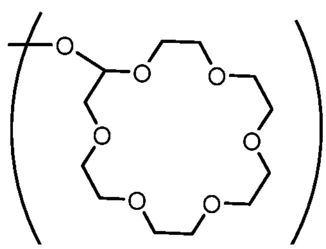
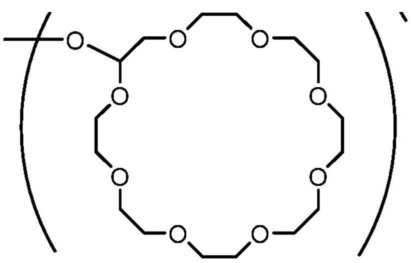

The group represented by the formula (4) includes, for example, groups represented by the following formulae.

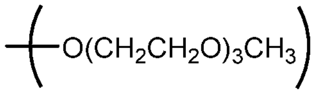

(4-1)

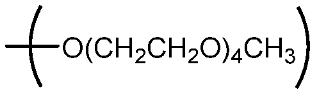

(4-2)

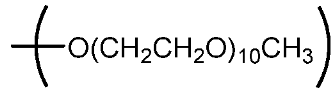

(4-3)

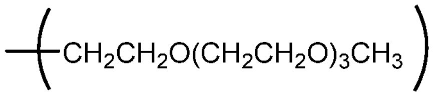

(4-4)

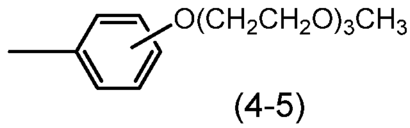

(4-5)

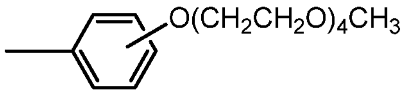

(4-6)

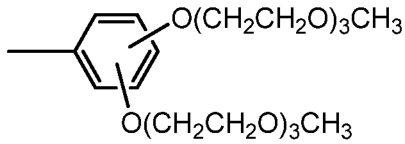

(4-7)

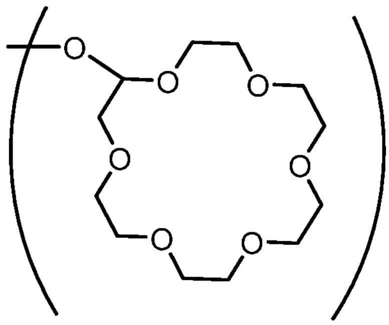

(4-8)

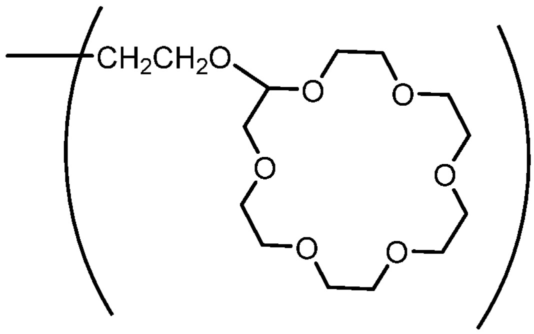

(4-9)

[Group represented by formula (2')]

The group represented by the formula (2) is preferably the above-described group represented by the formula (2') because the driving voltage of the light emitting device of the present invention lowers.

The number of carbon atoms of the aromatic hydrocarbon group represented by $R^6$ is usually 6 to 30, preferably 6 to 18, more preferably 6 to 10, not including the number of carbon atoms of the substituent.

The aromatic hydrocarbon group represented by $R^6$ includes, for example, groups obtained by removing (m2+m4) hydrogen atoms bonding directly to carbon atoms constituting the ring from an aryl group having a number of carbon atoms of 6 to 30 such as a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group and a 4-phenylphenyl group, and these groups each optionally have a substituent.

The number of carbon atoms of the heterocyclic group represented by $R^6$ is usually 3 to 30, preferably 3 to 20, more preferably 3 to 15, not including the number of carbon atoms of the substituent.

The heterocyclic group represented by $R^6$ is preferably an aromatic heterocyclic group because synthesis of the polymer compound comprising a constitutional unit represented by the formula (ET-1) is easy.

The heterocyclic group represented by $R^6$ includes, for example, groups obtained by removing (m2+m4) hydrogen atoms bonding directly to carbon atoms or hetero atoms constituting the ring from a monovalent heterocyclic group having a number of carbon atoms of 3 to 30 such as a thienyl group, a pyrrolyl group, a furyl group, a pyridyl group, a piperidinyl group, a quinolinyl group, an isoquinolinyl group, a pyrimidinyl group and a triazinyl group, and these groups each optionally have a substituent.

$R^6$ is preferably an aromatic hydrocarbon group, more preferably a group obtained by removing (m2+m4) hydrogen atoms bonding directly to carbon atoms constituting the ring from a phenyl group because synthesis of the polymer compound comprising a constitutional unit represented by the formula (ET-1) is easy.

The group represented by the formula (2') includes, for example, the groups represented by the formula (2-9) to the formula (2-16) described above.

[Group represented by formula (3')]

The group represented by the formula (3) is preferably the above-described group represented by the formula (3') because the driving voltage of the light emitting device of the present invention lowers.

The number of carbon atoms of the aromatic hydrocarbon group represented by $R^7$ is usually 6 to 30, preferably 6 to 18, more preferably 6 to 10, not including the number of carbon atoms of the substituent.

Examples of the aromatic hydrocarbon group represented by $R^7$ are the same as examples of the aromatic hydrocarbon group represented by $R^6$.

The number of carbon atoms of the heterocyclic group represented by $R^7$ is usually 3 to 30, preferably 3 to 20, more preferably 3 to 15, not including the number of carbon atoms of the substituent.

The heterocyclic group represented by $R^7$ is preferably an aromatic heterocyclic group because synthesis of the polymer compound comprising a constitutional unit represented by the formula (ET-1) is easy.

Examples of the heterocyclic group represented by $R^7$ are the same as examples of the heterocyclic group represented by $R^6$.

$R^7$ is preferably an aromatic hydrocarbon group, more preferably a group obtained by removing (m2+m4) hydrogen atoms bonding directly to carbon atoms constituting the ring from a phenyl group because synthesis of the polymer compound comprising a constitutional unit represented by the formula (ET-1) is easy.

The group represented by the formula (3') includes, for example, the groups represented by the formula (3-10) to the formula (3-17) described above.

<Constitutional unit represented by formula (1)>

The constitutional unit represented by the formula (ET-1) is preferably a constitutional unit represented by the formula (1) because the light emitting device of the present invention is capable of emitting light at higher luminance.

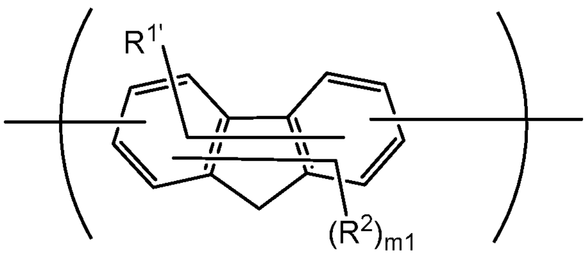

(1)

[wherein,

m1 represents an integer of 0 or more.
$R^{1'}$ represents a group represented by the formula (2) or the formula (3).
$R^2$ represents a group represented by the formula (4). When a plurality of $R^2$ are present, they may be the same or different.

The constitutional unit represented by the formula (1) optionally has a substituent other than $R^{1'}$ and $R^2$.]

The substituent other than $R^{1'}$ and $R^2$ which the constitutional unit represented by the formula (1) optionally has includes, for example, an alkyl group, a cycloalkyl group, an alkoxy group or an aryl group, and it is preferably an alkyl group, an alkoxy group or an aryl group, more preferably an alkyl group or an alkoxy group because synthesis of the polymer compound comprising a constitutional unit represented by the formula (1) is easy.

The constitutional unit represented by the formula (1) is preferably a constitutional unit represented by the formula (7), more preferably a constitutional unit represented by the formula (7') because the polymer compound comprising a constitutional unit represented by the formula (1) is excellent in stability.

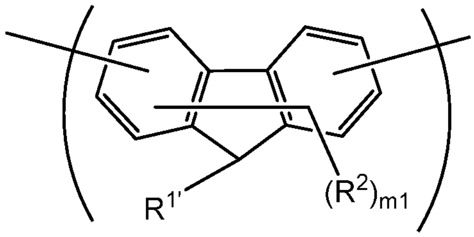

(7)

[in the formula (7),
m1, $R^{1'}$ and $R^2$ represent the same meaning as described above.

The constitutional unit represented by the formula (7) optionally has a substituent other than $R^{1'}$ and $R^2$.]

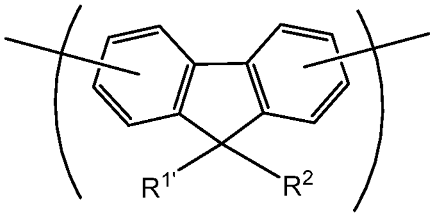

(7')

[in the formula (7'),
$R^{1'}$ and $R^2$ represent the same meaning as described above.

The constitutional unit represented by the formula (7') optionally has a substituent other than $R^{1'}$ and $R^2$.]

Examples and preferable ranges of the substituent other than $R^{1'}$ and $R^2$ which the constitutional unit represented by the formula (7) or the formula (7') optionally has are the same as examples and preferable ranges of the substituent other than $R^{1'}$ and $R^2$ which the constitutional unit represented by the formula (1) optionally has.

<Preferable embodiment of constitutional unit represented by formula (ET-1)>

The constitutional unit represented by the formula (ET-1) includes, for example, constitutional units represented by the following formulae.

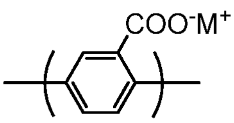

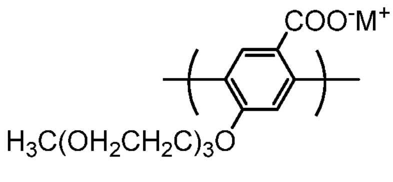

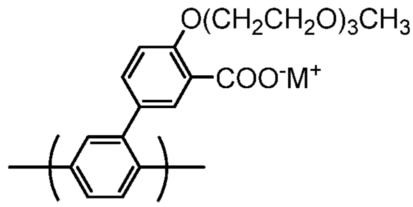

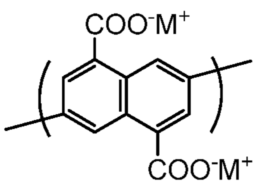

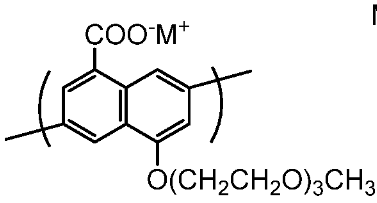

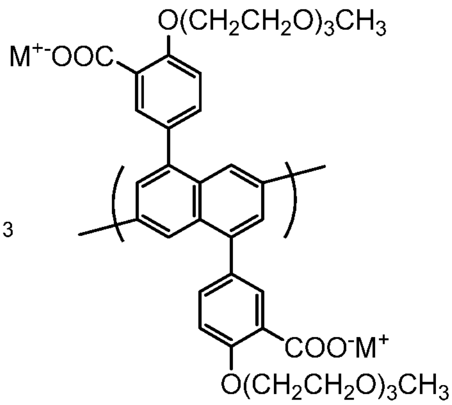

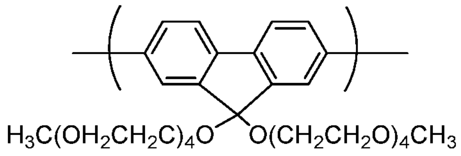

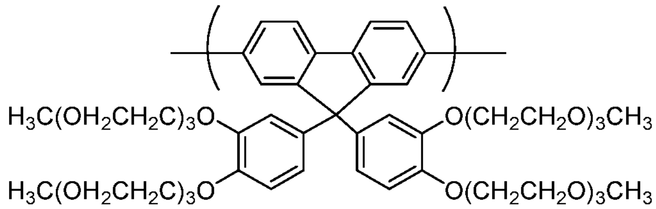

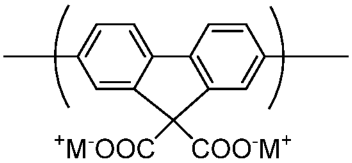

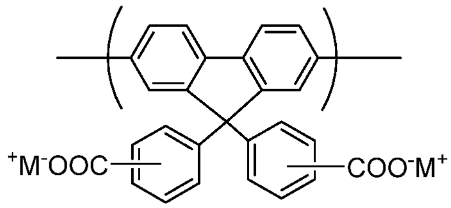

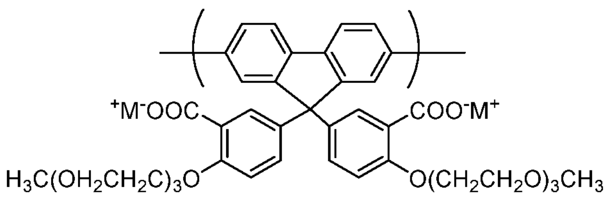

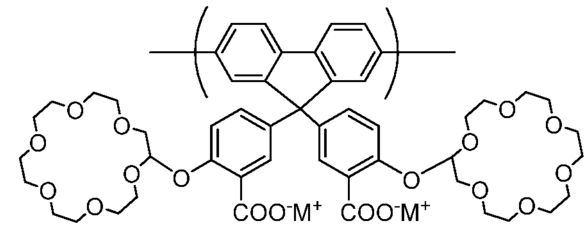

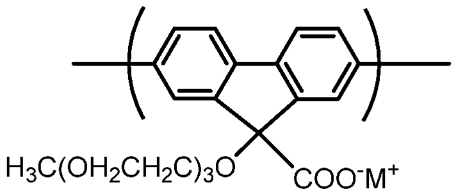

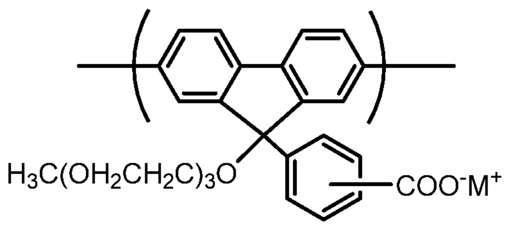

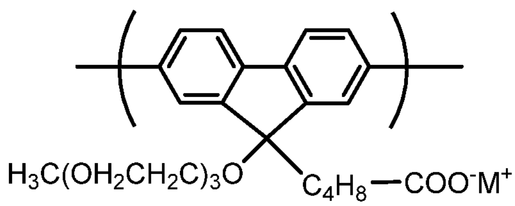

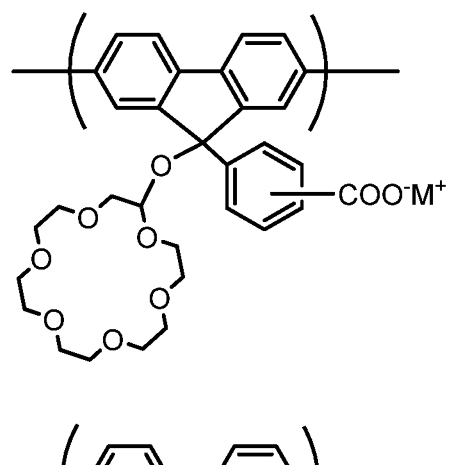

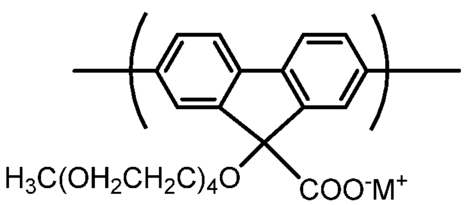

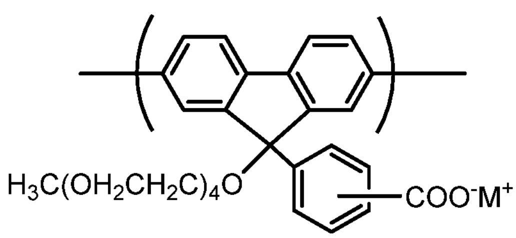

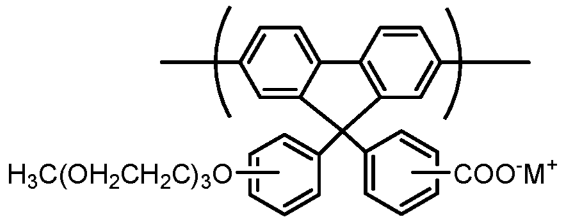

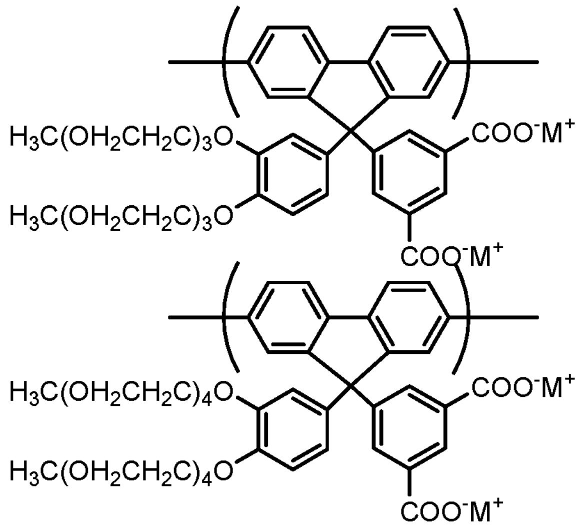

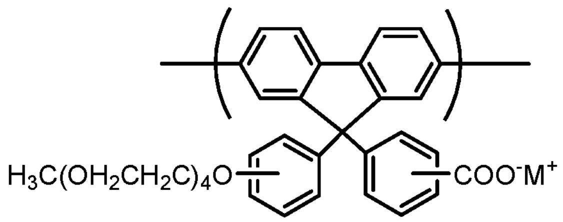

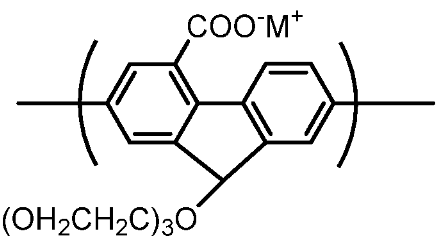

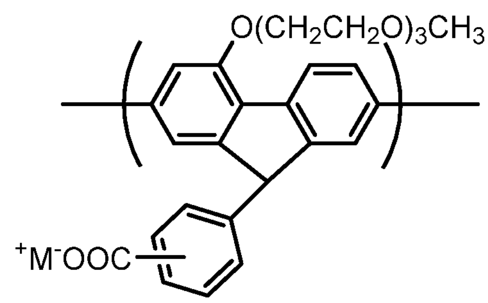

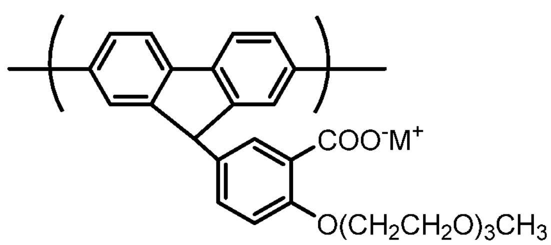

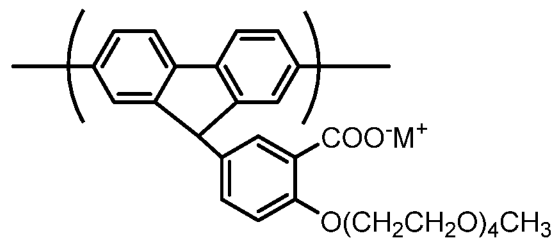

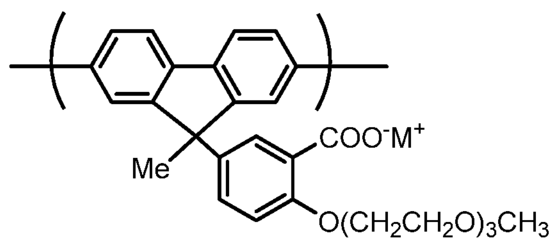

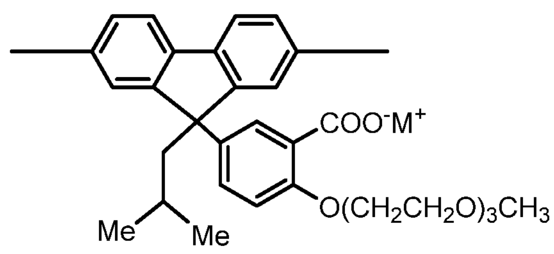

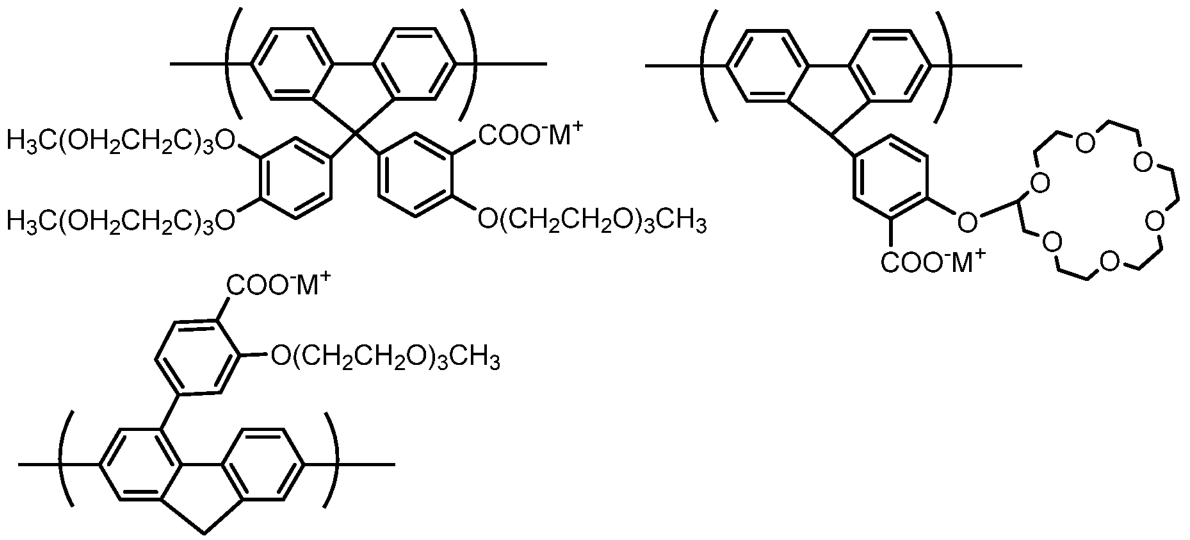

[wherein, $M^+$ represents the same meaning as described above. When a plurality of $M^+$ are present, they may be the same or different.]

The content of the constitutional unit represented by the formula (ET-1) is usually 30 to 100 mol% with respect to the content of all constitutional units contained in the polymer compound, and it is preferably 50 to 100 mol%, more preferably 70 to 100 mol% because the driving voltage of the light emitting device lowers.

The constitutional unit represented by the formula (ET-1) may be contained singly or two or more kinds of the constitutional units represented by the formula (ET-1) may be contained in the polymer compound.

<Other constitutional units>

The polymer compound comprising a constitutional unit represented by the formula (ET-1) may further comprises at least one constitutional unit selected from the group consisting of a constitutional unit represented by the formula (Y) and a constitutional unit represented by the formula (X).

$$-\left[ Ar^{Y1} \right]- \qquad (Y)$$

[wherein, $Ar^{Y1}$ represents an arylene group, a divalent heterocyclic group or a divalent group in which at least one arylene group and at least one divalent heterocyclic group are bonded directly to each other, and these groups each optionally have a substituent.]

The arylene group represented by $Ar^{Y1}$ is more preferably a group represented by the formula (A-1), the formula (A-2), the formula (A-6) to (A-10), the formula (A-19) or the formula (A-20), further preferably a group represented by the formula (A-1), the formula (A-2), the formula (A-7), the formula (A-9) or the formula (A-19), and these groups each optionally have a substituent.

The divalent heterocyclic group represented by $Ar^{Y1}$ is more preferably a group represented by the formula (AA-1) to (AA-4), the formula (AA-10) to (AA-15), the formula (AA-18) to (AA-21), the formula (AA-33) or the formula (AA-34), further preferably a group represented by the formula (AA-4), the formula (AA-10), the formula (AA-12), the formula (AA-14) or the formula (AA-33), and these groups each optionally have a substituent.

The more preferable range and the further preferable range of the arylene group and the divalent heterocyclic group in the divalent group in which at least one arylene group and at least one divalent heterocyclic group are bonded directly to each other represented by $Ar^{Y1}$ are the same as the more preferable range and the further preferable range of the arylene group and the divalent heterocyclic group represented by $Ar^{Y1}$ described above, respectively.

"The divalent group in which at least one arylene group and at least one divalent heterocyclic group are bonded directly to each other" includes, for example, groups represented by the following formulae, and each of them optionally has a substituent.

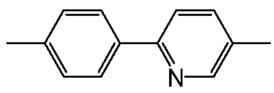 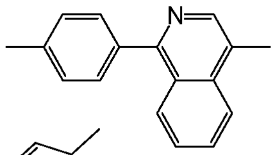 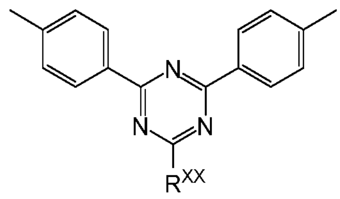

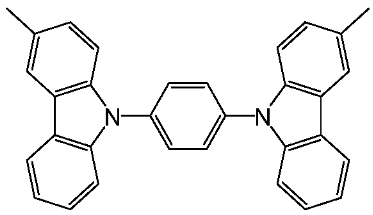

[wherein, $R^{XX}$ represents a hydrogen atom, an alkyl group, a cycloalkyl group, an aryl group or a monovalent heterocyclic group, and these groups each optionally have a substituent.]

$R^{XX}$ is preferably an alkyl group, a cycloalkyl group or an aryl group, and these groups each optionally have a substituent.

The substituent which the group represented by $Ar^{Y1}$ optionally has is preferably an alkyl group, a cycloalkyl group or an aryl group, and these groups each optionally further have a substituent.

The constitutional unit represented by the formula (Y) includes, for example, constitutional units represented by the formulae (Y-1) to (Y-10), and from the standpoint of the luminance life of the light emitting device preferable are constitutional units represented by the formulae (Y-1) to (Y-3), from the standpoint of electron transportability preferable are constitutional units represented by the formulae (Y-4) to (Y-7), and from the standpoint of hole transportability preferable are constitutional units represented by the formulae (Y-8) to (Y-10).

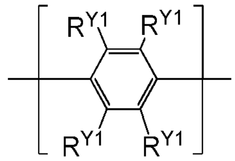 (Y-1)

[wherein, $R^{Y1}$ represents a hydrogen atom, an alkyl group, a cycloalkyl group, an alkoxy group, a cycloalkoxy group, an aryl group or a monovalent heterocyclic group, and these groups each optionally have a substituent. The plurality of $R^{Y1}$ may be the same or different, and adjacent $R^{Y1}$s may be combined together to form a ring together with the carbon atoms to which they are attached.]

$R^{Y1}$ is preferably a hydrogen atom, an alkyl group, a cycloalkyl group or an aryl group, and these groups each optionally have a substituent.

The constitional unit represented by the formula (Y-1) is preferably a constitutional unit represented by the formula (Y-1').

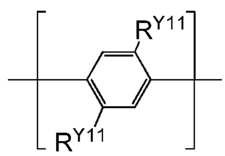 (Y-1')

[wherein, $R^{Y11}$ represents an alkyl group, a cycloalkyl group, an alkoxy group, a cycloalkoxy group, an aryl group or a monovalent heterocyclic group, and these groups each optionally have a substituent. The plurality of $R^{Y11}$ may be the same or different.]

$R^{Y11}$ is preferably an alkyl group, a cycloalkyl group or an aryl group, more preferably an alkyl group or a cycloalkyl group, and these groups each optionally have a substituent.

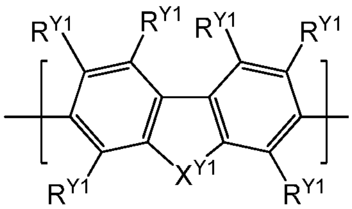 (Y-2)

[wherein, $R^{Y1}$ represents the same meaning as described above. $X^{Y1}$ represents a group represented by $-C(R^{Y2})_2-$, $-C(R^{Y2})=C(R^{Y2})-$ or $-C(R^{Y2})_2-C(R^{Y2})_2-$. $R^{Y2}$ represents a hydrogen atom, an alkyl group, a cycloalkyl group, an alkoxy group, a cycloalkoxy group, an aryl group or a monovalent heterocyclic group and these groups each optionally have a substituent. The plurality of $R^{Y2}$ may be the same or different, and groups $R^{Y2}$ may be combined together to form a ring together with the carbon atoms to which they are attached.]

$R^{Y2}$ is preferably an alkyl group, a cycloalkyl group, an aryl group or a monovalent heterocyclic group, more preferably an alkyl group a cycloalkyl group or an aryl group, and these groups each optionally have a substituent.

Regarding the combination of two $R^{Y2}$s in the group represented by $-C(R^{Y2})_2$ - in $X^{Y1}$, it is preferable that the both are an alkyl group, the both are an aryl group, the both are a monovalent heterocyclic group, or one is an alkyl group and the other is an aryl group or a monovalent heterocyclic group, it is more preferable that one is an alkyl group or cycloalkyl group and the other is an aryl group, and these groups each optionally have a substituent. The two groups $R^{Y2}$ may be combined together to form a ring together with the atoms to which they are attached, and when the groups $R^{Y2}$ form a ring, the group represented by $-C(R^{Y2})_2-$ is preferably a group represented by the formula (Y-A1) to (Y-A5), more preferably a group represented by the formula (Y-A4), and these groups each optionally have a substituent.

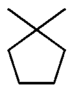 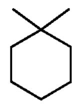 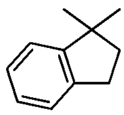 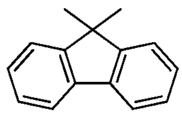 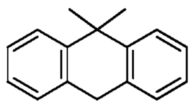

(Y-A1) (Y-A2) (Y-A3) (Y-A4) (Y-A5)

Regarding the combination of two $R^{Y2}$s in the group represented by $-C(R^{Y2})=C(R^{Y2})-$ in $X^{Y1}$, it is preferable that the both are an alkyl group or cycloalkyl group, or one is an alkyl group or a cycloalkyl group and the other is an aryl group, and these groups each optionally have a substituent.

Four $R^{Y2}$ s in the group represented by $-C(R^{Y2})_2-C(R^{Y2})_2$ - in $X^{Y1}$ are preferably an alkyl group or a cycloalkyl group each optionally having a substituent. The plurality of $R^{Y2}$ may be combined together to form a ring together with the atoms to which they are attached, and when the groups $R^{Y2}$ form a ring, the group represented by $-C(R^{Y2})_2-C(R^{Y2})_2-$ is preferably a group represented by the formula (Y-B1) to (Y-B5), more preferably a group represented by the formula (Y-B3), and these groups each optionally have a substituent.

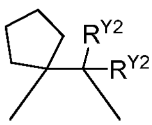 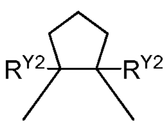 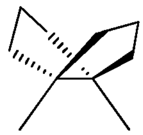 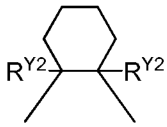 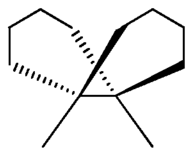

(Y-B1) (Y-B2) (Y-B3) (Y-B4) (Y-B5)

[wherein, $R^{Y2}$ represents the same meaning as described above.]

The constitutional unit represented by the formula (Y-2) is preferably a constitutional unit represented by the formula (Y-2').

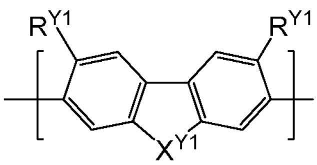 (Y-2')

[wherein, $R^{Y1}$ and $X^{Y1}$ represent the same meaning as described above.]

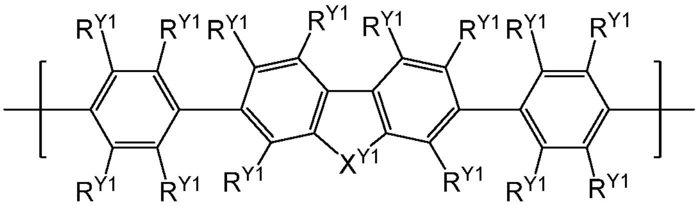

(Y-3)

[wherein, $R^{Y1}$ and $X^{Y1}$ represent the same meaning as described above.]

The constitutional unit represented by the formula (Y-3) is preferably a constitutional unit represented by the formula (Y-3').

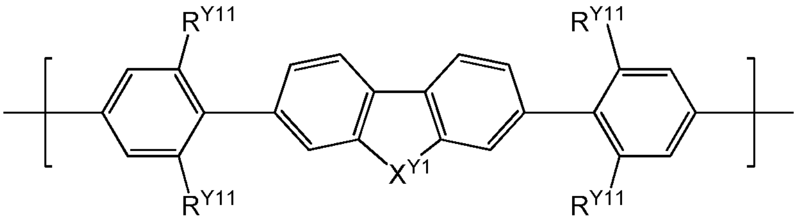

(Y-3')

[wherein, $R^{Y11}$ and $X^{Y1}$ represent the same meaning as described above.]

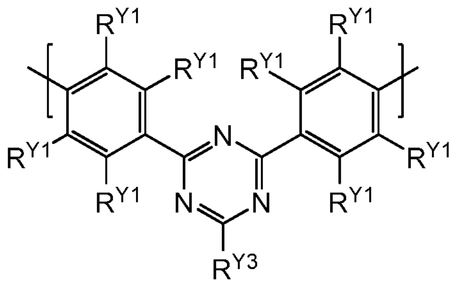

(Y-4)

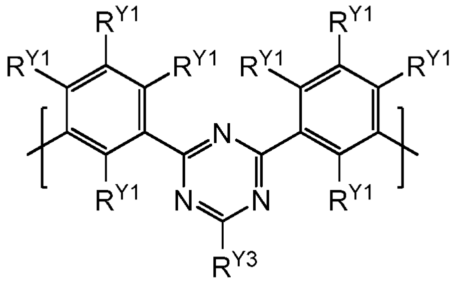

(Y-5)

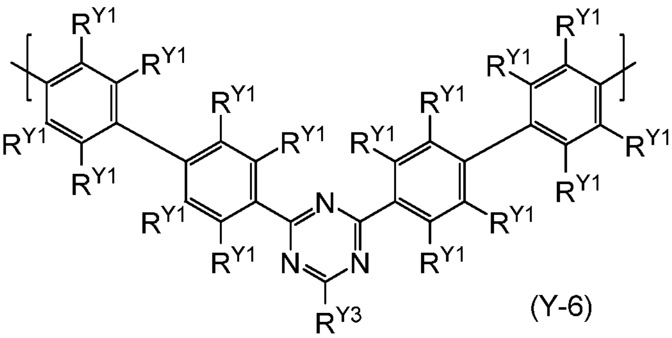

(Y-6)

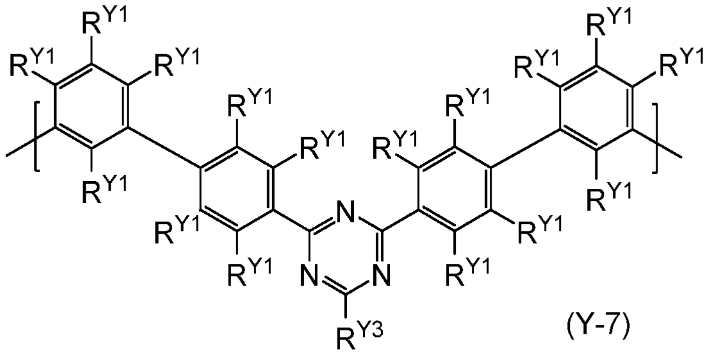

(Y-7)

[wherein, $R^{Y1}$ represents the same meaning as described above. $R^{Y3}$ represents a hydrogen atom, an alkyl group, a cycloalkyl group, an alkoxy group, a cycloalkoxy group, an aryl group or a monovalent heterocyclic group and these groups each optionally have a substituent.]

$R^{Y3}$ is preferably an alkyl group, a cycloalkyl group, an alkoxy group, a cycloalkoxy group, an aryl group or a monovalent heterocyclic group, more preferably an aryl group, and these groups each optionally have a substituent.

The constitutional unit represented by the formula (Y-4) is preferably a constitutional unit represented by the formula (Y-4'), and the constitutional unit represented by the formula (Y-6) is preferably a constitutional unit represented by the formula (Y-6').

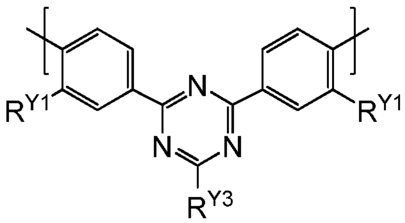

(Y-4')

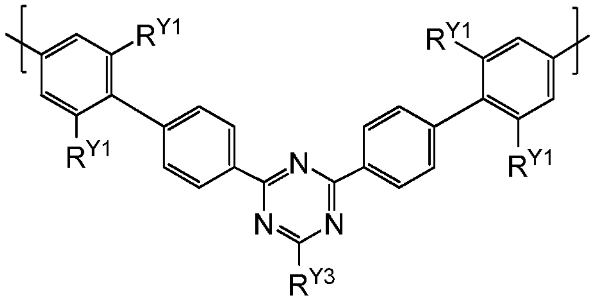

(Y-6')

[wherein, $R^{Y1}$ and $R^{Y3}$ represent the same meaning as described above.]

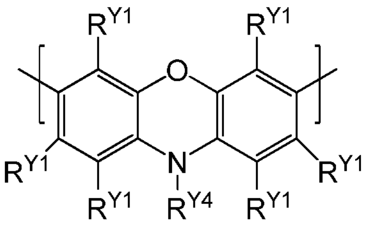

(Y-8)

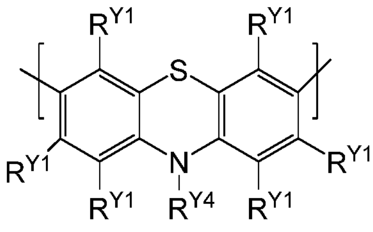

(Y-9)

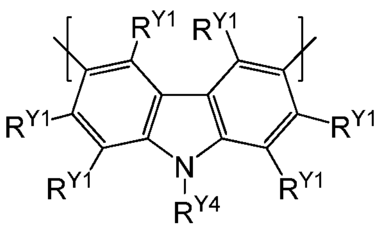

(Y-10)

[wherein, $R^{Y1}$ represents the same meaning as described above. $R^{Y4}$ represents a hydrogen atom, an alkyl group, a cycloalkyl group, an alkoxy group, a cycloalkoxy group, an aryl group or a monovalent heterocyclic group, and these groups each optionally have a substituent.]

$R^{Y4}$ is preferably an alkyl group, a cycloalkyl group, an alkoxy group, a cycloalkoxy group, an aryl group or a monovalent heterocyclic group, more preferably an aryl group, and these groups each optionally have a substituent.

The constitutional unit represented by the formula (Y) includes, for example, a constitutional unit composed of an arylene group represented by the formula (Y-101) to (Y-121), a constitutional unit composed of a divalent heterocyclic group represented by the formula (Y-201) to (Y-206), and a constitutional unit composed of a divalent group in which at least one arylene group and at least one divalent heterocyclic group are bonded directly to each other represented by the formula (Y-301) to (Y-304).

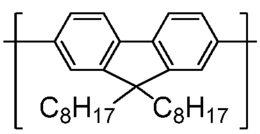
(Y-101)

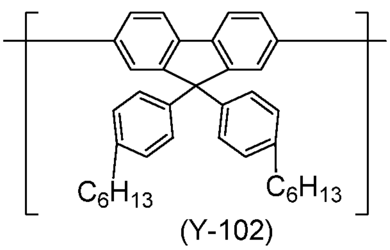
(Y-102)

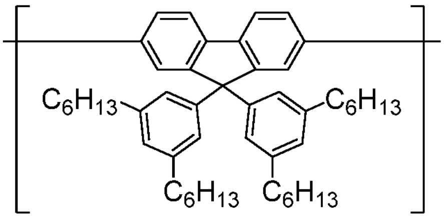
(Y-103)

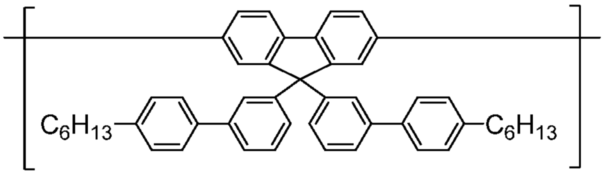
(Y-104)

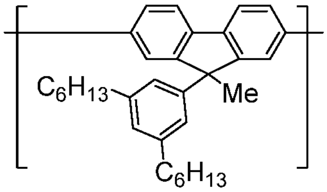
(Y-105)

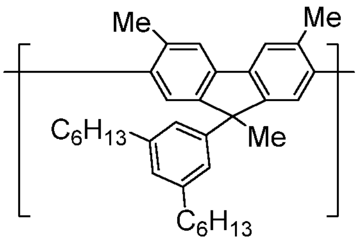
(Y-106)

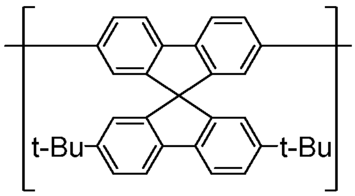
(Y-107)

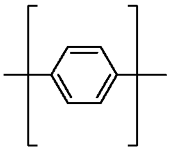
(Y-108)

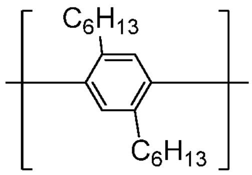
(Y-109)

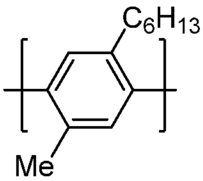
(Y-110)

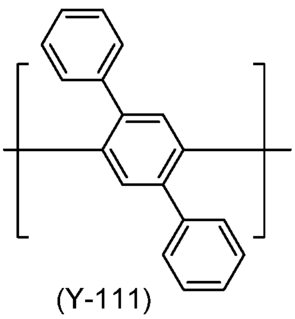
(Y-111)

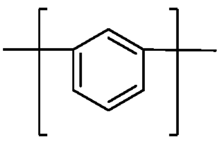
(Y-112)

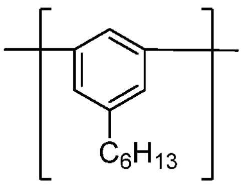
(Y-113)

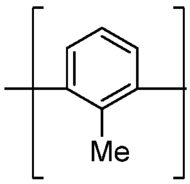
(Y-114)

[0257]

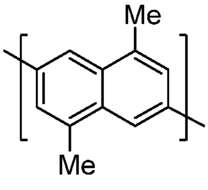
(Y-115)

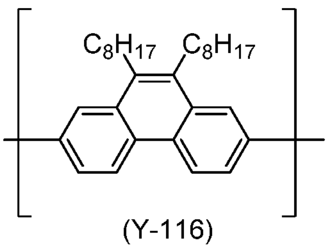
(Y-116)

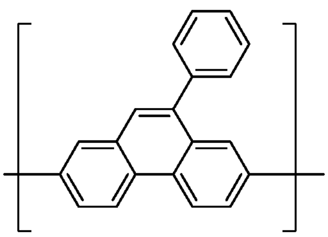
(Y-117)

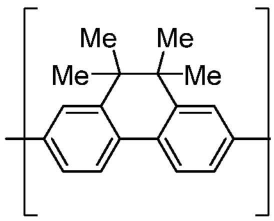
(Y-118)

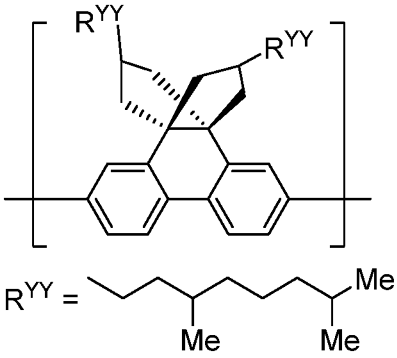

(Y-119)

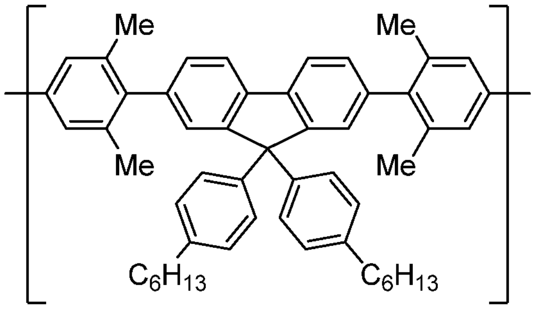

(Y-120)

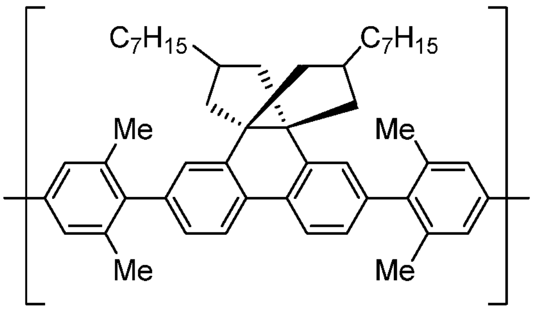

(Y-121)

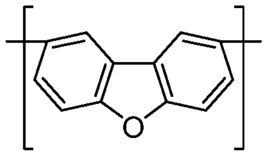

(Y-201)

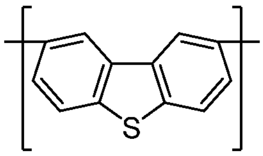

(Y-202)

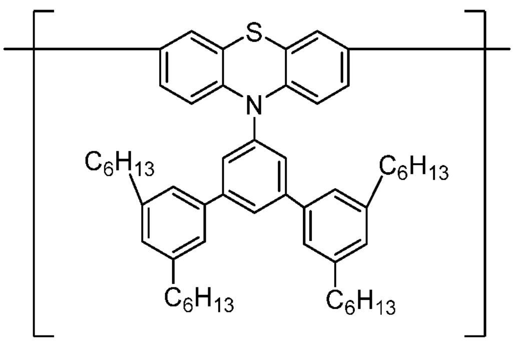

(Y-203)

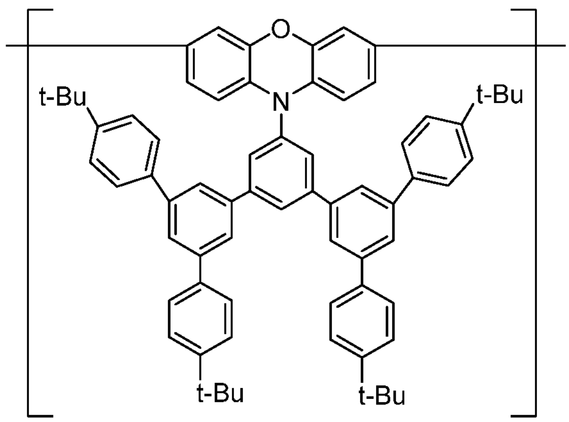

(Y-204)

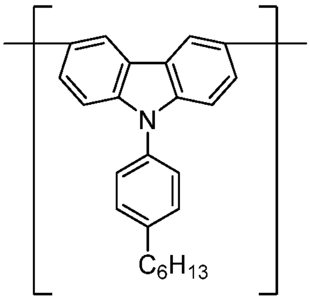

(Y-205)

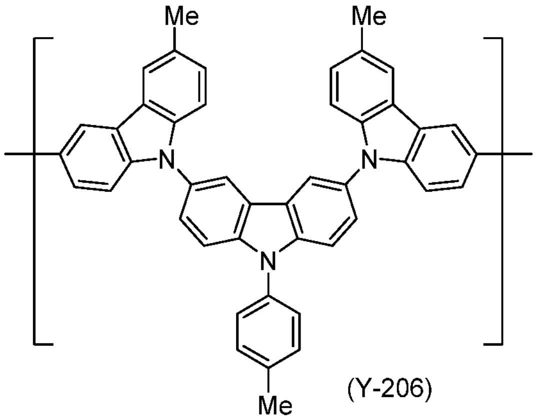

(Y-206)

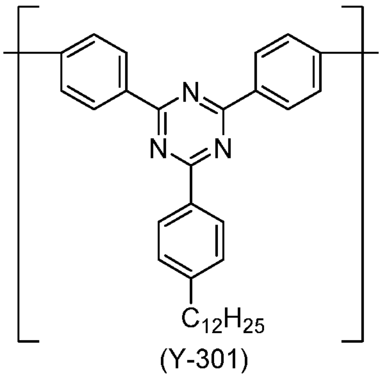

(Y-301)

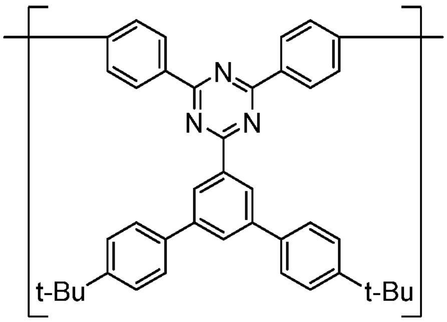

(Y-302)

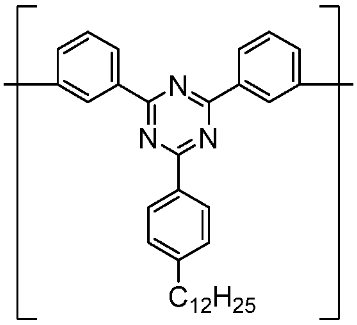

(Y-303)

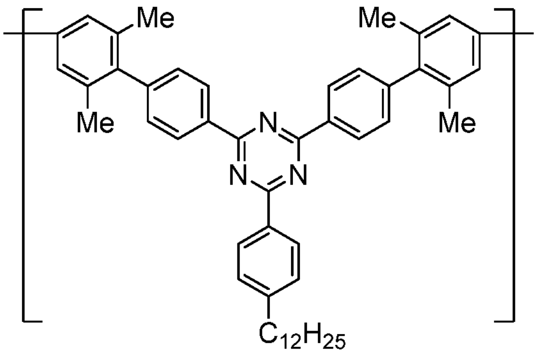

(Y-304)

The amount of the constitutional unit represented by the formula (Y) in which $Ar^{Y1}$ is an arylene group is preferably 0.5 to 80 mol%, more preferably 30 to 60 mol% with respect to the total amount of constitutional units contained in the polymer compound comprising a constitutional unit represented by the formula (ET-1) because the luminance life of the light emitting device is excellent.

The amount of the constitutional unit represented by the formula (Y) in which $Ar^{Y1}$ is a divalent heterocyclic group or a divalent group in which at least one arylene group and at least one divalent heterocyclic group are bonded directly to each other is preferably 0.5 to 30 mol%, more preferably 3 to 20 mol% with respect to the total amount of constitutional units contained in the polymer compound comprising a constitutional unit represented by the formula (ET-1) because the charge transportability of the light emitting device is excellent.

The constitutional unit represented by the formula (Y) may be contained only singly or two or more units thereof may be contained in the polymer compound comprising a constitutional unit represented by the formula (ET-1).

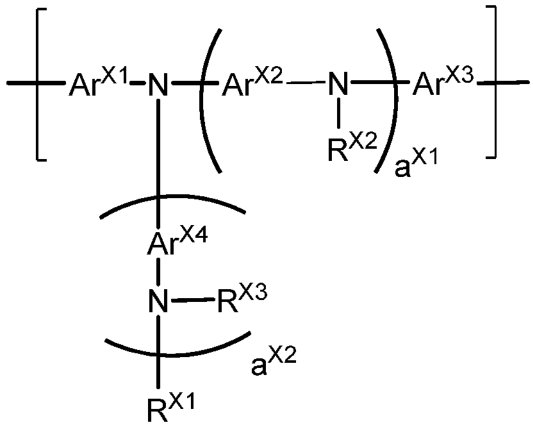

(X)

[wherein, $a^{X1}$ and $a^{X2}$ each independently represent an integer of 0 or more. $Ar^{X1}$ and $Ar^{X3}$ each independently represent an arylene group or a divalent heterocyclic group, and these groups each optionally have a substituent. $Ar^{X2}$ and $Ar^{X4}$ each independently represent an arylene group, a divalent heterocyclic group or a divalent group in which at least one arylene group and at least one divalent heterocyclic group are bonded directly to each other, and these groups each optionally have a substituent. When a plurality of $Ar^{X2}$ and $Ar^{X4}$ are present, they may be the same or different at each occurrence. $R^{X1}$, $R^{X2}$ and $R^{X3}$ each independently represent a hydrogen atom, an alkyl group, a cycloalkyl group, an aryl group or a monovalent heterocyclic group, and these groups each optionally have a substituent. When a plurality of $R^{X2}$ and $R^{X3}$ are present, they may be the same or different at each occurrence.]

$a^{X1}$ is preferably 2 or less, more preferably 1 because the luminance life of a light emitting device is excellent.

$a^{X2}$ is preferably 2 or less, more preferably 0 because the luminance life of a light emitting device is excellent.

$R^{X1}$, $R^{X2}$ and $R^{X3}$ are preferably an alkyl group, a cycloalkyl group, an aryl group or a monovalent heterocyclic group, more preferably an aryl group, and these groups each optionally have a substituent.

The arylene group represented by $Ar^{X1}$ and $Ar^{X3}$ is more preferably a group represented by the formula (A-1) or the formula (A-9), further preferably a group represented by the formula (A-1), and these groups each optionally have a substituent.

The divalent heterocyclic group represented by $Ar^{X1}$ and $Ar^{X3}$ is more preferably a group represented by the formula (AA-1), the formula (AA-2) or the formula (AA-7) to (AA-26), and these groups each optionally have a substituent.

$Ar^{X1}$ and $Ar^{X3}$ are preferably an arylene group optionally having a substituent.

The arylene group represented by $Ar^{X2}$ and $Ar^{X4}$ is more preferably a group represented by the formula (A-1), the formula (A-6), the formula (A-7), the formula (A-9) to (A-11) or the formula (A-19), and these groups each optionally have a substituent.

The more preferable range of the divalent heterocyclic group represented by $Ar^{X2}$ and $Ar^{X4}$ is the same as the more preferable range of the divalent heterocyclic group represented by $Ar^{X1}$ and $Ar^{X3}$.

The more preferable range and the further preferable range of the arylene group and the divalent heterocyclic group in the divalent group in which at least one arylene group and at least one divalent heterocyclic group are bonded directly to each other represented by $Ar^{X2}$ and $Ar^{X4}$ are the same as the more preferable range and the further preferable range of the arylene group and the divalent heterocyclic group represented by $Ar^{X1}$ and $Ar^{X3}$, respectively.

The divalent group in which at least one arylene group and at least one divalent heterocyclic group are bonded directly to each other represented by $Ar^{X2}$ and $Ar^{X4}$ includes the same groups as the divalent group in which at least one arylene group and at least one divalent heterocyclic group are bonded directly to each other represented by $Ar^{Y1}$ in the formula (Y).

$Ar^{X2}$ and $Ar^{X4}$ are preferably an arylene group optionally having a substituent.

The substituent which the group represented by $Ar^{X1}$ to $Ar^{X4}$ and $R^{X1}$ to $R^{X3}$ optionally has is preferably an alkyl group, a cycloalkyl group or an aryl group, and these groups each optionally further have a substituent.

The constitutional unit represented by the formula (X) is preferably a constitutional unit represented by the formula (X-1) to (X-7), more preferably a constitutional unit represented by the formula (X-1) to (X-6), further preferably a constitutional unit represented by the formula (X-3) to (X-6).

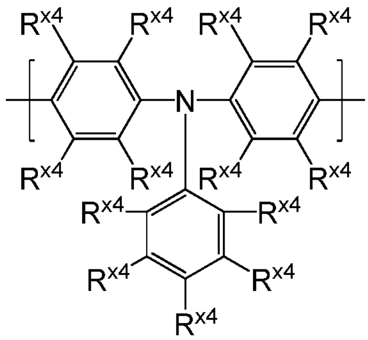

(X-1)

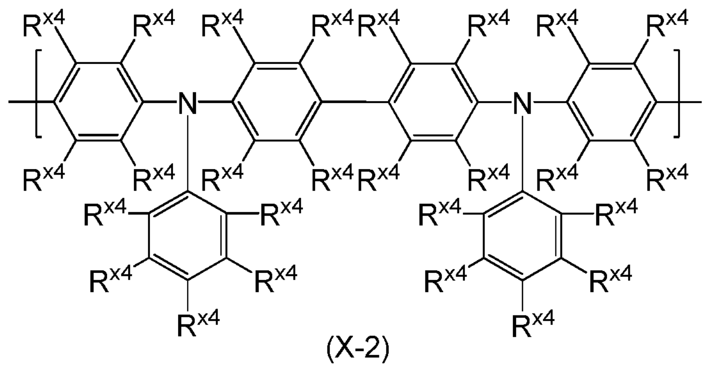

(X-2)

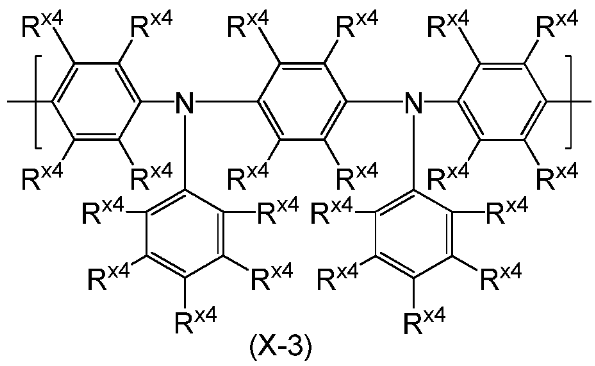

(X-3)

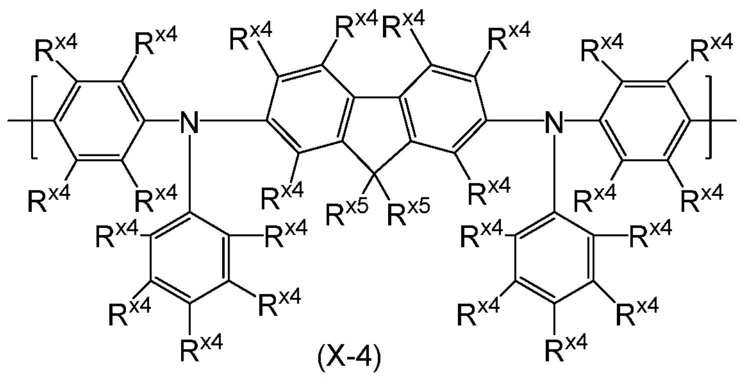

(X-4)

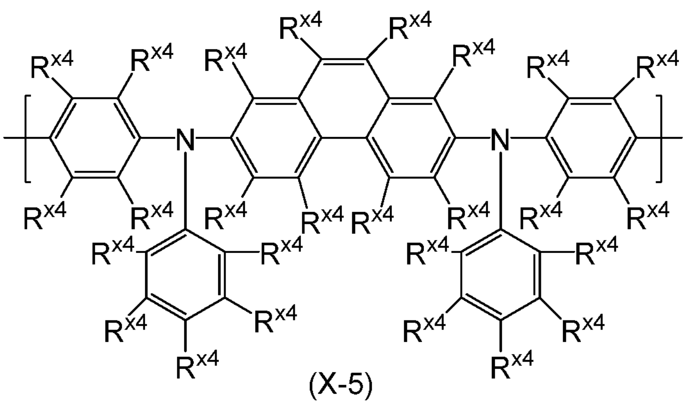

(X-5)

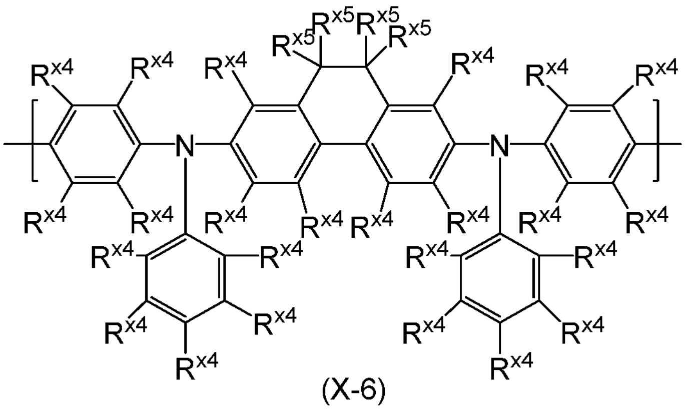

(X-6)

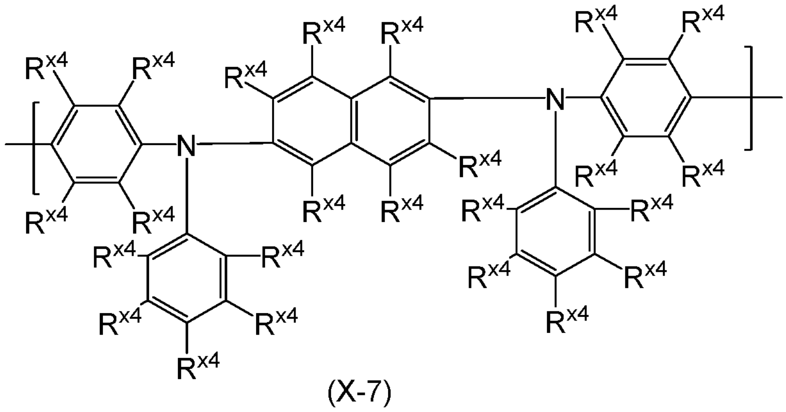

(X-7)

[wherein, $R^{X4}$ and $R^{X5}$ each independently represent a hydrogen atom, an alkyl group, a cycloalkyl group, an alkoxy group, a cycloalkoxy group, an aryl group, an aryloxy group, a halogen atom, a monovalent heterocyclic group or a cyano group, and these groups each optionally have a substituent. The plurality of $R^{X4}$ may be the same or different. The plurality of $R^{X5}$ may be the same or different, and adjacent groups $R^{X5}$ may be combined together to form a ring together with the carbon atoms to which they are attached.]

The amount of the constitutional unit represented by the formula (X) is preferably 0.1 to 50 mol%, more preferably 1 to 40 mol%, further preferably 5 to 30 mol% with respect to the total amount of constitutional units contained in the polymer compound comprising a constitutional unit represented by the formula (ET-1) because the luminance life of the light emitting device is excellent.

The constitutional unit represented by the formula (X) includes, for example, constitutional units represented by the formulae (X1-1) to (X1-11), preferably constitutional units represented by the formulae (X1-3) to (X1-10).

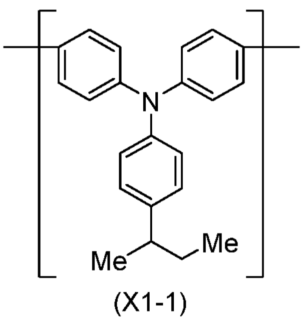

(X1-1)

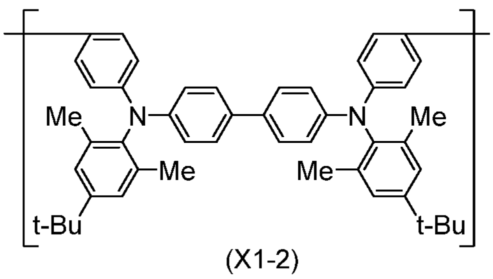

(X1-2)

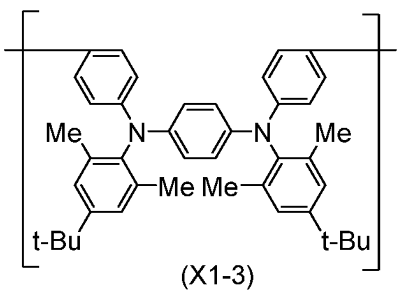

(X1-3)

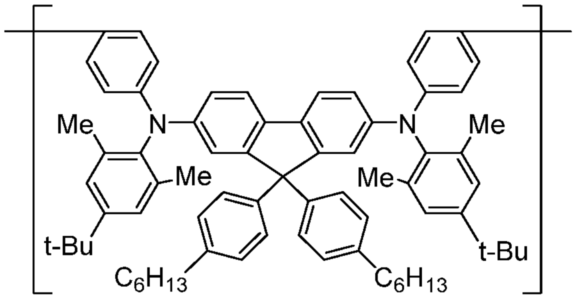
(X1-4)

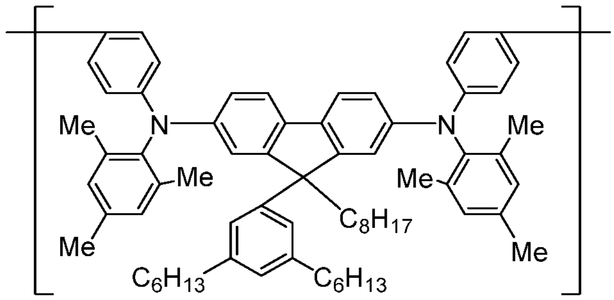
(X1-5)

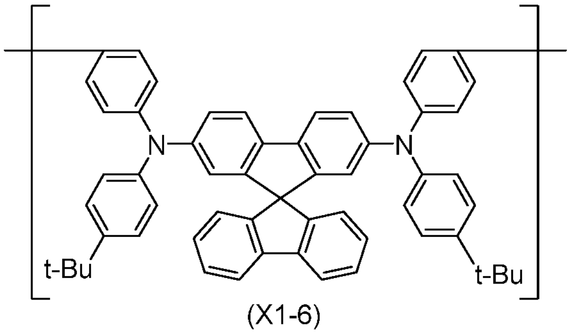
(X1-6)

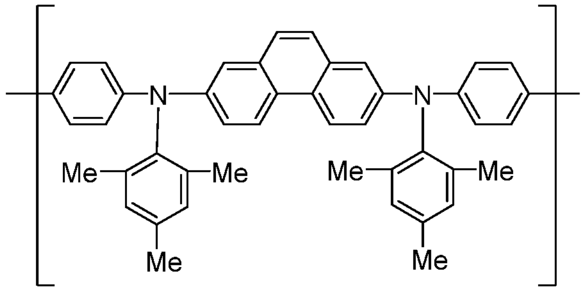
(X1-7)

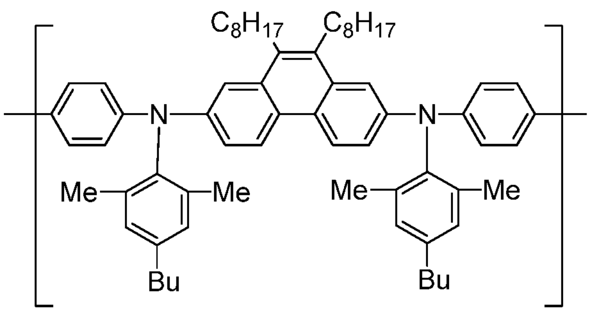
(X1-8)

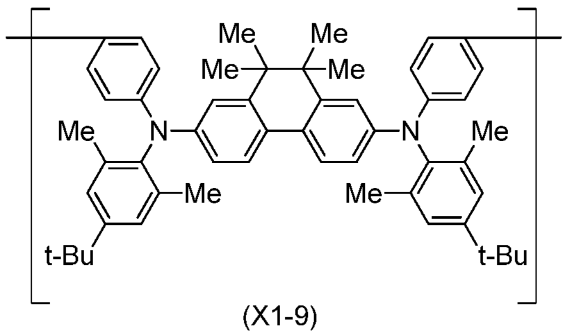
(X1-9)

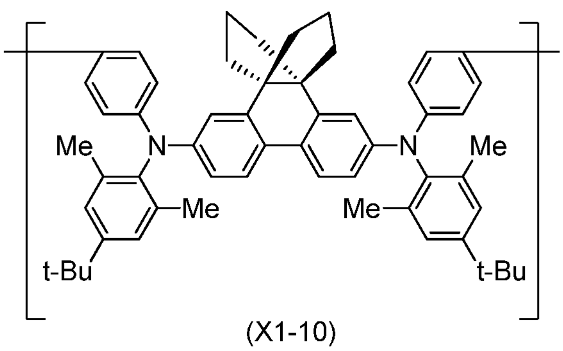
(X1-10)

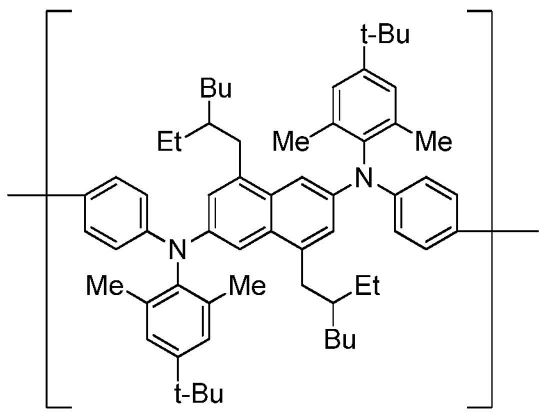
(X1-11)

The constitutional unit represented by the formula (X) may be contained only singly or two or more units thereof may be contained in the polymer compound comprising a constitutional unit represented by the formula (ET-1).

The polymer compound of the present invention includes, for example, polymer compounds P-1 to P-14 listed in the Table 1. "Other constitutional unit" denotes a constitutional unit other than the constitutional units represented by the formula (ET-1), the formula (X) and the formula (Y).

[Table 1]

| polymer compound | constitutional unit and mole fraction thereof | | | | | |
|---|---|---|---|---|---|---|
| | formula (ET-1) | formula (Y) | | | formula (X) | other |
| | | formulae (Y-1) to (Y-3) | formulae (Y-4) to (Y-7) | formulae (Y-8) to (Y-10) | formulae (X-1) to (X-7) | |
| | p' | q' | r' | s' | t' | u' |
| P-1 | 70 to 100 | 0 | 0 | 0 | 0 | 0 to 30 |
| P-2 | 0.1 to 99.9 | 0.1 to 99.9 | 0 | 0 | 0 | 0 to 30 |
| P-3 | 0.1 to 99.9 | 0 | 0.1 to 99.9 | 0 | 0 | 0 to 30 |
| P-4 | 0.1 to 99.9 | 0 | 0 | 0.1 to 99.9 | 0 | 0 to 30 |
| P-5 | 0.1 to 99.8 | 0.1 to 99.8 | 0.1 to 99.8 | 0 | 0 | 0 to 30 |
| P-6 | 0.1 to 99.8 | 0.1 to 99.8 | 0 | 0.1 to 99.8 | 0 | 0 to 30 |
| P-7 | 0.1 to 99.8 | 0 | 0.1 to 99.8 | 0.1 to 99.8 | 0 | 0 to 30 |
| P-8 | 0.1 to 99.8 | 0.1 to 99.8 | 0 | 0 | 0.1 to 99.8 | 0 to 30 |
| P-9 | 0.1 to 99.8 | 0 | 0.1 to 99.8 | 0 | 0.1 to 99.8 | 0 to 30 |
| P-10 | 0.1 to 99.8 | 0 | 0 | 0.1 to 99.8 | 0.1 to 99.8 | 0 to 30 |
| P-11 | 0.1 to 99.7 | 0.1 to 99.7 | 0.1 to 99.7 | 0 | 0.1 to 99.7 | 0 to 30 |
| P-12 | 0.1 to 99.7 | 0.1 to 99.7 | 0 | 0.1 to 99.7 | 0.1 to 99.7 | 0 to 30 |
| P-13 | 0.1 to 99.7 | 0 | 0.1 to 99.7 | 0.1 to 99.7 | 0.1 to 99.7 | 0 to 30 |
| P-14 | 0.1 to 99.6 | 0.1 to 99.6 | 0.1 to 99.6 | 0.1 to 99.6 | 0.1 to 99.6 | 0 to 30 |

[wherein, p', q', r', s', t' and u' represent the mole fraction of each constitutional unit. $p'+q'+r'+s'+t'+u' = 100$, and $100 \geq p'+q'+r'+s'+t' \geq 70$.]

For the aromatic polymer compound contained in the electron transporting layer (A) or the electron transporting layer (B), electron affinity RA (eV) and electron affinity RB (eV) can be controlled by selection of the above-described constitutional unit and adjustment of the molar ratio.

The aromatic compound contained in the electron transporting layer (A) is
preferably an aromatic polymer compound comprising a constitutional unit represented by the formula (ET-1) and at least one constitutional unit selected from the group consisting of a constitutional unit represented by the formula (Y-1'), a constitutional unit represented by the formula (Y-2''), a constitutional unit represented by the formula (Y-3'), a constitutional unit represented by the formula (Y-4'') and a constitutional unit represented by the formula (Y-6"),
more preferably an aromatic polymer compound comprising a constitutional unit represented by the formula (ET-1) and at least one constitutional unit selected from the group consisting of a constitutional unit represented by the formula (Y-1'), a constitutional unit represented by the formula (Y-2'') and a constitutional unit represented by the formula (Y-3'),

further preferably an aromatic polymer compound comprising a constitutional unit represented by the formula (ET-1) and a constitutional unit represented by the formula (Y-1').

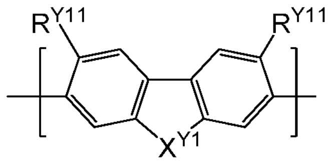

(Y-2")

[wherein, $R^{Y11}$ and $X^{Y1}$ represent the same meaning as described above.]

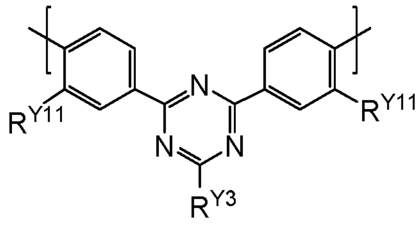

(Y-4")

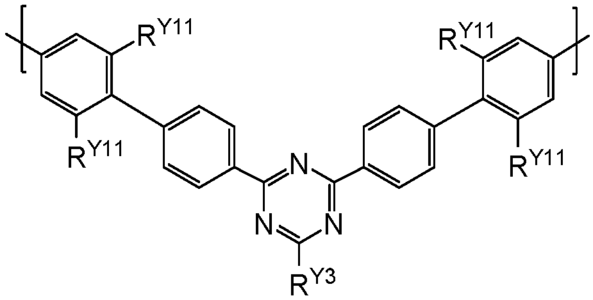

(Y-6")

[wherein, $R^{Y11}$ and $R^{Y3}$ represent the same meaning as described above.]

Of the above-described polymer compounds, P-1, P-2, P-4 to P-6 and P-8 to P-14 are preferable and P-1, P-2, P-6, P-8 and P-12 are more preferable as the aromatic polymer compound contained in the electron transporting layer (A) because electron affinity RA (eV) is lower.

Of the above-described polymer compounds, P-1, P-3 to 5, P-7, P-9, P-11, P-13 and P-14 are preferable and P-1, P-3, P-5, P-7, P-9, P-11, P-13 and P-14 are more preferable as the aromatic polymer compound contained in the electron transporting layer (B) because electron affinity RB (eV) is higher.

The polymer compound of the present invention can be produced by known polymerization methods described in JP-A No. 2012-033845, Chemical Review (Chem. Rev.), Vol No. 109, pp. 897-1091 (2009) and the like, for example, by methods of polymerization by a coupling reaction using a transition metal catalyst such as the Suzuki reaction, the Yamamoto reaction, the Buchwald reaction, the Stille reaction, the Negishi reaction and the Kumada reaction.

It is preferable that at least one of the compound contained in an amount of 5% by weight or more in the electron transporting layer (A) and the compound contained in an amount of 5% by weight or more in the electron transporting layer (B) is a compound having an aromatic heterocyclic ring, and it is more preferable that the compound contained in an amount of 5% by weight or more in the electron transporting layer (A) is a compound having an aromatic heterocyclic ring. The compound having an aromatic heterocyclic ring includes a compound having a carbazole structure, a compound having an azacarbazole structure, a compound having a diazacarbazole structure, a compound having a benzimidazole structure, a compound having an oxazole structure, a compound having a triazine structure, and the like.

The compound having an aromatic heterocyclic ring is preferably a compound represented by the formula (H-1) because the luminance life of the light emitting device is excellent. In particular, in one embodiment of the present invention, at least one of a compound contained in an amount of 5% by weight or more in the electron transporting layer (A) and a compound contained in an amount of 5% by weight or more in the electron transporting layer (B) is a compound having an aromatic heterocyclic ring represented by the formula (H-1).

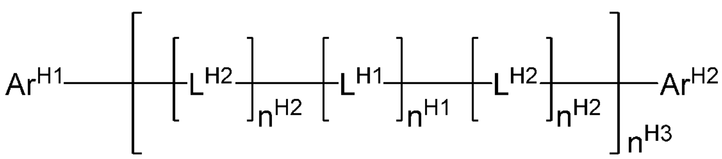

**(H-1)**

$Ar^{H1}$ and $Ar^{H2}$ are preferably a phenyl group, a fluorenyl group, a spirobifluorenyl group, a pyridyl group, a pyrimidinyl group, a triazinyl group, a quinolinyl group, an isoquinolinyl group, a thienyl group, a benzothienyl group, a

dibenzothienyl group, a furyl group, a benzofuryl group, a dibenzofuryl group, a pyrrolyl group, an indolyl group, an azaindolyl group, a carbazolyl group, an azacarbazolyl group, a diazacarbazolyl group, a phenoxazinyl group or a phenothiazinyl group, more preferably a phenyl group, a spirobifluorenyl group, a pyridyl group, a pyrimidinyl group, a triazinyl group, a dibenzothienyl group, a dibenzofuryl group, a carbazolyl group or an azacarbazolyl group, further preferably a phenyl group, a pyridyl group, a carbazolyl group or an azacarbazolyl group, particularly preferably a group represented by the following formula (TDA-1) or (TDA-3), especially preferably a group represented by the following formula (TDA-3) described above, and these groups each optionally have a substituent.

The substituent which $Ar^{H1}$ and $Ar^{H2}$ optionally have is preferably a halogen atom, an alkyl group, a cycloalkyl group, an alkoxy group, a cycloalkoxy group, an aryl group or a monovalent heterocyclic group, more preferably an alkyl group, a cycloalkoxy group, an alkoxy group or cycloalkoxy group, further preferably an alkyl group or cycloalkoxy group, and these groups each optionally further have a substituent.

$n^{H1}$ is preferably 1. $n^{H2}$ is preferably 0.

$n^{H3}$ is usually an integer of 0 to 10, preferably an integer of 0 to 5, further preferably an integer of 1 to 3, particularly preferably 1.

$n^{H11}$ is preferably an integer of 1 to 5, more preferably an integer of 1 to 3, further preferably 1.

$R^{H11}$ is preferably a hydrogen atom, an alkyl group, a cycloalkyl group, an aryl group or a monovalent heterocyclic group, more preferably a hydrogen atom, an alkyl group or a cycloalkyl group, further preferably a hydrogen atom or an alkyl group, and these groups each optionally have a substituent.

$L^{H1}$ is preferably an arylene group or a divalent heterocyclic group.

$L^{H1}$ is preferably a group represented by the formula (A-1) to (A-3), the formula (A-8) to (A-10), the formula (AA-1) to (AA-6), the formula (AA-10) to (AA-21) or the formula (AA-24) to (AA-34), more preferably a group represented by the formula (A-1), the formula (A-2), the formula (A-8), the formula (A-9), the formula (AA-1) to (AA-4), the formula (AA-10) to (AA-15) or the formula (AA-29) to (AA-34), further preferably a group represented by the formula (A-1), the formula (A-2), the formula (A-8), the formula (A-9), the formula (AA-2), the formula (AA-4) or the formula (AA-10) to (AA-15), particularly preferably a group represented by the formula (A-1), the formula (A-2), the formula (A-8), the formula (AA-2), the formula (AA-4), the formula (AA-10), the formula (AA-12) or the formula (AA-14), especially preferably a group represented by the formula (A-1), the formula (A-2), the formula (AA-2), the formula (AA-4) or the formula (AA-14).

The substituent which $L^{H1}$ optionally has is preferably a halogen atom, an alkyl group, a cycloalkyl group, an alkoxy group, a cycloalkoxy group, an aryl group or a monovalent heterocyclic group, more preferably an alkyl group, an alkoxy group, an aryl group or a monovalent heterocyclic group, further preferably an alkyl group, an aryl group or a monovalent heterocyclic group, and these groups each optionally further have a substituent.

$L^{H21}$ is preferably a single bond or an arylene group, more preferably a single bond, and this arylene group optionally has a substituent.

The definition and examples of the arylene group or the divalent heterocyclic group represented by $L^{H21}$ are the same as the definition and examples of the arylene group or the divalent heterocyclic group represented by $L^{H1}$.

$R^{H21}$ is preferably an aryl group or a monovalent heterocyclic group, and these groups each optionally have a substituent.

The definition and examples of the aryl group and the monovalent heterocyclic group represented by $R^{H21}$ are the same as the definition and examples of the aryl group and the monovalent heterocyclic group represented by $Ar^{H1}$ and $Ar^{H2}$.

The definition and examples of the substituent which $R^{H21}$ may optionally has are the same as the definition and examples of the substituent which $Ar^{H1}$ and $Ar^{H2}$ optionally have.

The compound represented by the formula (H-1) is preferably a compound represented by the formula (H-2).

$$Ar^{H1}-\left[L^{H1}\right]_{n^{H3}}-Ar^{H2} \qquad \textbf{(H-2)}$$

As the compound represented by the formula (H-1), compounds represented by the following formulae (H-101) to (H-121) are exemplified.

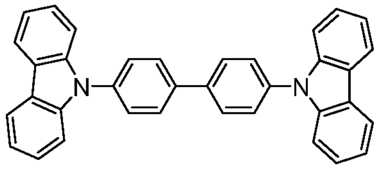

(H-101)

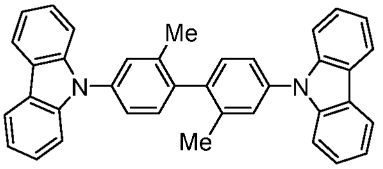

(H-102)

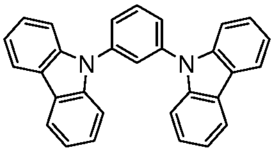

(H-103)

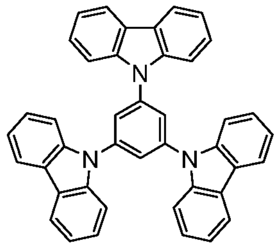

(H-104)

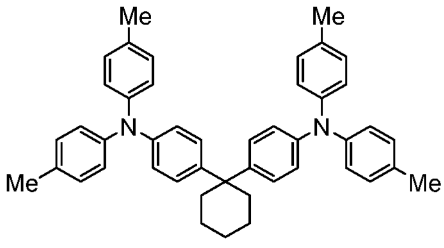

(H-105)

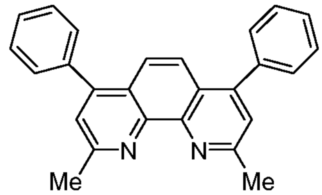

(H-106)

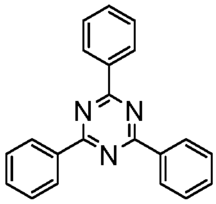

(H-107)

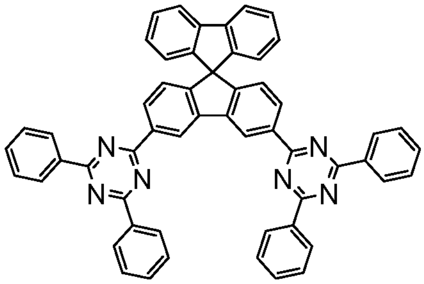

(H-108)

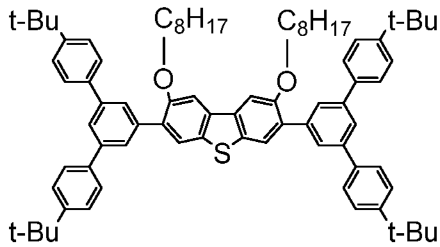

(H-109)

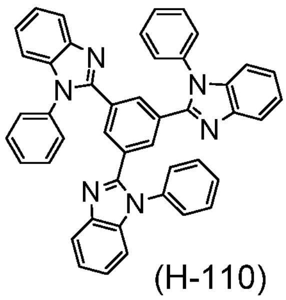

(H-110)

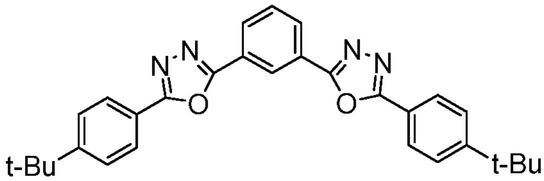

(H-111)

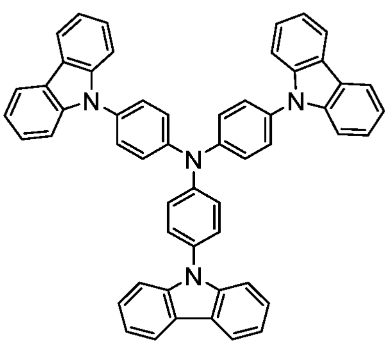

(H-112)

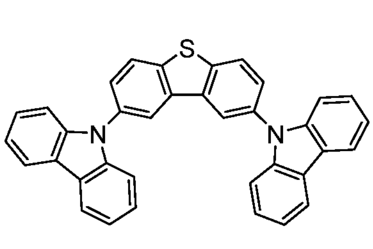

(H-113)

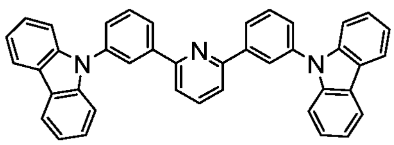

(H-114)

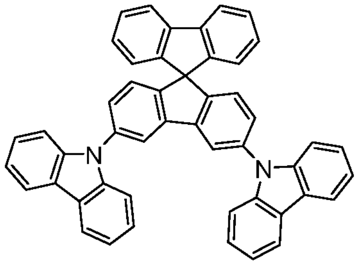
(H-115)

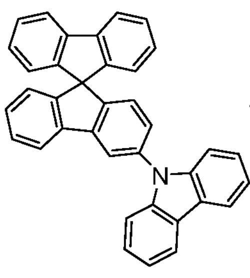
(H-116)

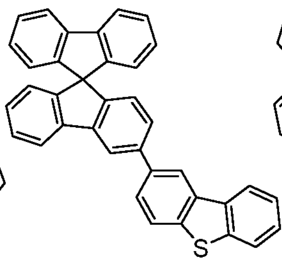
(H-117)

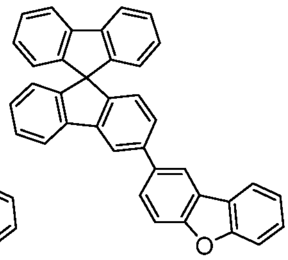
(H-118)

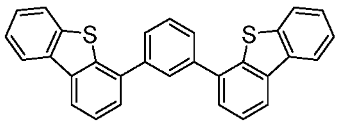
(H-119)

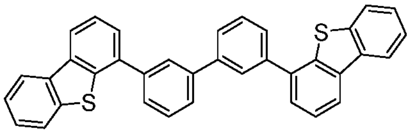
(H-120)

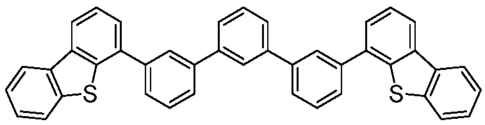
(H-121)

As the electron transporting material other than the polymer compound comprising a constitutional unit represented by the formula (ET-1) and the compound represented by the formula (H-1) in the light emitting device of the present invention, known electron transporting materials can be used, and triazole derivatives, oxazole derivatives, oxadiazole derivatives, imidazole derivatives, fluorene derivatives, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinone derivatives, anthraquinodimethane derivatives, anthrone derivatives, thiopyrandioxide derivatives, carbodiimide derivatives, fluorenylidenemethane derivatives, distyrylpyrazine derivatives, aromatic ring tetracarboxylic anhydrides such as naphthalene and perylene, phthalocyanine derivatives; various metal complexes typified by metal complexes of 8-quinolinol derivatives, metallophthalocyanines and metal complexes having benzoxazole or benzothiazole as a ligand; organosilane derivatives, metal complexes of 8-hydroxyquinoline and derivatives thereof, polyquinoline and derivatives thereof, polyquinoxaline and derivatives thereof, polyfluorene and derivatives thereof and the like are mentioned. Of them, triazole derivatives, oxadiazole derivatives, benzoquinone and derivatives thereof, anthraquinone and derivatives thereof, and metal complexes of 8-hydroxyquinoline and derivatives thereof, polyquinoline and derivatives thereof, polyquinoxaline and derivatives thereof and polyfluorene and derivatives thereof are preferable.

The electron transporting materials may be used each singly or two or more kinds of the electron transporting materials may be used in combination.

As the combination of the compound contained in an amount of 5% by weight or more in the electron transporting layer (A) and the compound contained in an amount of 5% by weight or more in the electron transporting layer (B),

a combination in which an aromatic polymer compound is contained in both the electron transporting layer (A) and the electron transporting layer (B), a combination in which a compound having an aromatic heterocyclic ring is contained in both the electron transporting layer (A) and the electron transporting layer (B), or a combination in which an aromatic polymer compound is contained in one of the electron transporting layer (A) and the electron transporting layer (B) and a compound having an aromatic heterocyclic ring is contained in the other is preferable,

a combination in which an aromatic polymer compound is contained in both the electron transporting layer (A) and the electron transporting layer (B), a combination in which a compound having an aromatic heterocyclic ring is contained in both the electron transporting layer (A) and the electron transporting layer (B), or a combination in which a compound having an aromatic heterocyclic ring is contained in the electron transporting layer (A) and an aromatic polymer compound is contained in the electron transporting layer (B) is more preferable,

a combination in which a compound having an aromatic heterocyclic ring is contained in the electron transporting layer (A) and an aromatic polymer compound is contained in the electron transporting layer (B) is further preferable.

As the aromatic polymer compound, a polymer compound comprising a constitutional unit represented by the formula (ET-1) is preferable, and as the compound having an aromatic heterocyclic ring, a compound represented by the formula (H-1) is preferable.

When two or more electron transporting layers are formed by an application method, it is preferable to use different solvents in suchi a manner that the lower layer is not dissolved in a solvent contained in the solution of a layer to be applied later.

When the lower layer is dissolvable in a solvent contained in the solution of a layer to be applied later in forming two or more electron transporting layers by an application method, the lower layer can be insolubilized in a solvent by

the same manner as exemplified for the formation method of a hole injection layer.

The thickness of each electron transporting layer is usually 1 nm to 1 μm, preferably 2 nm to 500 nm, more preferably 5 nm to 100 nm. The thickness of the electron transporting layer (A) and the thickness of the electron transporting layer (B) may be the same or different.

[Light emitting layer]

In the light emitting device of the present invention, the light emitting material may be used singly, however, in usual cases, the light emitting material is used in combination with a host material. The host material is a material which is used for the purpose of suppressing a decrease in light emission efficiency due to agglomeration of the light emitting material, and for the purpose of transporting charges, thereby attaining a decrease in the driving voltage.

In the light emitting device of the present invention, the light emitting material is classified into a low molecular weight compound and a polymer compound. The light emitting material optionally has a crosslinkable group.

Low molecular weight compounds include, for example, naphthalene and derivatives thereof, anthracene and derivatives thereof, perylene and derivatives thereof, and, triplet light emitting complexes having iridium, platinum or europium as the central metal.

The polymer compound includes, for example, polymer compounds comprising a phenylene group, a naphthalenediyl group, a fluorenediyl group, a phenanthrenediyl group, dihydrophenanthrenediyl group, a group represented by the formula (X), a carbazolediyl group, a phenoxazinediyl group, a phenothiazinediyl group, an anthracenediyl group, a pyrenediyl group and the like.

The light emitting material may comprise a low molecular weight compound and a polymer compound, and preferably, comprises a triplet light emitting complex and a polymer compound.

As the triplet light emitting complex, preferable are iridium complexes such as metal complexes represented by the formulae Ir-1 to Ir-5. In the light emitting device of the present invention, the phosphorescent light emitting layer must comprise an iridium complex represented by the formula Ir-1, Ir-2, Ir-3, Ir-4 or Ir-5.

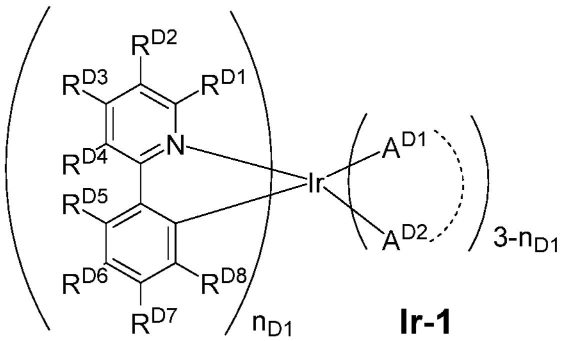

**Ir-1**

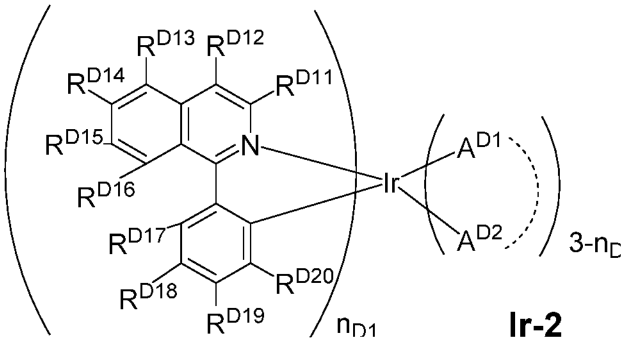

**Ir-2**

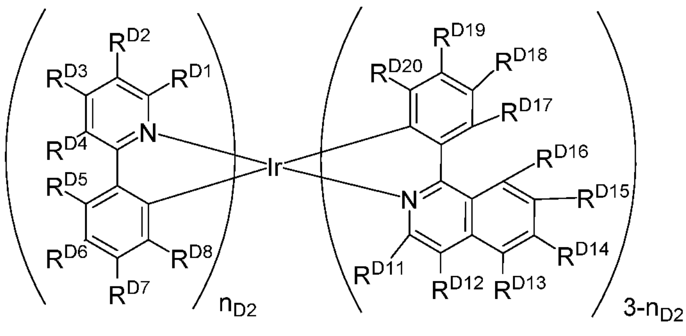

**Ir-3**

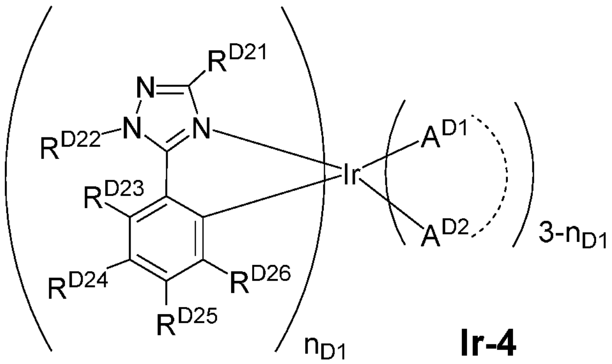

Ir-4

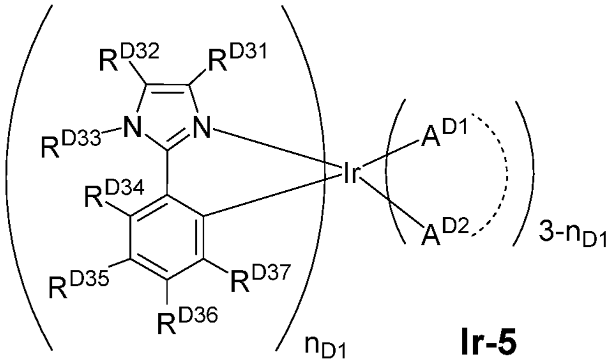

Ir-5

[wherein,

$R^{D1}$ to $R^{D8}$, $R^{D11}$ to $R^{D20}$, $R^{D21}$ to $R^{D26}$ and $R^{D31}$ to $R^{D37}$ each independently represent a hydrogen atom, an alkyl group, a cycloalkyl group, an alkoxy group, a cycloalkoxy group, an aryl group, an aryloxy group, a monovalent heterocyclic group or a halogen atom, and these groups each optionally have a substituent. When a plurality of $R^{D1}$ to $R^{D8}$ , $R^{D11}$ to $R^{D20}$, $R^{D21}$ to $R^{D26}$ and $R^{D31}$ to $R^{D37}$ are present, they may be the same or different at each occurrence.

$-A^{D1}$---$A^{D2}-$ represents an anionic bidentate ligand, and $A^{D1}$ and $A^{D2}$ each independently represent a carbon atom, an oxygen atom or a nitrogen atom linking to an iridium atom, and these atoms each may be an atom consisting a ring. When a plurality of $-A^{D1}$---$A^{D2}-$ are present, they may be the same or different.

$n_{D1}$ represents 1, 2 or 3, and $n_{D2}$ represents 1 or 2.]

In the metal complex represented by the formula Ir-1 in the light emitting device of the present invention, at least one of $R^{D1}$ to $R^{D8}$ is a group represented by the formula (D-A).

In the metal complex represented by the formula Ir-2 in the light emitting device of the present invention, at least one of $R^{D11}$ to $R^{D20}$ is a group represented by the formula (D -A) .

In the metal complex represented by the formula Ir-3 in the light emitting device of the present invention, at least one of $R^{D1}$ to $R^{D8}$ and $R^{D11}$ to $R^{D20}$ is a group represented by the formula (D-A).

In the metal complex represented by the formula Ir-4, at least one of $R^{D21}$ to $R^{D26}$ is preferably a group represented by the formula (D-A).

In the metal complex represented by the formula Ir-5, at least one of $R^{D31}$ to $R^{D37}$ is preferably a group represented by the formula (D-A).

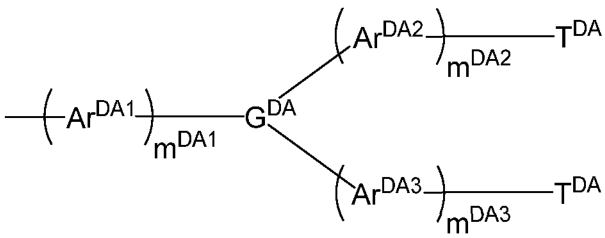

(D-A)

[wherein,

$m^{DA1}$, $m^{DA2}$ and $m^{DA3}$ each independently represent an integer of 0 or more.

$G^{DA}$ represents a nitrogen atom, an aromatic hydrocarbon group or a heterocyclic group, and these groups each optionally have a substituent.

$Ar^{DA1}$, $Ar^{DA2}$ and $Ar^{DA3}$ each independently represent an arylene group or a divalent heterocyclic group, and these groups each optionally have a substituent. When a plurality of $Ar^{DA1}$ , $Ar^{DA2}$ and $Ar^{DA3}$ are present, they may be the same or different at each occurrence.

$T^{DA}$ represents an aryl group or a monovalent heterocyclic group, and these groups each optionally have a substituent. The plurality of $T^{DA}$ may be the same or different.]

$m^{DA1}$, $m^{DA2}$ and $m^{DA3}$ are usually an integer of 10 or less, preferably an integer of 5 or less, more preferably 0 or 1. It is preferable that $m^{DA1}$, $m^{DA2}$ and $m^{DA3}$ are the same integer.

$G^{DA}$ is preferably a group represented by the formula (GDA-11) to (GDA-15), and these groups each optionally have a substituent.

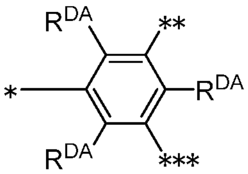
(GDA-11)

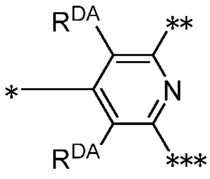
(GDA-12)

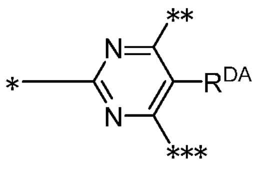
(GDA-13)

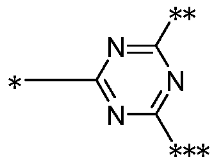
(GDA-14)

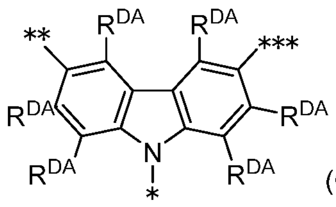
(GDA-15)

[wherein,

*, ** and *** each represent a linkage to $Ar^{DA1}$, $Ar^{DA2}$ and $Ar^{DA3}$.
$R^{DA}$ represents a hydrogen atom, an alkyl group, a cycloalkyl group, an alkoxy group, a cycloalkoxy group, an aryl group or a monovalent heterocyclic group, and these groups each optionally further have a substituent. When a plurality of $R^{DA}$ are present, they may be the same or different.]

$R^{DA}$ is preferably a hydrogen atom, an alkyl group, a cycloalkyl group, an alkoxy group or a cycloalkoxy group, more preferably a hydrogen atom, an alkyl group or cycloalkyl group, and these groups each optionally have a substituent.
$Ar^{DA1}$, $Ar^{DA2}$ and $Ar^{DA3}$ are preferably groups represented by the formulae (ArDA-1) to (ArDA-3).

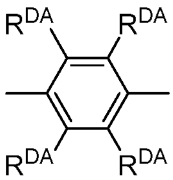
**(ArDA-1)**

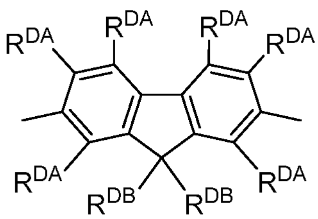
**(ArDA-2)**

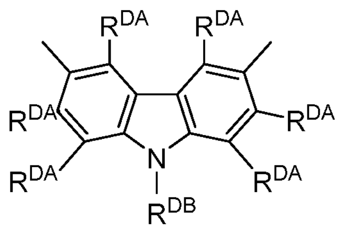
**(ArDA-3)**

[wherein,

$R^{DA}$ represents the same meaning as described above.
$R^{DB}$ represents a hydrogen atom, an alkyl group, a cycloalkyl group, an aryl group or a monovalent heterocyclic group, and these groups each optionally have a substituent. When a plurality of $R^{DB}$ are present, they may be the same or different.]

$T^{DA}$ is preferably groups represented by the formulae (TDA-1) to (TDA-3).

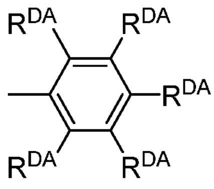

**(TDA-1)**

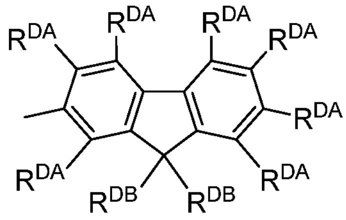

**(TDA-2)**

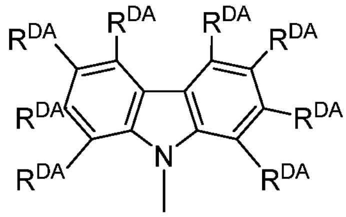

**(TDA-3)**

[wherein, $R^{DA}$ and $R^{DB}$ represent the same meaning described above.]

The group represented by the formula (D-A) is preferably a group represented by the formula (D-A1) to (D-A3).

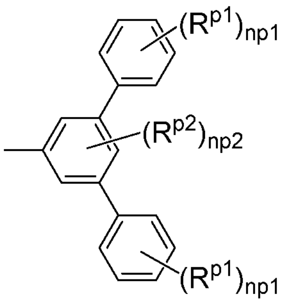

**(D-A1)**

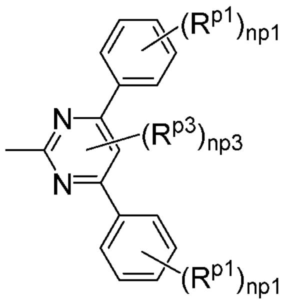

**(D-A2)**

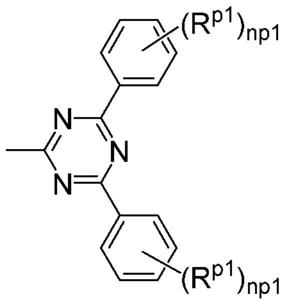

**(D-A3)**

[wherein,

$R^{p1}$, $R^{p2}$ and $R^{p3}$ each independently represent an alkyl group, a cycloalkyl group, an alkoxy group, a cycloalkoxy group or a halogen atom. When a plurality of $R^{p1}$ and $R^{p2}$ are present, they may be the same or different at each occurrence.

np1 represents an integer of 0 to 5, np2 represents an integer of 0 to 3, and np3 represents 0 or 1. The plurality of np1 may be the same or different.]

np1 is preferably an integer of 0 to 3, more preferably an integer of 1 to 3, further preferably 1. np2 is preferably 0 or 1, more preferably 0. np3 is preferably 0.

$R^{p1}$, $R^{p2}$ and $R^{p3}$ are preferably an alkyl group or a cycloalkyl group.

The anionic bidentate ligand represented by $-A^{D1}$---$A^{D2}-$ includes, for example, ligands represented by the following formulae.

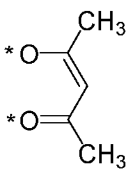

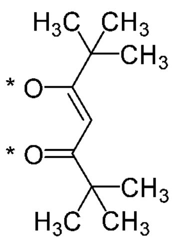

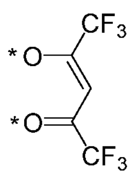

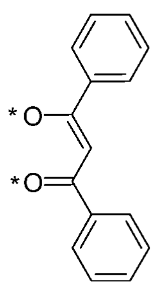

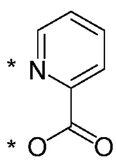

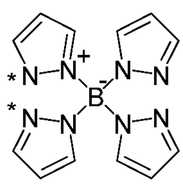

[wherein, * represents a position linking to Ir.]

The metal complex represented by the formula Ir-1 is preferably a metal complex represented by the formula Ir-11 to Ir-13. The metal complex represented by the formula Ir-2 is preferably a metal complex represented by the formula Ir-21. The metal complex represented by the formula Ir-3 is preferably a metal complexe represented by the formula Ir-31 to Ir-33. The metal complex represented by the formula Ir-4 is preferably a metal complex represented by the formula Ir-41 to Ir-43. The metal complex represented by the formula Ir-5 is preferably a metal complex represented by the formula Ir-51 to Ir-53.

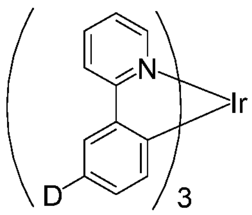

**Ir-11**

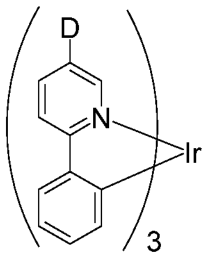

**Ir-12**

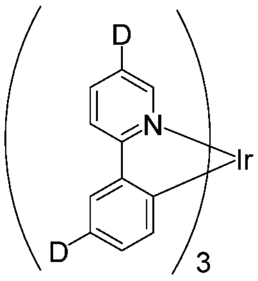

**Ir-13**

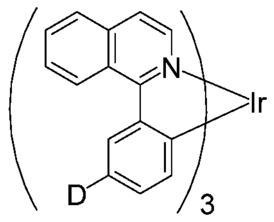

**Ir-21**

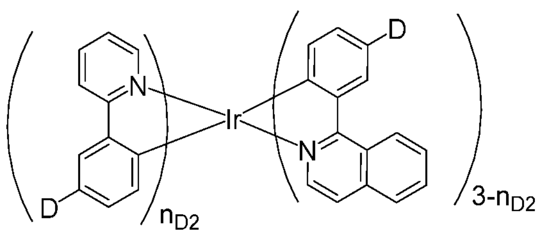

**Ir-31**

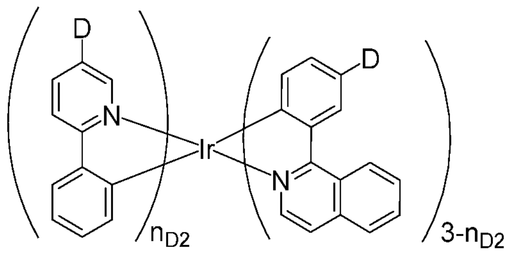

**Ir-32**

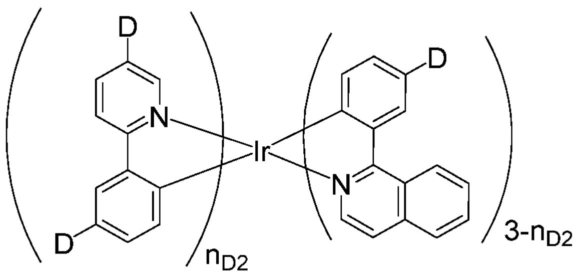

**Ir-33**

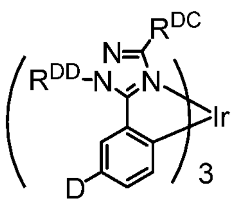

Ir-41

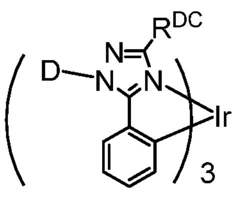

Ir-42

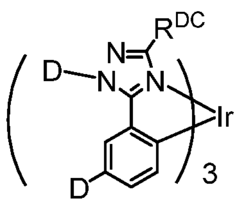

Ir-43

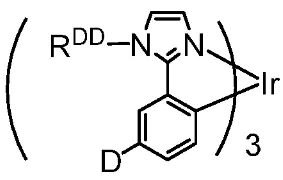

Ir-51

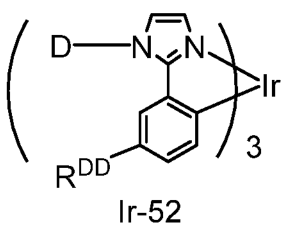

Ir-52

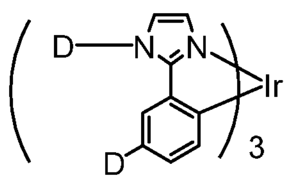

Ir-53

[wherein, $n_{D2}$ represents 1 or 2. D represents a group represented by the formula (D-A) . The plurality of D are the same or different. $R^{DC}$ represents a hydrogen atom, an alkyl group, a cycloalkyl group, an aryl group or a monovalent heterocyclic group, and these groups each optionally have a substituent. The plurality of $R^{DC}$ are the same or different. $R^{DD}$ represents an alkyl group, a cycloalkyl group, an aryl group or a monovalent heterocyclic group, and these groups each optionally have a substituent. The plurality of $R^{DD}$ are the same or different.]

The triplet light emitting complex includes, for example, metal complexes listed below.

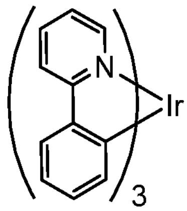

Ir(ppy)$_3$

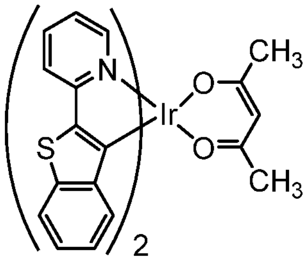

Btp$_2$Ir(acac)

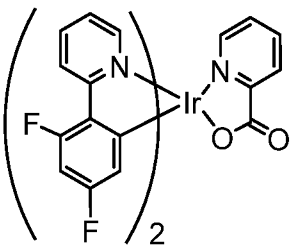

FIrpic

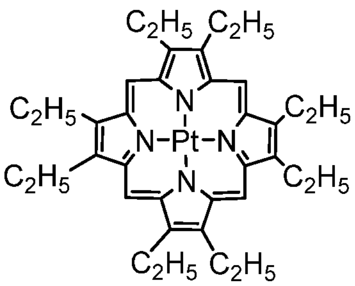

PtOEP

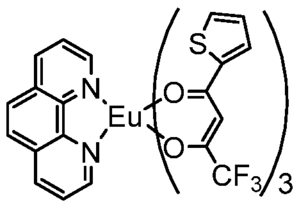

Eu(TTA)$_3$phen

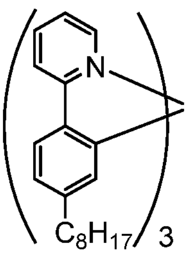

COM-1

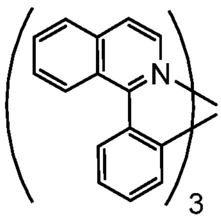

COM-2

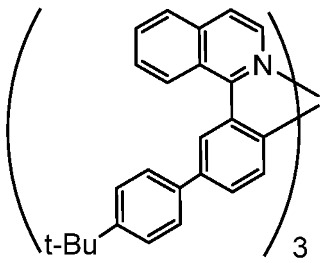

COM-3

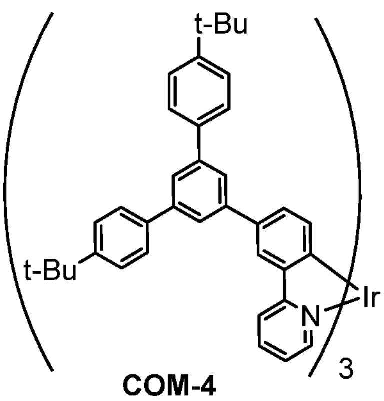

COM-4

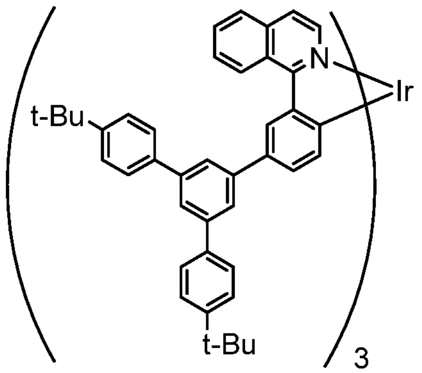

COM-5

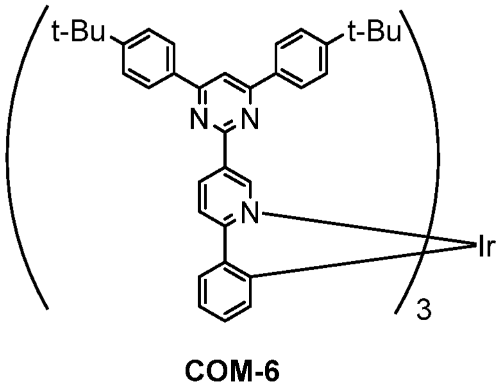

COM-6

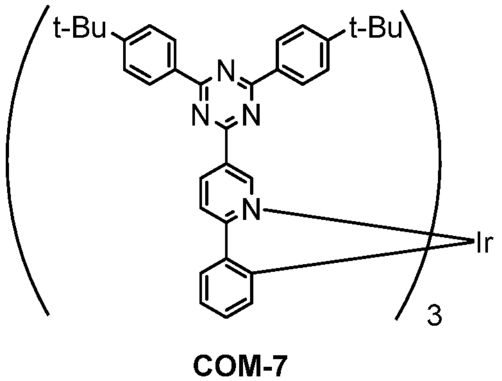

COM-7

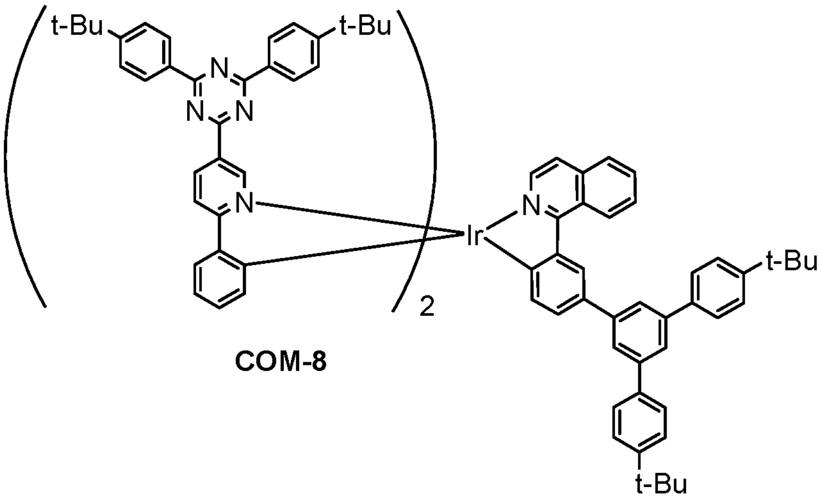

**COM-8**

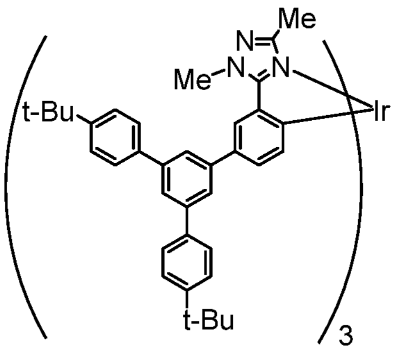

COM-9

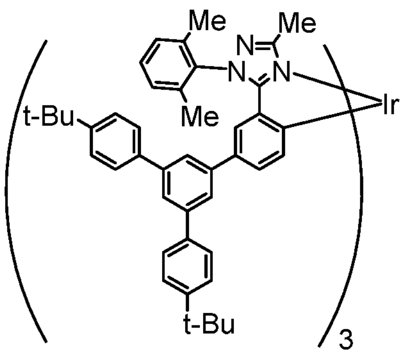

COM-10

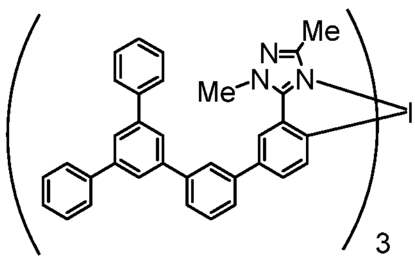

COM-11

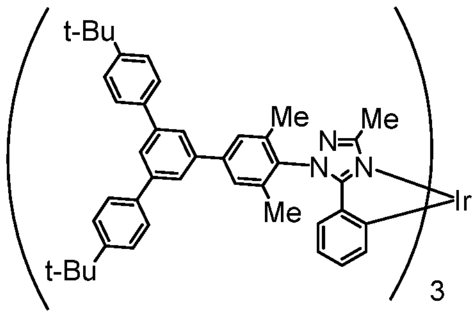

COM-12

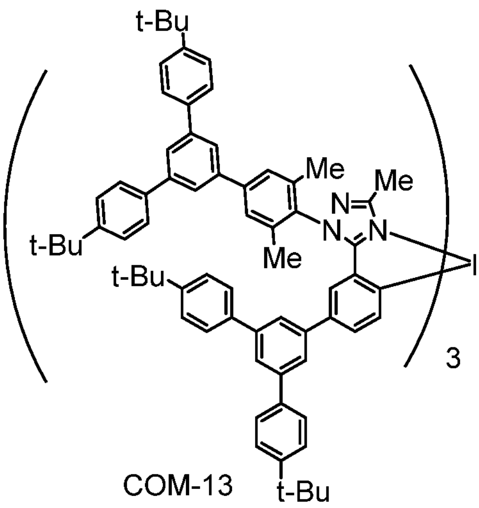

COM-13

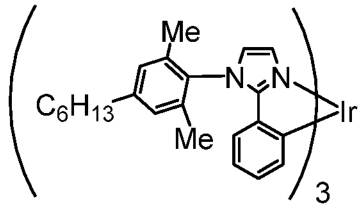

COM-14

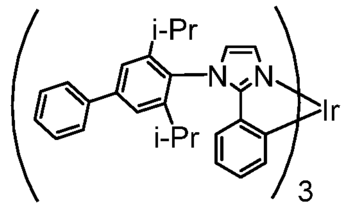

COM-15

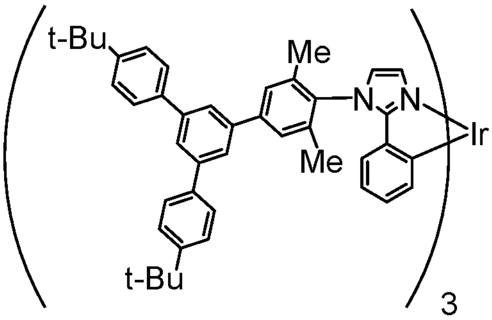

COM-16

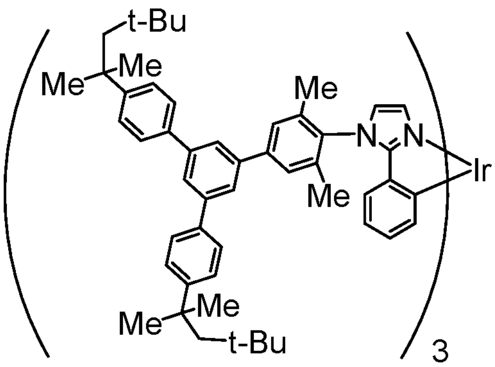

COM-17

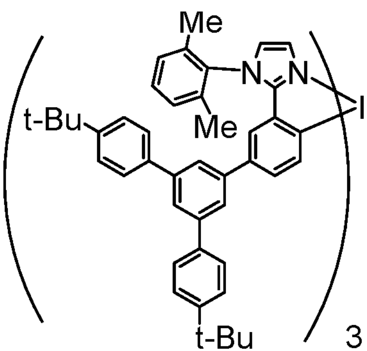

COM-18

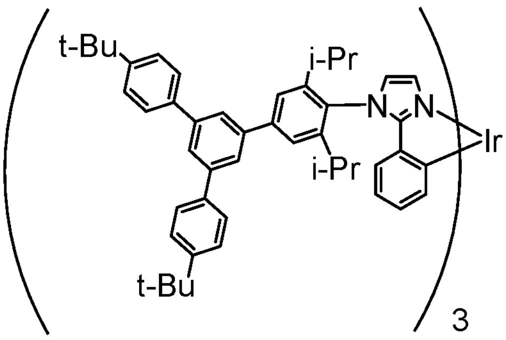

COM-19

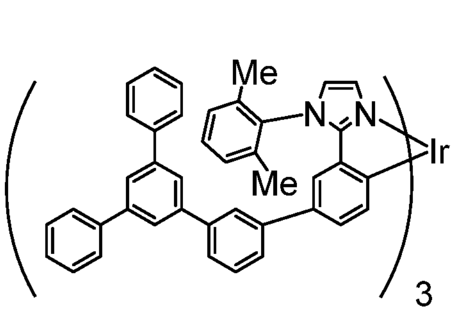

COM-20

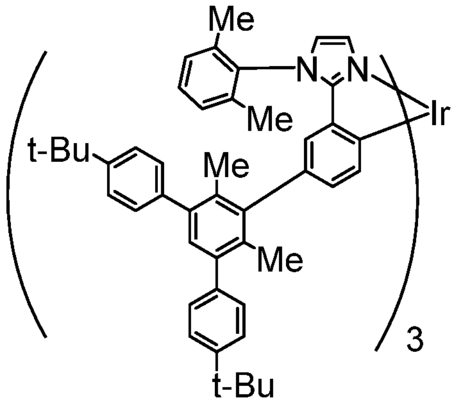

COM-21

The light emitting materials may be used each singly or two or more kinds of the light emitting materials may be used in combination.

The host material is classified into a low molecular weight compound and a polymer compound.

When a metal complex is used as the light emitting material, the host material is preferably a compound having the lowest excited triplet state ($T_1$) having energy level not lower than that of the lowest excited triplet state ($T_1$) of the metal complex because the external quantum efficiency of the light emitting device is excellent.

When a metal complex is used as the light emitting material, the host material is preferably a compound showing dissolvability in a solvent capable of dissolving the metal complex because the light emitting device can be fabricated by an application method.

The low molecular weight compound used as the host material includes low molecular weight compounds exemplified as the above-described hole transporting material, low molecular weight compounds exemplified as the above-described electron transporting material (that is, a compound represented by the formula (H-1) and a compound represented by the formula (H-2)) and the like, and preferable are compounds having higher excited state energy than that of the light emitting material used in combination. If the light emitting material is one utilizing light emission from the lowest excited triplet state, it is preferable that the energy of the lowest excited triplet state of the host material is not lower than the energy of the lowest excited triplet state of the light emitting material.

Of them, a compound having a carbazole structure, a compound having a triarylamine structure, a compound having a phenanthroline structure, a compound having a triaryltriazine structure, a compound having an azole structure, a compound having a benzothiophene structure, a compound having a benzofuran structure, a compound having a fluorene structure and a compound having a spirofluorene structure are preferable as the low molecular weight compound used as the host material. The low molecular weight compound used as the host material includes, for example, the following compounds.

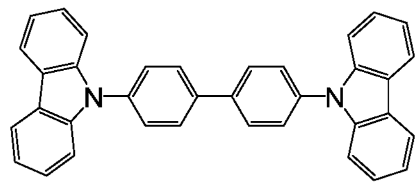

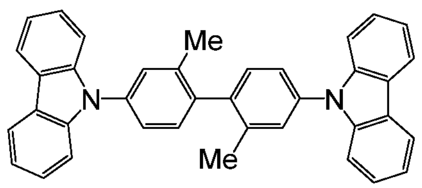

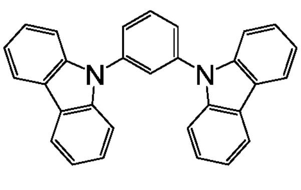

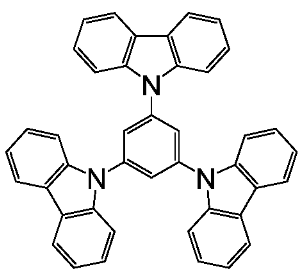

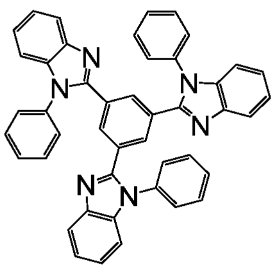

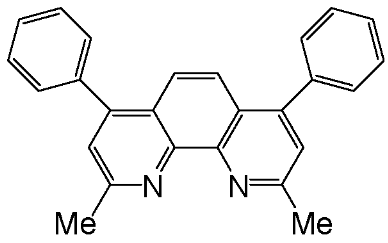
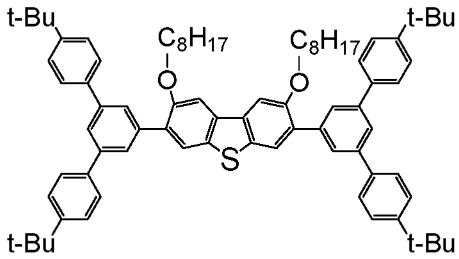
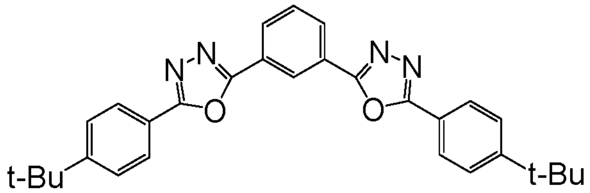
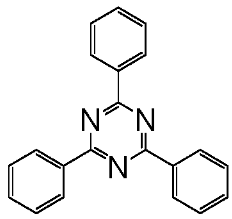
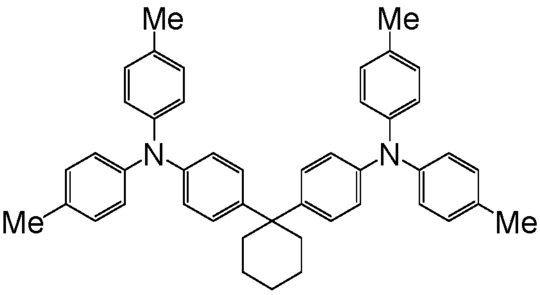
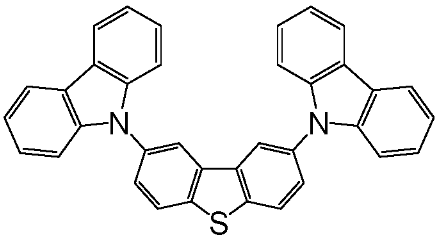

The polymer compound used as the host material (hereinafter, referred to as "polymer host") includes, for example, polymer compounds described as the hole transporting material or the electron transporting material.

As the polymer host, a polymer compound comprising a constitutional unit represented by the formula (X) or the formula (Y) is preferable. Explanations and examples of the polymer compound comprising a constitutional unit represented by the formula (X) or the formula (Y) are the same as described above.

The constitutional units represented by the formula (X) or the formula (Y) may be contained each singly or two or more kinds of the constitutional units may be contained in a polymer host.

The polymer host can be produced by using known polymerization methods described in Chem. Rev., vol. 109, pp. 897-1091 (2009) and the like, exemplified are methods of causing polymerization by a coupling reaction using a transition metal catalyst such as the Suzuki reaction, the Yamamoto reaction, the Buchwald reaction, the Stille reaction, the Negishi reaction and the Kumada reaction.

In the above-described polymerization method, the method of charging monomers includes, for example, a method in which the total amount of monomers is charged in a lump into the reaction system, a method in which monomers are partially charged and reacted, then, the remaining monomers are charged in a lump, continuously or in divided doses, and a method in which monomers are charged continuously or in divided doses.

The transition metal catalyst includes, for example, a palladium catalyst and a nicked catalyst.

For the post treatment of the polymerization reaction, known methods, for example, a method of removing water-soluble impurities by liquid-separation, a method in which the reaction solution after the polymerization reaction is added to a lower alcohol such as methanol to cause deposition of a precipitate which is then filtrated before drying, and other methods, are used each singly or combined. When the purity of the polymer host is low, the polymer host can be purified by usual methods such as, for example, recrystallization, reprecipitation, continuous extraction with a Soxhlet extractor and column chromatography.

When the light emitting material and the host material are used in combination, the content of the light emitting material is usually 0.01 to 80 parts by weight, preferably 0.05 to 40 parts by weight, more preferably 0.1 to 20 parts by weight, further preferably 1 to 20 parts by weight, when the sum of the light emitting material and the host material is 100 parts by weight.

The light emitting layer may have a single-layered structure composed of one or two or more kinds of light emitting materials, or may have a multi-layered structure composed of several layers having the same composition or

different compositions.

When the lower layer is dissolvable in a solvent contained in the solution of a layer to be applied later in forming an organic layer such as an electron transporting layer by an application method following formation of a light emitting layer, the lower layer can be insolubilized in a solvent in the same manner as exemplified for the formation method of a hole injection layer.

The thickness of the light emitting layer is usually 5 nm to 1 μm, preferably 10 nm to 500 nm, more preferably 30 nm to 200 nm.

[Hole injection layer]

As the hole injection material in the light emitting device of the present invention, carbazole derivatives, triazole derivatives, oxazole derivatives, oxadiazole derivatives, imidazole derivatives, fluorene derivatives, polyarylalkane derivatives, pyrazoline derivatives, pyrazolone derivatives, phenylenediamine derivatives, arylamine derivatives, star burst type amine, phthalocyanine derivatives, amino-substituted chalcone derivatives, styrylanthracene derivatives, fluorenone derivatives, hydrazone derivatives, stilbene derivatives, silazane derivatives, aromatic tertiary amine compound, styrylamine compound, aromatic dimethylidine type compound, porphyrin compounds, polysilane compounds, poly(N-vinylcarbazole) derivatives, organosilane derivatives, and polymers comprising them; conductive metal oxides such as vanadium oxide, tantalum oxide, tungsten oxide, molybdenum oxide, ruthenium oxide and aluminum oxide; conductive polymers and oligomers such as polyaniline, aniline copolymers, thiophene oligomers and polythiophene; organic conductive materials such as poly(3,4-ethylenedioxythiophene)·polystyrenesulfonic acid and polypyrrole, and polymers comprising them; amorphous carbon; acceptor-like organic compounds such as tetracyanoquinodimethane derivatives (for example, 2,3,5,6-tetrafluoro-7,7,8,8-tetracyanoquinodimethane), 1,4-naphthoquinone derivatives, diphenoquinone derivatives and polynitro compounds; silane coupling agents such as octadecyltrimethoxysilane can be suitably used.

The hole injection materials may be used each singly or two or more kinds of the hole injection materials may be used in combination. The hole injection layer may have a single-layered structure composed only of the above-described material or may have a multi-layered structure composed of several layers having the same composition or different compositions.

The method of forming a hole injection layer is as described above, and it is also possible to form a hole injection layer using a mixed solution prepared by dispersing a polymer compound binder and a low molecular weight organic material.

As the polymer compound binder to be mixed, those not extremely disturbing charge transportation are preferable, and further, compounds showing not strong absorption for visible light are suitably used. As this polymer compound binder, poly(N-vinylcarbazole), polyaniline and derivatives thereof, polythiophene and derivatives thereof, poly(p-phenylenevinylene) and derivatives thereof, poly(2,5-thienylenevinylene) and derivatives thereof, polycarbonate, polyacrylate, polymethyl acrylate, polymethyl methacrylate, polystyrene, polyvinyl chloride and polysiloxane are exemplified.

When organic compound layers such as a hole transporting layer and a light emitting layer are formed following formation of a hole injection layer, especially when both the layers are formed by an application method, the layer applied earlier is dissolved in a solvent contained in the solution of a layer to be applied later and fabrication of a laminated structure becomes difficult in some cases. In this case, a method of insolubilizing the lower layer in a solvent can be used. The method of insolubilization in a solvent includes a method in which a crosslinkable group is attached to a polymer compound and cross-linked to attain insolubilization, a method in which a low molecular weight compound having a crosslinkable group having an aromatic ring typified by an aromatic bisazide is mixed as a crosslinkable agent and cross-linked to attain insolubilization, a low molecular weight compound having a crosslinkable group having no aromatic ring typified by an acrylate group is mixed as a crosslinkable agent and cross-linked to attain insolubilization, a method in which the lower layer is cross-linked by exposing to ultraviolet light, thereby insolubilizing in an organic solvent used for production of the upper layer, a method in which the lower layer is cross-linked by heating, thereby insolubilizing in an organic solvent used for production of the upper layer, and the like. The temperature in heating the lower layer is usually 100°C to 300°C and the heating time is usually 1 minute to 1 hour.

The method of lamination without dissolving the lower layer by means other than crosslinking includes a method of using solutions of different polar characters in production of adjacent layers, and there are, for example, methods in which the lower layer is not dissolved even after application, by using a water-soluble polymer compound in the lower layer and using an oil-soluble polymer compound in the upper layer.

The thickness of the hole injection layer is usually 1 nm to 1 μm, preferably 2 nm to 500 nm, more preferably 10 nm to 100 nm.

[Hole transporting layer]

In the light emitting device of the present invention, the hole transporting material is classified into a low molecular

weight compound and a polymer compound, and a polymer compound is preferable and a polymer compound having a crosslinkable group is more preferable.

The polymer compound includes, for example, polyvinylcarbazole and derivatives thereof; and polyarylene having an aromatic amine structure in the side chain or the main chain, and derivatives thereof. The polymer compound may also be a compound to which an electron accepting region is bonded. The electron accepting region includes, for example, fullerene, tetrafluorotetracyanoquinodimethane, tetracyanoethylene, trinitrofluorenone and the like, and preferable is fullerene.

The hole transporting materials may be used each singly or two or more kinds of the hole transporting materials may be used in combination.

When the lower layer is dissolvable in a solvent contained in the solution of a layer to be applied later in forming an organic layer such as a light emitting layer by an application method following formation of a hole transporting layer, the lower layer can be insolubilized in a solvent by the same method as exemplified for the formation method of a hole injection layer.

The thickness of the hole transporting layer is usually 1 nm to 1 μm, preferably 2 nm to 500 nm, more preferably 5 nm to 100 nm.

[Anode]

The material of the anode includes, for example, electrically conductive metal oxides, and semi-transparent metals, preferably, indium oxide, zinc oxide, tin oxide; electrically conductive compounds such as indium·tin·oxide (ITO) and indizum·zinc·oxide; composite of Ag, palladium and copper (APC); NESA, gold, platinum, silver and copper.

The anode may have a single-layered structure composed of one or two or more of these materials, or may have a multi-layered structure composed of several layers having the same composition or different compositions.

As the anode fabrication method, known methods can be used, and a vacuum vapor deposition method, a sputtering method, an ion plating method, a plating method, a method by film formation from a solution (a mixed solution with a polymer binder may be used) and the like are mentioned.

The thickness of the anode is usually 10 nm to 10μm, preferably 40 nm to 500 nm.

After being fabricated by the above-described method, the anode may be subjected to a surface treatment with a solution comprising an electron accepting compound such as UV ozone, a silane coupling agent and 2,3,5,6-tetrafluoro-7,7,8,8-tetracyanoquinodimethane, for improving electrical connection to a layer in contact with the anode.

The anode may have a single-layered structure or may have a multi-layered structure.

[Cathode]

The material of the cathode includes, for example, metals such as lithium, sodium, potassium, rubidium, cesium, beryllium, magnesium, calcium, strontium, barium, aluminum, zinc and indium; alloys composed of two or more of them; alloys composed of at least one of them and at least one of silver, copper, manganese, titanium, cobalt, nickel, tungsten and tin; and, graphite and graphite intercalation compounds. The alloy includes, for example, a magnesium-silver alloy, a magnesium-indium alloy, a magnesium-aluminum alloy, an indium-silver alloy, a lithium-aluminum alloy, a lithium-magnesium alloy, a lithium-indium alloy, a calcium-aluminum alloy, and, metal nano particles, metal nano wires and conductive metal oxide nano particles.

The metal material contained in an amount of 1% by weight or more in the cathode in the light emitting device of the present invention is Al, Au, Ag, Cu, ZnO, ITO or IZO, preferably Au, Ag, Cu, ZnO, ITO or IZO, more preferably Ag.

As the cathode fabrication method, known methods can be used, and a vacuum vapor deposition method, a sputtering method, an ion plating method and a method by film formation from a solution (a mixed solution with a polymer binder may be used) are exemplified. When the cathode is made of metal nano particles, metal nano wires or conductive metal oxide nano particles, a method by film formation from a solution is used.

The thickness of the cathode is usually 1 to 1000 nm, preferably 10 to 500 nm.

The cathode may have a single-layered structure or may have a multi-layered structure.

[Substrate]

The substrate which the light emitting device of the present invention can have may advantageously be one which does not chemically change in forming an electrode and forming an organic layer, and for example, substrates composed of glass, plastic, polymer film, metal film, silicon and the like, and substrates obtained by laminating them are used.

[Other constitutional elements]

The light emitting device of the present invention may have a sealing member on the opposite side to the substrate sandwiching a light emitting layer and the like. In addition, any constitutional elements for constituting a display apparatus, such as filters such as a color filter and a fluorescence conversion filter, circuit and wiring necessary for driving of pixels, may be carried.

[Production method]

The light emitting device of the present invention can be produced, for example, by laminating layers on a substrate in series. Specifically, an anode is provided on a substrate, layers such as a hole injection layer and a hole transporting layer are provided on this, a light emitting layer is provided on this, layers such as an electron transporting layer are provided on this, further, a cathode is laminated on this, thus, a light emitting device can be produced. As the other production method, a light emitting device can be produced by providing a cathode on a substrate, providing layers such as an electron transporting layer, a light emitting layer, a hole transporting layer and a hole injection layer on this, and further, laminating an anode on this. As still another production method, a light emitting device can be produced by bonding an anode or an anode side substrate obtained by laminating layers on an anode and a cathode or a cathode side substrate obtained by laminating layers on a cathode so as to face. Production of the light emitting device of the present invention may comprise a step of forming at least one selected from the group consisting of an electron transporting layer (A), an electron transporting layer (B) and a cathode by application.

[Use]

For obtaining planar light emission by using a light emitting device, a planar anode and a planar cathode are disposed so as to overlap with each other. Patterned light emission can be produced by a method of placing a mask with a patterned window on the surface of a planer light emitting device, a method of forming an extremely thick layer intended to be a non-light emitting, thereby having the layer essentially no-light emitting or a method of forming an anode, a cathode or both electrodes in a patterned shape. By forming a pattern with any of these methods and disposing certain electrodes so as to switch ON/OFF independently, a segment type display capable of displaying numbers and letters and the like is provided. For producing a dot matrix display, both an anode and a cathode are formed in a stripe shape and disposed so as to cross with each other. Partial color display and multi-color display are made possible by a method of printing separately certain polymer compounds showing different emission or a method of using a color filter or a fluorescence conversion filter. The dot matrix display can be passively driven, or actively driven combined with TFT and the like. These displays can be used in computers, television sets, portable terminals and the like. The planar light emitting device can be suitably used as a planer light source for backlight of a liquid crystal display or as a planar light source for illumination. If a flexible substrate is used, it can be used also as a curved light source and a curved display.

[EXAMPLES]

The present invention will be illustrated in detail by examples below, but the present invention is not limited to these examples. Examples falling outside of the scope of the claims are included for reference purposes only.

In examples, the polystyrene-equivalent number-average molecular weight (Mn) and the polystyrene-equivalent weight-average molecular weight (Mw) of a polymer compound were determined by the following size exclusion chromatography (SEC) using tetrahydrofuran as a moving bed. The measurement conditions of SEC are as described below.

A polymer compound to be measured was dissolved at a concentration of about 0.05% by weight in tetrahydrofuran, and 10 μL of the solution was injected into SEC. A moving bed was flowed at a flow rate of 0.6 mL/min. As the column, each one column of TSKguardcolumn SuperAW-H, TSKgel Super AWM-H and TSKgel SuperAW3000 (all are manufactured by Tosoh Corp.) were connected serially and used. As the detector, an UV-VIS detector (manufactured by Tosoh Corp., trade name: UV-8320GPC) was used.

NMR was measured by the following method.

A measurement sample (5 to 10 mg) was dissolved in about 0.5 mL of deuterated chloroform ($CDCl_3$), deuterated tetrahydrofuran, deuterated dimethyl sulfoxide, deuterated acetone, deuterated N,N-dimethylformamide, deuterated toluene, deuterated methanol, deuterated ethanol, deuterated 2-propanol or deuterated methylene chloride, and NMR thereof was measured using an NMR apparatus (manufactured by Agilent, trade name: INOVA300 or MERCURY 400VX).

As the index of the purity of a compound, the high performance liquid chromatography (HPLC) area percentage value was used. This value is a value according to HPLC (manufactured by Shimadzu Corp., trade name: LC-20A) when UV = 254nm, unless otherwise stated. In this case, the compound to be measured was dissolved in tetrahydrofuran or chloroform so as to give a concentration of 0.01 to 0.2% by weight, and the solution in an amount of 1 to 10 μL according

to the concentration was injected into HPLC. As the moving bed of HPLC, acetonitrile/tetrahydrofuran was used while changing the ratio of acetonitrile/tetrahydrofuran from 100/0 to 0/100 (volume ratio), and flowed at a flow rate of 1.0 mL/min. As the column, Kaseisorb LC ODS 2000 (manufactured by Tokyo Chemical Industry Co., Ltd.) or an ODS column having the equivalent performance was used. As the detector, a photo diode array detector (manufactured by Shimadzu Corp., trade name: SPD-M20A) was used.

The electron affinity of a compound was determined by subtracting the value of energy (eV) of the absorption edge at the longer wavelength side of the absorption wavelength of a compound obtained by measuring with an ultraviolet·visible·near infrared spectrometer from the value of ionization potential (eV) described later.

The ionization potential of a compound was measured by a photoelectron spectrometer (manufactured by RIKEN KEIKI Co., Ltd., trade name:AC2) in the air.

The work function of a metal was measured by a photoelectron spectrometer (manufactured by RIKEN KEIKI Co., Ltd., trade name:AC2) in the air. The absorption wavelength was measured by an ultraviolet·visible·near infrared spectrometer (manufactured by Varian, Cary 5E).

The sample for measurement was made by preparing a 1% by weight solution of a compound, spin-coating the solution on a quartz substrate at a rotation frequency of 1000 rpm for 30 seconds, and drying the coated solution at 100°C for 15 minutes.

<Synthesis Example 1> Synthesis of phosphorescent compounds MC1 and MC2

As phosphorescent compounds MC1 and MC2, those synthesized according to methods described in the following documents and showing an HPLC area percentage value of 99.5% or more were used.

The phosphorescent compound MC1 was synthesized according to a method described in International Publication WO2009/131255. The phosphorescent compound MC1 had an electron affinity of 2.8 eV.

The phosphorescent compound MC2 was synthesized according to a method described in JP-A No. 2013-147551. The phosphorescent compound MC2 had an electron affinity of 2.4 eV.

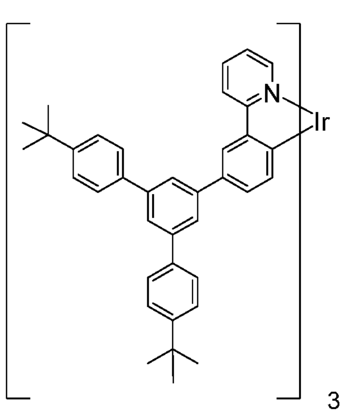

MC1

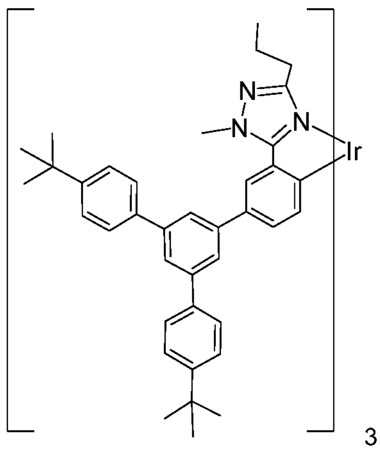

MC2

<Synthesis Example 2> Synthesis of monomers CM1 to CM9

As monomers CM1, CM1', CM2 to CM9, those synthesized according to methods described in the following documents and showing an HPLC area percentage value of 99.5% or more were used.

The monomers CM1 and CM1' were synthesized according to a method described in JP-A No. 2012-033845.

The monomer CM2 was synthesized according to a method described in JP-A No. 2010-189630.

The monomer CM3 was synthesized according to a method described in International Publication WO2013/191088.

The monomer CM4 was synthesized according to a method described in International Publication WO2012/086671.

The monomer CM5 was synthesized according to a method described in JP-A No. 2011-174061.

The monomer CM6 was synthesized according to a method described in International Publication WO2002/045184.

The monomer CM7 was synthesized according to a method described in JP-A No. 2008-106241.

The monomer CM8 was synthesized according to a method described in JP-A No. 2003-226744.

The monomer CM9 was synthesized according to a method described in JP-A No. 2010-189630.

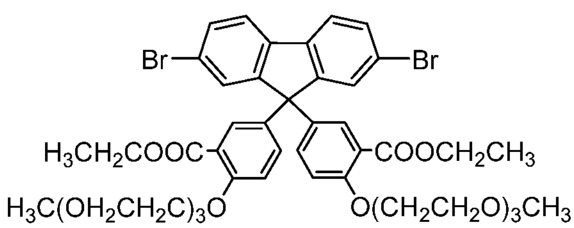

CM1

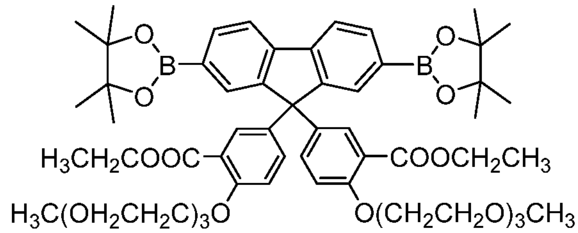

CM1'

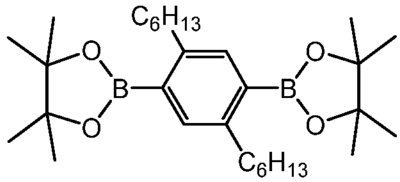

CM2

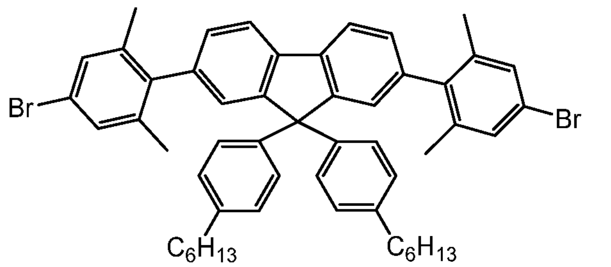

CM3

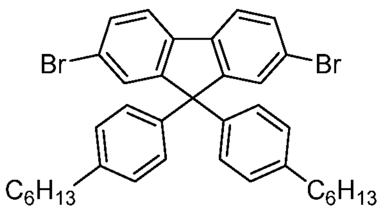

**CM4**

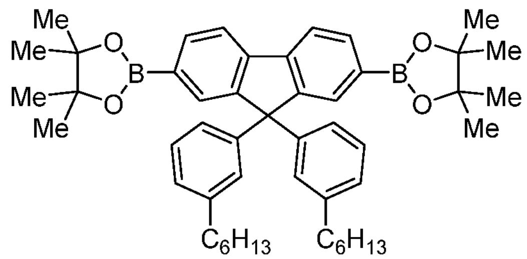

**CM5**

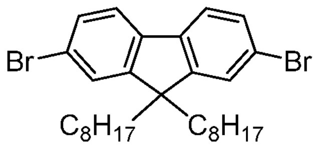

CM6

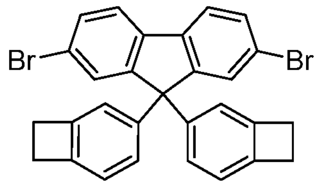

CM7

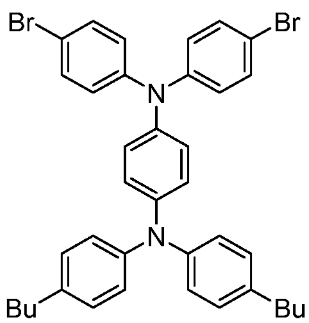

CM8

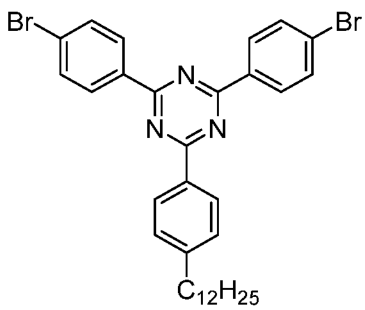

CM9

<Synthesis Example 3> Synthesis of polymer compound 1

(Step 1) An inert gas atmosphere was prepared in a reaction vessel, then, the monomer CM1 (9.23 g), the monomer CM2 (4.58 g), dichlorobis(tris-o-methoxyphenylphosphine)palladium (8.6 mg) and toluene (175 mL) were added and the mixture was heated at 105°C.

(Step 2) Thereafter, into this was added a 12% by weight sodium carbonate aqueous solution (40.3 mL), and the mixture was refluxed for 29 hours.

(Step 3) Thereafter, to this were added phenylboronic acid (0.47 g) and dichlorobis(tris-o-methoxyphenylphosphine)palladium (8.7 mg), and the mixture was refluxed for 14 hours.

(Step 4) Thereafter, to this was added a sodium diethyldithiacarbamate aqueous solution, and the mixture was stirred at 80°C for 2hours. The resultant reaction liquid was cooled, then, dropped into methanol, to observe generation of a precipitate. The precipitate was isolated by filtration, washed with methanol and water, then, dried to obtain a solid which was then dissolved in chloroform, and the solution was purified by passing through an alumina column and a silica gel column in series through which chloroform had passed previously. The resultant purified liquid was dropped into methanol, and the mixture was stirred, to observe generation of a precipitate. The precipitate was isolated by filtration and dried, to obtain a polymer compound P1 (7.15 g). The polymer compound P1 had a Mn of $3.2\times10^4$ and a Mw of $6.0\times10^4$.

The polymer compound P1 is a copolymer constituted of a constitutional unit derived from the monomer CM1 and a constitutional unit derived from the monomer CM2 at a molar ratio of 50:50 according to the theoretical values calculated from the amounts of the charged raw materials.

(Step 5) An argon gas atmosphere was prepared in a reaction vessel, then, the polymer compound P1 (3.1 g), tetrahydrofuran (130 mL), methanol (66 mL), cesium hydroxide monohydrate (2.1 g) and water (12.5 mL) were added, and the mixture was stirred at 60°C for 3 hours.

(Step 6) Thereafter, to this was added methanol (220 mL), and the mixture was stirred for 2 hours. The resultant reaction mixture was concentrated, then, dropped into isopropyl alcohol, and the mixture was stirred, to observe generation of a precipitate. The precipitate was isolated by filtration and dried, to obtain a polymer compound 1 (3.5 g). The polymer compound 1 was subjected to $^1$H-NMR analysis, to confirm that a signal of an ethyl ester portion in the polymer compound P1 disappeared and the reaction was completed.

The polymer compound 1 is a copolymer constituted of a constitutional unit represented by the following formula and a constitutional unit derived from the monomer CM2 at a molar ratio of 50:50 according to the theoretical values calculated from the amounts of the charged raw materials of the polymer compound P1. The polymer compound 1 had an electron affinity of 2.57 eV.

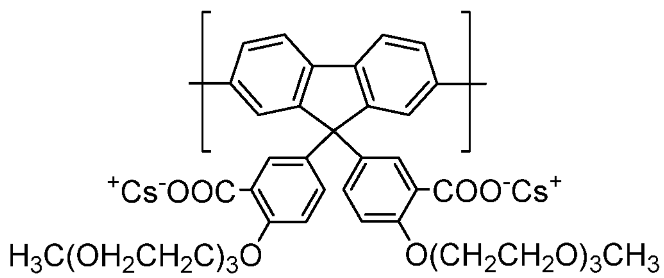

<Synthesis Example 4> Synthesis of polymer compound 2

A polymer compound P2 (0.5 g) was obtained in the same manner as for Synthesis of polymer compound 1, excepting that (Step 1) in Synthesis of polymer compound 1 was changed to "An inert gas atmosphere was prepared in a reaction vessel, then, the monomer CM1 (0.55 g), monomer CM1' (0.61 g), triphenylphosphinepalladium (10 mg) and toluene (10 mL) were added and the mixture was heated at 105°C.". The polymer compound P2 had a Mn of $5.2\times10^4$ and a Mw of $1.5\times10^5$.

The polymer compound P2 is a copolymer constituted of a constitutional unit derived from the monomer CM1 and a constitutional unit derived from the monomer CM1' at a molar ratio of 50:50 according to the theoretical values calculated from the amounts of the charged raw materials.

A polymer compound 2 (150 mg) was obtained in the same manner as for Synthesis of polymer compound 1, excepting that (Step 5) in Synthesis of polymer compound 1 was changed to "An argon gas atmosphere was prepared

in a reaction vessel, then, the polymer compound P2 (0.2 g), tetrahydrofuran (20 mL), methanol (20 mL), cesium hydroxide monohydrate (0.2 g) and water (2 mL) were added, and the mixture was stirred at 55°C for 6 hours.". The polymer compound 2 was subjected to $^1$H-NMR analysis, to confirm that a signal of an ethyl ester portion in the polymer compound P2 disappeared and the reaction was completed.

The polymer compound 2 is a polymer constituted of a constitutional unit represented by the following formula according to the theoretical values calculated from the amounts of the charged raw materials of the polymer compound P2. The polymer compound 2 had an electron affinity of 2.84 eV.

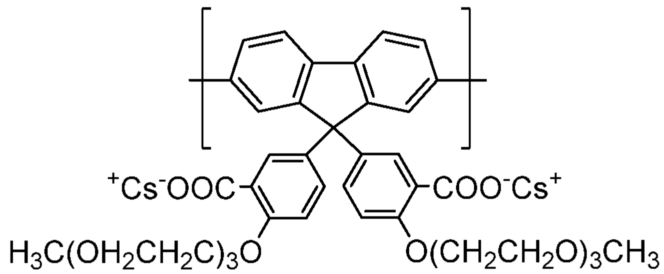

<Synthesis Example 5> Synthesis of polymer compound HT1

(Step 1) An inert gas atmosphere was prepared in a reaction vessel, then, the monomer CM5 (185 g), the monomer CM6 (35.9 g), the monomer CM7 (20.1 g), the monomer CM8 (104 g), dichlorobis(triphenylphosphine)palladium (177 mg) and toluene (4.3 kg) were added and the mixture was heated at 100°C. To this was added a 20% by weight tetraethylammonium hydroxide aqueous solution (873 g), then, and the mixture was stirred at 100°C for 5 hours. To this were added phenylboronic acid (3.08 g) and toluene (120 g), and the mixture was stirred at 100°C for 14 hours.

(Step 2) An aqueous layer was removed from the reaction liquid, then, to this were added a sodium diethyldithiacarbamate aqueous solution and toluene, and the mixture was stirred at 40°C for 3 hours. Thereafter, the mixture was cooled down to room temperature, then, an aqueous layer was removed, to obtain an organic layer. The resultant organic layer was washed with 10% by weight hydrochloric acid twice, with a 3% by weight ammonia aqueous solution twice, and with ion exchanged water twice. The washed organic layer was purified by passing through an alumina column and a silica gel column in series. The resultant purified liquid was dropped into methanol, and the mixture was stirred, to observe generation of a precipitate, thus, the precipitate was isolated by filtration and dried, to obtain a polymer compound HT1 (204 g). The polymer compound HT1 had a Mn of $6.7\times10^4$ and a Mw of $2.3\times10^5$ .

The polymer compound HT1 is a copolymer constituted of a constitutional unit derived from the monomer CM5, a constitutional unit derived from the monomer CM6, a constitutional unit derived from the monomer CM7 and a constitutional unit derived from the monomer CM8 at a molar ratio of 50:12.5:7.5:30 according to the theoretical values calculated from the amounts of the charged raw materials.

<Synthesis Example 6> Synthesis of polymer compound HP1

Under an inert gas atmosphere, the monomer CM2 (8.182 g), the monomer CM4 (8.508 g), the monomer CM9 (2.097 g) and toluene (250 mL) were mixed, and the mixture was stirred while heating. To this were added palladium acetate (3.7 mg) and tris(2-methoxyphenyl)phosphine (23.2 mg) and the mixture was heated at 100°C. Into the resultant solution was dropped a 20% by weight tetraethylammonium hydroxide aqueous solution (61.3 g), and the mixture was refluxed under heating for 8 hours.

Next, phenylboric acid (0.20 g), palladium acetate (3.7 mg), tris(2-methoxyphenyl)phosphine (23.3 mg) and a 20% by weight tetraethylammonium hydroxide aqueous solution (58.3 g) were added, and the mixture was refluxed under heating for 15 hours.

An aqueous layer was removed from the reaction liquid, then, sodium N,N-diethyldithiocarbamate trihydrate (9.31 g) and ion exchanged water (60 mL) were added, and the mixture was stirred at 40°C for 3 hours.

An organic layer of the reaction liquid was separated from an aqueous layer, then, the organic layer was washed with ion exchanged water once, with 10% by weight hydrochloric acid twice, with a 3% by weight ammonia aqueous solution twice and with ion exchanged water twice in this order.

The organic layer was passed through a column filled with silica gel and alumina through which toluene had passed previously, and the passed solution was dropped into methanol, to cause deposition of a precipitate. The precipitate was isolated by filtration, then, dried, to obtain 9.80 g of a polymer compound (hereinafter, referred to as "polymer compound HP1".) . The polymer compound HP1 had a Mn of $9.2\times10^4$ and a Mw of $2.3\times10^5$.

The polymer compound HP1 is a copolymer constituted of a constitutional unit derived from the monomer CM2,

a constitutional unit derived from the monomer CM4 and a constitutional unit derived from the monomer CM9 at a molar ratio of 50:40:10 according to the theoretical values calculated from the amounts of the charged raw materials. The polymer compound HP1 had an electron affinity of 2.65 eV.

<Synthesis Example 7> Synthesis of polymer compound HP2

(Step 1) An inert gas atmosphere was prepared in a reaction vessel, then, the monomer CM2 (2.2 g), the monomer CM3 (1.3 g), dichlorobis(tris-o-methoxyphenylphosphine)palladium (2.3 mg) and toluene (55 mL) were added and the mixture was heated at 105°C.

(Step 2) Thereafter, into this was dropped a 20% by weight tetraethylammonium hydroxide aqueous solution (9.1 g), and the mixture was refluxed for 4 hours.

(Step 3) Thereafter, to this were added 2-isopropylphenylboronic acid (0.47 g) and dichlorobis(tris-o-methoxyphenylphosphine)palladium (2.2 mg), and the mixture was refluxed for 16 hours.

(Step 4) Thereafter, to this was added a sodium diethyldithiacarbamate aqueous solution, and the mixture was stirred at 85°C for 5 hours. The resultant reaction liquid was cooled, then, washed with hydrochloric acid, ammonia water and ion exchanged water, and the resultant organic layer was dropped into methanol, to observe generation of a precipitate. The precipitate was isolated by filtration and dried, to obtain a solid which was then dissolved in toluene, and the solution was purified by passing through an alumina column and a silica gel column in series through which toluene had passed previously. The resultant purified liquid was dropped into methanol, and the mixture was stirred, to observe generation of a precipitate. The precipitate was isolated by filtration and dried, to obtain a polymer compound HP2 (2.3 g). The polymer compound HP2 had a Mn of $7.4\times10^4$ and a Mw of $2.3\times10^5$ . The polymer compound HP2 had an electron affinity of 2.59 eV or less.

The polymer compound HP2 is a copolymer constituted of a constitutional unit derived from the monomer CM2 and a constitutional unit derived from the monomer CM3 at a molar ratio of 50:50 according to the theoretical values calculated from the amounts of the charged raw materials.

<Synthesis Example 8> Synthesis of polymer compound 3

(Step 1) An inert gas atmosphere was prepared in a reaction vessel, then, the monomer CM1 (0.43 g), monomer CM1' (0.70 g), 2,6-dibromopyridine (0.072 g), bis(tri-ortho-anisylphosphine)dichloropalladium (0.66 mg), methyltrioctylammonium chloride (manufactured by Aldrich, trade name: Aliquat336 (registered trademark)) (7.6 mg), a 17.5% by weight sodium carbonate aqueous solution (10 mL) and toluene (20 mL) were added, and the mixture was reacted at 105°C for 6 hours.

(Step 2) Thereafter, to this were added bis(tri-ortho-anisylphosphine)dichloropalladium (0.66 mg), a 17.5% by weight sodium carbonate aqueous solution (3 mL), toluene (3 mL) and phenylboronic acid (37 mg) and the mixture was stirred for 3 hours.

(Step 3) Thereafter, to this was added a sodium diethyldithiacarbamate aqueous solution, and the mixture was stirred at 80°C for 2 hours. The reaction liquid was cooled, then, dropped into methanol, to observe generation of a precipitate. The precipitate was isolated by filtration, washed with methanol and water, then, dried to obtain a solid which was then dissolved in chloroform, and the solution was purified by passing through an alumina column and a silica gel column in series through which chloroform had passed previously. The resultant purified liquid was dropped into methanol, and the mixture was stirred, to observe generation of a precipitate. The precipitate was isolated by filtration and dried, to obtain 575 mg of a polymer compound P3. The polymer compound P3 had a Mn of $2.2\times10^4$ and a Mw of $6.3\times10^4$.

The polymer compound P3 is a copolymer constituted of a constitutional unit derived from the monomer CM1, a constitutional unit derived from the monomer CM1' and a constitutional unit represented by the following formula:

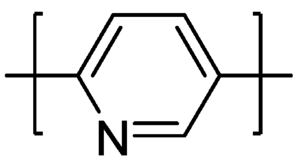

at a molar ratio of 30:50:20 according to the theoretical values calculated from the amounts of the charged raw materials.

(Step 4) An argon gas atmosphere was prepared in a reaction vessel, then, the polymer compound P3 (500 mg), tetrahydrofuran (20 mL), methanol (10 mL), cesium hydroxide monohydrate (522 mg) and water (0.4 mL) were

added, and the mixture was stirred at 65°C for 1 hour and half.

(Step 5) Thereafter, to this was added methanol (20 mL), and the mixture was stirred for 2 and a half hours. The resultant reaction mixture was concentrated, then, dropped into isopropyl alcohol, and the mixture was stirred, to observe generation of a precipitate. The precipitate was isolated by filtration and dried, to obtain a polymer compound 3 (580 mg) . The polymer compound 3 was subjected to $^1$H-NMR analysis, to confirm that a signal of an ethyl ester portion in the polymer compound P3 disappeared and the reaction was completed.

The polymer compound 3 is a copolymer constituted of a constitutional unit represented by the following formula:

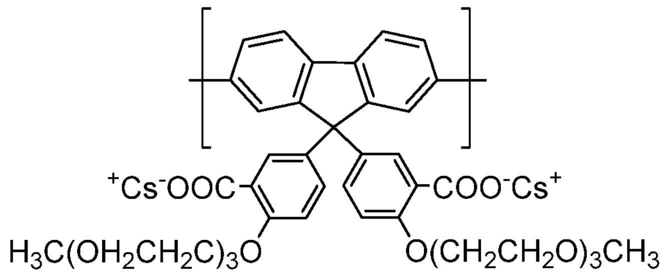

and a constitutional unit represented by the following formula:

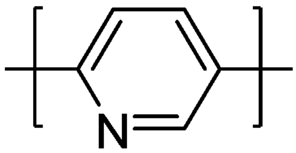

at a molar ratio of 80:20 according to the theoretical values calculated from the amounts of the charged raw materials of the polymer compound P3. The polymer compound 3 had an electron affinity of 2.91 eV.

<Synthesis Example 9> Synthesis of polymer compound HP3

A polymer compound HP3 was synthesized according to a method described in JP-A No. 2012-036381.

The polymer compound HP3 is a copolymer constituted of a constitutional unit represented by the following formula:

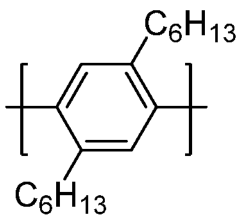

, a constitutional unit represented by the following formula:

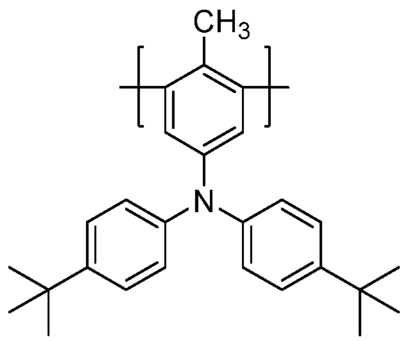

and a constitutional unit represented by the following formula:

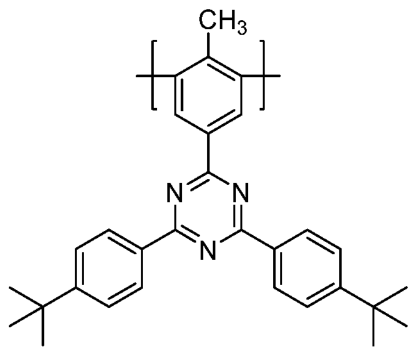

at a molar ratio of 50:20:30 according to the theoretical values calculated from the amounts of the charged raw materials of the polymer compound HP3. The polymer compound HP3 had an electron affinity of 1.94 eV.

<Synthesis Example 10> Synthesis of low molecular weight compound 1

A low molecular weight compound 1 (3,3'-di(4-dibenzothiophenyl)-1,1'-biphenyl) was synthesized according to descriptions of The Journal of Physical Chemistry C 2004, 118, 2375-2384 . The low molecular weight compound 1 had an electron affinity of 2.60 eV.

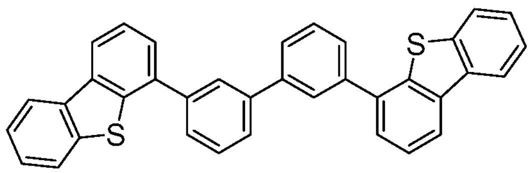

<Synthesis Example 11> Synthesis of low molecular weight compound 2

A low molecular weight compound 2 (2,8-bis(9H-carbazole-9-yl)dibenzothiophene) was synthesized according to descriptions of Journal of Materials Chemistry 2011,21,14604-10609. The low molecular weight compound 2 had an electron affinity of 2.61 eV.

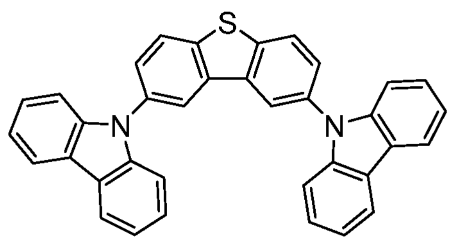

<Example D1> Fabrication and evaluation of light emitting device D1

(Formation of anode and hole injection layer)

An ITO film was attached with a thickness of 45 nm to a glass substrate by a sputtering method, to form an anode. On the anode, a polythiophene•sulfonic acid type hole injection material (AQ-1200, manufactured by Plextronics) was spin-coated to form a film with a thickness of 60 nm, and the film was heated on a hot plate at 170°C for 15 minutes under an air atmosphere, to form a hole injection layer.

(Formation of hole transporting layer)

The polymer compound HT1 was dissolved at a concentration of 0.7% by weight in xylene. The resultant xylene solution was spin-coated on the hole injection layer to form a film with a thickness of 20 nm, and the film was heated on a hot plate at 180°C for 60 minutes under a nitrogen gas atmosphere, to form a hole transporting layer.

(Formation of light emitting layer)

The polymer compound HP1 and the phosphorescent compound MC1 (polymer compound HP1/phosphorescent compound MC1 = 70% by weight/30% by weight) were dissolved at a concentration of 1.5% by weight in xylene, to prepare a xylene solution. This xylene solution was spin-coated on the hole transporting layer to form a film with a thickness of 70 nm, and the film was heated at 130°C for 10 minutes under a nitrogen gas atmosphere, to form a light emitting layer.

(Formation of electron transporting layer (A))

The polymer compound 1 was dissolved at a concentration of 0.2% by weight in 2, 2, 3, 3, 4, 4, 5, 5-octafluoro-1-pentanol to obtain a solution, and the solution was spin-coated on the light emitting layer to form a film with a thickness of 10 nm, and the film was heated at 130°C for 10 minutes under a nitrogen gas atmosphere, to form an electron transporting layer (A).

(Formation of electron transporting layer (B))

The polymer compound 2 was dissolved at a concentration of 0.2% by weight in methanol to obtain a solution, and the solution was spin-coated on the light emitting layer to form a film with a thickness of 10 nm, and the film was heated at 130°C for 10 minutes under a nitrogen gas atmosphere, to form an electron transporting layer (B).

The substrate carrying the electron transporting layer (B) formed thereon was placed in a vapor deposition machine and the internal pressure was reduced to $1.0 \times 10^{-4}$ Pa or less, then, silver (work function: 4.5 eV) was vapor-deposited with a thickness of 100 nm on the electron transporting layer (B) as a cathode. After vapor deposition, sealing with a glass substrate was performed, to fabricate a light emitting device D1.

(Evaluation of light emitting device)

Voltage was applied to the light emitting device D1, to observe EL emission mainly derived from the phosphorescent compound MC1. When 10 V was applied, the luminance was 691 $cd/m^2$. This result is shown in Table 2.

<Example D3> Fabrication and evaluation of light emitting device D3

A light emitting device D3 was fabricated in the same manner as in Example D1, excepting that the polymer compound 3 was used instead of the polymer compound 2, in Example D1. Voltage was applied to the light emitting device D3, to observe EL emission mainly derived from the phosphorescent compound MC1. The luminance shown by the light emitting device D3 when 10 V was applied was 680 $cd/m^2$. This result is shown in Table 2.

<Example D4> Fabrication and evaluation of light emitting device D4

A light emitting device D4 was fabricated in the same manner as in Example D1, excepting that the substrate carrying the light emitting layer formed thereon was placed in a vapor deposition machine, the internal pressure was reduced to $1.0 \times 10^{-4}$ Pa or less, then, the low molecular weight compound 1 was vapor-deposited with a thickness of 10 nm on the light emitting layer, to form an electron transporting layer (A) instead of a process in which the polymer compound 1 was dissolved at a concentration of 0.2% by weight in 2,2,3,3,4,4,5,5-octafluoro-1-pentanol to obtain a solution, the solution was spin-coated on the light emitting layer to form a film with a thickness of 10 nm, and the film was heated at 130°C for 10 minutes under a nitrogen gas atmosphere, to form an electron transporting layer (A), in Example D1. Voltage was applied to the light emitting device D4, to observe EL emission mainly derived from the phosphorescent compound MC1. The luminance shown by the light emitting device D4 when 10 V was applied was 1147 $cd/m^2$. This result is shown in Table 2.

<Comparative Example CD1> Fabrication and evaluation of light emitting device CD1

A light emitting device CD1 was fabricated in the same manner as in Example D1, excepting that the electron transporting layer (B) was not formed, in Example D1. Voltage was applied to the light emitting device CD1, to observe EL emission mainly derived from the phosphorescent compound MC1. The luminance shown by the light emitting device CD1 when 10 V was applied was 304 $cd/m^2$ . This result is shown in Table 2.

<Example D2> Fabrication of light emitting device D2

A light emitting device D2 was fabricated according to Example D1, excepting that a xylene solution prepared by dissolving the polymer compound HP2 and the phosphorescent compound MC2 (polymer compound HP2/phosphorescent compound MC2 = 64% by weight/36% by weight) at a concentration of 1.5% by weight in xylene was used instead of the xylene solution prepared by dissolving the polymer compound HP1 and the phosphorescent compound MC1 (polymer compound HP1/phosphorescent compound MC1 = 70% by weight/30% by weight) at a concentration of 1.5% by weight in xylene, in Example D1. Voltage was applied to the light emitting device D2, to observe EL emission mainly derived from the phosphorescent compound MC2. The luminance shown by the light emitting device D2 when 10 V was applied was 26 cd/$m^2$ . This result is shown in Table 2.

<Comparative Example CD2> Fabrication and evaluation of light emitting device CD2

A light emitting device CD2 was fabricated in the same manner as in Example D2, excepting that the electron transporting layer (B) was not formed, in Example D2. Voltage was applied to the light emitting device CD2, to observe EL emission mainly derived from the phosphorescent compound MC2. The luminance shown by the light emitting device CD2 when 10 V was applied was 18 cd/$m^2$ . This result is shown in Table 2.

<Example D5> Fabrication and evaluation of light emitting device D5

A light emitting device D5 was fabricated in the same manner as in Example D2, excepting that a xylene solution prepared by dissolving the low molecular weight compound 2 and the phosphorescent compound MC2 (low molecular weight compound 2/phosphorescent compound MC2 = 64% by weight/36% by weight) at a concentration of 1.5% by weight in xylene was used instead of the xylene solution prepared by dissolving the polymer compound HP2 and the phosphorescent compound MC2 (polymer compound HP2/phosphorescent compound MC2 = 64% by weight/36% by weight) at a concentration of 1.5% by weight in xylene and excepting that the substrate carrying the light emitting layer formed thereon was placed in a vapor deposition machine, the internal pressure was reduced to $1.0\times10^{-4}$ Pa or less, then, the low molecular weight compound 1 was vapor-deposited with a thickness of 10 nm on the light emitting layer, to form an electron transporting layer (A) instead of a process in which the polymer compound 1 was dissolved at a concentration of 0.2% by weight in 2,2,3,3,4,4,5,5-octafluoro-1-pentanol to obtain a solution, the solution was spin-coated on the light emitting layer to form a film with a thickness of 10 nm, and the film was heated at 130°C for 10 minutes under a nitrogen gas atmosphere, to form an electron transporting layer (A), in Example D2. Voltage was applied to the light emitting device D5, to observe EL emission mainly derived from the phosphorescent compound MC2. The luminance shown by the light emitting device D5 when 10 V was applied was 163 cd/$m^2$ . This result is shown in Table 2.

<Example D6> Fabrication and evaluation of light emitting device D6

A light emitting device D6 was fabricated in the same manner as in Example D2, excepting that a xylene solution prepared by dissolving the polymer compound HP3 and the phosphorescent compound MC2 (polymer compound HP3/phosphorescent compound MC2 = 64% by weight/36% by weight) at a concentration of 1.5% by weight in xylene was used instead of the xylene solution prepared by dissolving the polymer compound HP2 and the phosphorescent compound MC2 (polymer compound HP2/phosphorescent compound MC2 = 64% by weight/36% by weight) at a concentration of 1.5% by weight in xylene, in Example D2. Voltage was applied to the light emitting device D6, to observe EL emission mainly derived from the phosphorescent compound MC2. The luminance shown by the light emitting device D6 when 10 V was applied was 3750 cd/$m^2$ . This result is shown in Table 2.

[Table 2]

| light emitting device | light emitting layer | | electron transporting layer (A) | electron transporting layer (B) | emission luminance (cd/$m^2$) (10 V) |
|---|---|---|---|---|---|
| | host material | metal complex | | | |
| D1 | polymer compound HP1 (2.65 eV) | MC1 (2.4 eV) | polymer compound 1 (2.57 eV) | polymer compound 2 (2.84 eV) | 691 |
| D3 | polymer compound HP1 (2.65 eV) | MC1 (2.4 eV) | polymer compound 1 (2.57 eV) | polymer compound 3 (2.91 eV) | 680 |

(continued)

| light emitting device | light emitting layer | | electron transporting layer (A) | electron transporting layer (B) | emission luminance (cd/m$^2$) (10 V) |
|---|---|---|---|---|---|
| | host material | metal complex | | | |
| D4 | polymer compound HP1 (2.65 eV) | MC1 (2.4 eV) | low molecular weight compound 1 (2.60 eV) | polymer compound 2 (2.84 eV) | 1147 |
| CD1 | polymer compound HP1 (2.65 eV) | MC1 (2.4 eV) | polymer compound 1 (2.57 eV) | none | 304 |
| D2 | polymer compound HP2 (2.59eV or less) | MC2 (2.8 eV) | polymer compound 1 (2.57 eV) | polymer compound 2 (2.84 eV) | 26 |
| CD2 | polymer compound HP2 (2.59eV or less) | MC2 (2.8 eV) | polymer compound 1 (2.57 eV) | none | 18 |
| D5 | low molecular weight compound 2 (2.61 eV) | MC2 (2.8 eV) | weight molecular compound 1 (2.60 eV) | polymer compound 2 (2.84 eV) | 163 |
| D6 | polymer compound HP3 (1.94 eV) | MC2 (2.8 eV) | polymer compound 1 (2.57 eV) | polymer compound 2 (2.84 eV) | 3750 |

## Claims

**1.** A light emitting device comprising
an anode,
a cathode,
a phosphorescent light emitting layer disposed between the anode and the cathode,
an electron transporting layer (B) disposed between the cathode and the light emitting layer and adjacent to the cathode, and
an electron transporting layer (A) disposed between the light emitting layer and the electron transporting layer (B), wherein
the electron transporting layer (B) comprises an organic compound,
the cathode contains a metal material in an amount of 1% by weight or more, wherein said metal material is Al, Au, Ag, Cu, ZnO, ITO or IZO,
at least one of a compound contained in an amount of 5% by weight or more in the electron transporting layer (A) and a compound contained in an amount of 5% by weight or more in the electron transporting layer (B) is:

(a) an aromatic polymer compound comprising a constitutional unit represented by the following formula (ET-1); or
(b) a compound having an aromatic heterocyclic ring represented by the following formula (H-1);

P (eV) which is the smallest work function of the metal material contained in an amount of 1% by weight or more in the cathode satisfies the formula (1A),
Q (eV) which is the smallest electron affinity of the compound contained in an amount of 5% by weight or more in the light emitting layer satisfies the formula (2A),
P (eV), Q (eV), RA (eV) which is the smallest electron affinity of the compound contained in an amount of 5% by weight or more in the electron transporting layer (A) and RB (eV) which is the smallest electron affinity of the compound contained in an amount of 5% by weight or more in the electron transporting layer (B) satisfy the formula (3A) and the formula (4A),
wherein the electron affinity of a compound is determined by subtracting the value of energy (eV) of the absorption edge at the longer wavelength side of the absorption wavelength of the compound from the value of ionization potential (eV) of the compound,
the absorption wavelength of a compound is obtained by measuring with an ultraviolet•visible•near infrared spectrometer,
the ionization potential (eV) of a compound is measured by a photoelectron spectrometer in the air, and
the work function of a metal is measured by a photoelectron spectrometer in the air, and
the phosphorescent light emitting layer comprises an iridium complex represented by the formula Ir-1, Ir-2, Ir-3, Ir-4 or Ir-5:

$$P > 3.5 \quad (1A)$$

$$Q < 2.7 \quad (2A)$$

$$P > RB > Q \quad (3A)$$

$$RB > RA \quad (4A):$$

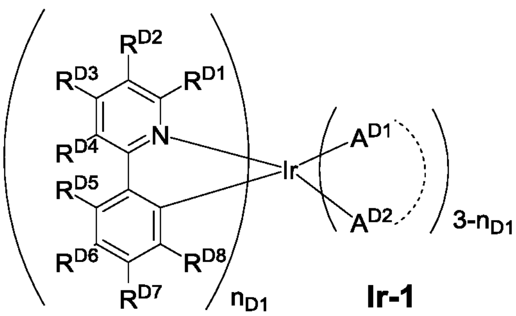
Ir-1

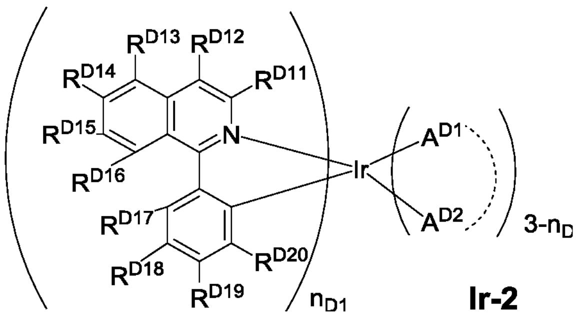
Ir-2

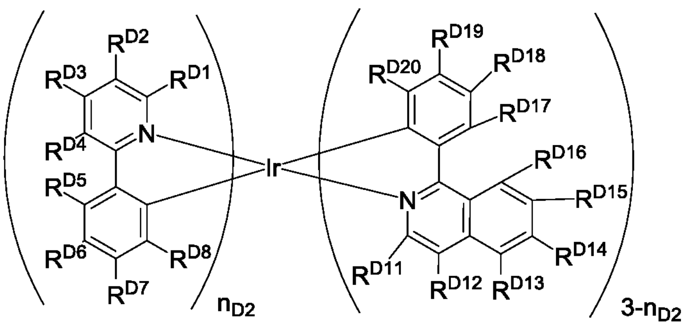
Ir-3

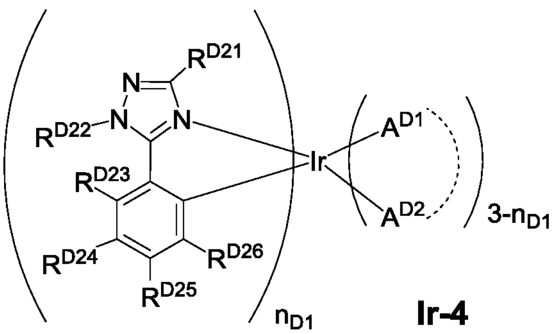
Ir-4

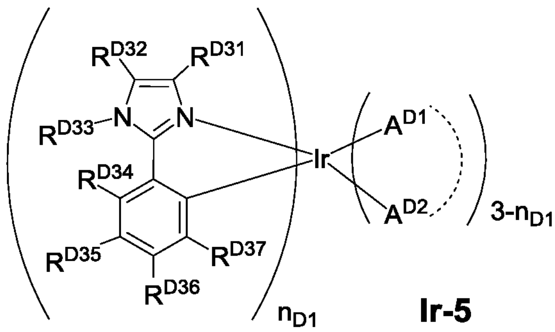
Ir-5

wherein

$R^{D1}$ to $R^{D8}$, $R^{D11}$ to $R^{D20}$, $R^{D21}$ to $R^{D26}$ and $R^{D31}$ to $R^{D37}$ each independently represent a hydrogen atom, an

alkyl group, a cycloalkyl group, an alkoxy group, a cycloalkoxy group, an aryl group, an aryloxy group, a monovalent heterocyclic group or a halogen atom and these groups each optionally have a substituent, and when a plurality of $R^{D1}$ to $R^{D8}$, $R^{D11}$ to $R^{D20}$, $R^{D21}$ to $R^{D26}$ and $R^{D31}$ to $R^{D37}$ are present, they may be the same or different at each occurrence,

$-A^{D1}---A^{D2}-$ represents an anionic bidentate ligand, and $---A^{D1}$ and $A^{D2}$ each independently represent a carbon atom, an oxygen atom or a nitrogen atom linking to an iridium atom and these atoms each may be an atom consisting a ring, and when a plurality of $-A^{D1}---A^{D2}-$ are present, they may be the same or different,

$n_{D1}$ represents 1, 2 or 3, and $n_{D2}$ represents 1 or 2, and

provided that at least one of $R^{D1}$ to $R^{D8}$ in the formula Ir-1 is a group represented by the formula (D-A), at least one of $R^{D11}$ to $R^{D20}$ in the formula Ir-2 is a group represented by the formula (D-A), and at least one of $R^{D1}$ to $R^{D8}$ and $R^{D11}$ to $R^{D20}$ in the formula Ir-3 is a group represented by the formula (D-A) :

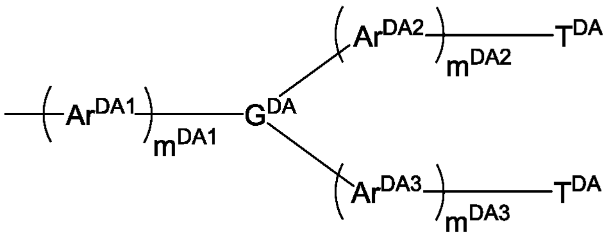

**(D-A)**

wherein

$m^{DA1}$ , $m^{DA2}$ and $m^{DA3}$ each independently represent an integer of 0 or more,

$G^{DA}$ represents a nitrogen atom, an aromatic hydrocarbon group or a heterocyclic group and these groups each optionally have a substituent,

$Ar^{DA1}$, $Ar^{DA2}$ and $Ar^{DA3}$ each independently represent an arylene group or a divalent heterocyclic group and these groups each optionally have a substituent, and when a plurality of $Ar^{DA1}$, $Ar^{DA2}$ and $Ar^{DA3}$ are present, they may be the same or different at each occurrence, and

$T^{DA}$ represents an aryl group or a monovalent heterocyclic group and these groups each optionally have a substituent, and the plurality of $T^{DA}$ may be the same or different:

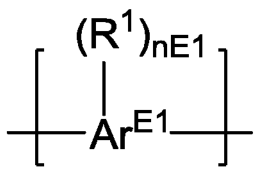

(ET-1)

wherein

$R^1$ represents a group represented by the formula (2), the formula (3) or the formula (4), and when a plurality of $R^1$ are present, they may be the same or different,

nE1 represents an integer of 1 or more,

$Ar^{E1}$ represents an aromatic hydrocarbon group or a heterocyclic group, and

the constitutional unit represented by the formula (ET-1) optionally has a substituent other than $R^1$:

$$-R^3-\{(Q^1)_{n1}-Y^1(M^1)_{a1}(Z^1)_{b1}\}_{m2} \qquad (2)$$

wherein

$R^3$ represents a single bond, a hydrocarbon group, a heterocyclic group or $-O-R^{3'}$, wherein $R^{3'}$ represents a hydrocarbon group or a heterocyclic group, and these groups each optionally have a substituent,

$Q^1$ represents an alkylene group, a cycloalkylene group, an arylene group, an oxygen atom or a sulfur atom and these groups each optionally have a substituent, and when a plurality of $Q^1$ are present, they may be the same or different,

$Y^1$ represents $-CO_2^-$, $-SO_3^-$, $-SO_2^-$ or $-PO_3^{2-}$, and when a plurality of $Y^1$ are present, they may be

the same or different,
$M^1$ represents an alkali metal cation, an alkaline earth metal cation or an ammonium cation and this ammonium cation optionally has a substituent, and when a plurality of $M^1$ are present, they may be the same or different,
$Z^1$ represents $F^-$, $Cl^-$, $Br^-$, $I^-$, $OH^-$, $B(R^{aa})_4^-$, $R^{aa}SO_3^-$, $R^{aa}COO^-$, $NO_3^-$, $SO_4^{2-}$, $HSO_4^-$, $PO_4^{3-}$, $HPO_4^{2-}$, $H_2PO_4^-$, $BF_4^-$ or $PF_6^-$, and $R^{aa}$ represents an alkyl group, a cycloalkyl group or an aryl group and these groups each optionally have a substituent, and when a plurality of $Z^1$ are present, they may be the same or different, and
n1 represents an integer of 0 or more, a1 represents an integer of 1 or more, b1 represents an integer of 0 or more and m2 represents an integer of 1 or more, and when a plurality of n1, a1 and b1 are present, they may be the same or different at each occurrence, and m2 is 1 when $R^3$ is a single bond, and a1 and b1 are selected in such a manner that the electric charge of the group represented by the formula (2) is 0:

$$-R^4-\{(Q^2)_{n2}-Y^2(M^2)_{a2}(Z^2)_{b2}\}m3 \qquad (3)$$

wherein

$R^4$ represents a single bond, a hydrocarbon group, a heterocyclic group or $-O-R^{4'}$, wherein $R^{4'}$ represents a hydrocarbon group or a heterocyclic group, and these groups each optionally have a substituent,
$Q^2$ represents an alkylene group, a cycloalkylene group, an arylene group, an oxygen atom or a sulfur atom and these groups each optionally have a substituent, and when a plurality of $Q^2$ are present, they may be the same or different,
$Y^2$ represents $-C^+R^c_2$, $-N^+R^c_3$, $-P^+R^c_3$, $-S^+R^c_2$ or $-I^+R^c_2$, and $R^c$ represents an alkyl group, a cycloalkyl group or an aryl group and these groups each optionally have a substituent, and the plurality of $R^c$ may be the same or different, and when a plurality of $Y^2$ are present, they may be the same or different,
$M^2$ represents $F^-$, $Cl^-$, $Br^-$, $I^-$, $OH^-$, $B(R^b)_4^-$, $R^bSO_3^-$, $R^bCOO^-$, $BF_4^-$, $SbCl_6$ - or $SbF_6^-$, and $R^b$ represents an alkyl group, a cycloalkyl group or an aryl group and these groups optionally have a substituent, and when a plurality of $R^b$ are present, they may be the same or different, and when a plurality of $M^2$ are present, they may be the same or different,
$Z^2$ represents an alkali metal cation or an alkaline earth metal cation, and when a plurality of $Z^2$ are present, they may be the same or different, and
n2 represents an integer of 0 or more, a2 represents an integer of 1 or more, b2 represents an integer of 0 or more and m3 represents an integer of 1 or more, and when a plurality of n2, a2 and b2 are present, they may be the same or different at each occurrence, and m3 is 1 when $R^4$ is a single bond, and a2 and b2 are selected in such a manner that the electric charge of the group represented by the formula (3) is 0:

$$-R^5-\{(Q^3)_{n3}-Y^3\}_{m4} \qquad (4)$$

wherein

$R^5$ represents a single bond, a hydrocarbon group, a heterocyclic group or $-O-R^{5'}$, wherein $R^{5'}$ represents a hydrocarbon group or a heterocyclic group, and these groups each optionally have a substituent,
$Q^3$ represents an alkylene group, a cycloalkylene group, an arylene group, an oxygen atom or a sulfur atom and these groups each optionally have a substituent, and when a plurality of $Q^3$ are present, they may be the same or different,
$Y^3$ represents a group represented by the formula (5) or the formula (6), and when a plurality of $Y^3$ are present, they may be the same or different, and
n3 represents an integer of 0 or more, and m4 represents an integer of 1 or more, and when a plurality of n3 are present, they may be the same or different, and when $R^5$ is a single bond, m4 is 1:

$$-O-(R'O)_{a3}-R'' \qquad (5)$$

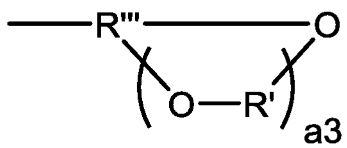

(6)

wherein

R' represents an alkylene group, a cycloalkylene group or an arylene group and these groups each optionally have a substituent, and when a plurality of R' are present, they may be the same or different,
R" represents a hydrogen atom, an alkyl group, a cycloalkyl group or an aryl group and these groups each optionally have a substituent,
R''' represents a hydrocarbon group and this hydrocarbon group optionally has a substituent, and
a3 represents an integer of 1 or more:

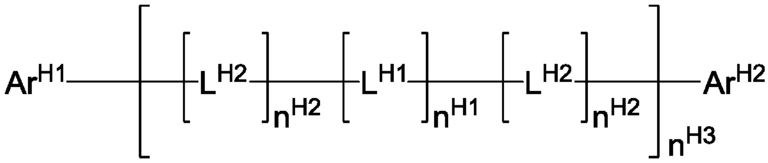

(H-1)

wherein

$Ar^{H1}$ and $Ar^{H2}$ each independently represent an aryl group or a monovalent heterocyclic group and these groups each optionally have a substituent,
$n^{H1}$ and $n^{H2}$ each independently represent 0 or 1, and when a plurality of $n^{H1}$ are present, they may be the same or different, and the plurality of $n^{H2}$ may be the same or different,
$n^{H3}$ represents an integer of 0 or more,
$L^{H1}$ represents an arylene group, a divalent heterocyclic group or a group represented by $-[C(R^{H11})_2]n^{H11}-$ and these groups each optionally have a substituent, and when a plurality of $L^{H1}$ are present, they may be the same or different,
$n^{H11}$ represents an integer of 1 or more and 10 or less, and $R^{H11}$ represents a hydrogen atom, an alkyl group, a cycloalkyl group, an alkoxy group, a cycloalkoxy group, an aryl group or a monovalent heterocyclic group and these groups each optionally have a substituent, and the plurality of $R^{H11}$ may be the same or different and may be combined together to form a ring together with the carbon atoms to which they are attached,
$L^{H2}$ represents a group represented by $-N(-L^{H21}-R^{H21})-$, and when a plurality of $L^{H2}$ are present, they may be the same or different, and
$L^{H21}$ represents a single bond, an arylene group or a divalent heterocyclic group and these groups each optionally have a substituent, and $R^{H21}$ represents a hydrogen atom, an alkyl group, a cycloalkyl group, an aryl group or a monovalent heterocyclic group and these groups each optionally have a substituent.

**2.** The light emitting device according to claim 1, wherein RB (eV) and RA (eV) satisfy the following formula (5A):

$$RB - RA \geq 0.2 \qquad (5A).$$

**3.** The light emitting device according to claim 1 or 2, wherein Q (eV) and RA (eV) satisfy the following formula (6A) :

$$RA - Q \geq 0.2 \qquad (6A).$$

4. The light emitting device according to claim 1, wherein the group represented by the formula (2) is a group represented by the formula (2'):

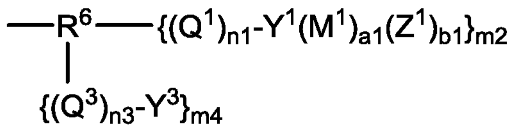

(2')

wherein

$R^6$ represents an aromatic hydrocarbon group or a heterocyclic group and these groups each optionally have a substituent, and
n1, a1, b1, m2, $Q^1$, $Y^1$, $M^1$, $Z^1$, n3, m4, $Q^3$ and $Y^3$ represent the same meaning as described above.

5. The light emitting device according to claim 1, wherein the group represented by the formula (3) is a group represented by the formula (3'):

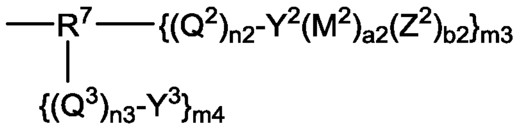

(3')

wherein

$R^7$ represents an aromatic hydrocarbon group or a heterocyclic group and these groups each optionally have a substituent, and
n2, a2, b2, m3, $Q^2$, $Y^2$ , $M^2$, $Z^2$, n3, m4, $Q^3$ and $Y^3$ represent the same meaning as described above.

6. The light emitting device according to claim 1, wherein the compound represented by the formula (H-1) is a compound represented by the formula (H-2):

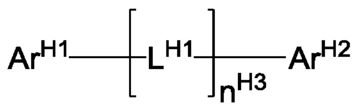

(H-2)

wherein $Ar^{H1}$, $Ar^{H2}$, $n^{H3}$ and $L^{H1}$ represent the same meaning as described above.

7. A production method of the light emitting device according to claim 1, comprising a step of forming at least one selected from the group consisting of an electron transporting layer (A), an electron transporting layer (B) and a cathode by application.

**Patentansprüche**

1. Lichtemittierende Vorrichtung, umfassend
eine Anode
eine Kathode,
eine phosphoreszierende lichtemittierende Schicht, angeordnet zwischen der Anode und der Kathode,
eine Elektronentransportschicht (B), angeordnet zwischen der Kathode und der lichtemittierenden Schicht und angrenzend an die Kathode, und
eine Elektronentransportschicht (A), angeordnet zwischen der lichtemittierenden Schicht und der Elektronentransportschicht (B),
wobei
die Elektronentransportschicht (B) eine organische Verbindung umfasst,
die Kathode Metallmaterial in einer Menge von 1 Gewichtsprozent oder mehr beinhaltet, wobei das Metallmaterial

Al, Au, Ag, Cu, ZnO, ITO oder IZO ist,
zumindest eine von einer Verbindung, die in einer Menge von 5 Gewichtsprozent oder mehr in der Elektronentransportschicht (A) enthalten ist, und einer Verbindung, die in einer Menge von 5 Gewichtsprozent oder mehr in der Elektronentransportschicht (B) enthalten ist, Folgendes ist:

(a) eine aromatische Polymerverbindung, umfassend eine Struktureinheit, dargestellt durch die folgende Formel (ET-1); oder
(b) eine Verbindung mit einem aromatischen heterocyclischen Ring, dargestellt durch die folgende Formel (H-1);

P (eV), welches die geringste Arbeitsfunktion des Metallmaterials ist, das in einer Menge von 1 Gewichtsprozent oder mehr in der Kathode enthalten ist, genügt der Formel (1A),
Q (eV), welches die kleinste Elektronenaffinität der Verbindung ist, die in einer Menge von 5 Gewichtsprozent oder mehr in der lichtemittierenden Schicht enthalten ist, genügt der Formel (2A),
P (eV), Q (eV), RA (eV), welches die kleinste Elektronenaffinität der Verbindung ist, die in einer Menge von 5 Gewichtsprozent oder mehr in der Elektronentransportschicht (A) enthalten ist, und RB (eV), welches die kleinste Elektronenaffinität der Verbindung ist, die in einer Menge von 5 Gewichtsprozent oder mehr in der Elektronentransportschicht (B) enthalten ist, genügen der Formel (3A) und der Formel (4A),
wobei die Elektronenaffinität einer Verbindung bestimmt wird durch Abziehen des Energiewertes (eV) der Absorptionskante an der längeren Wellenlängenseite der Absorptionswellenlänge der Verbindung von dem Ionisierungspotentialwert (eV) der Verbindung,
wobei die Absorptionswellenlänge einer Verbindung durch Messen mit einem UV-VIS-NIR-Spektrometer erhalten wird,
das Ionisierungspotential (eV) einer Verbindung durch ein Photoelektronenspektrometer in der Luft gemessen wird, und
die Arbeitsfunktion eines Metalls durch ein Photoelektronenspektrometer in der Luft gemessen wird, und
die phosphoreszierende lichtemittierende Schicht einen Iridiumkomplex umfasst, dargestellt durch die Formel Ir-1, Ir-2, Ir-3, Ir-4 oder Ir-5:

$$P > 3{,}5 \qquad (1A)$$

$$Q < 2{,}7 \qquad (2A)$$

$$P > RB > Q \qquad (3A)$$

$$RB > RA \qquad (4A):$$

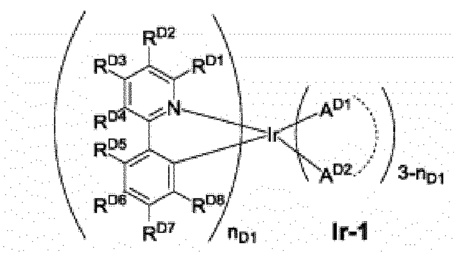
Ir-1

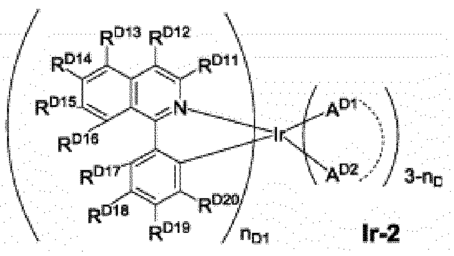
Ir-2

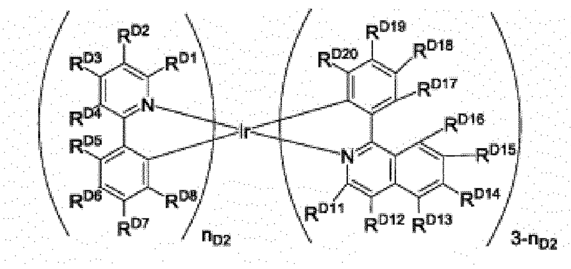

Ir-3

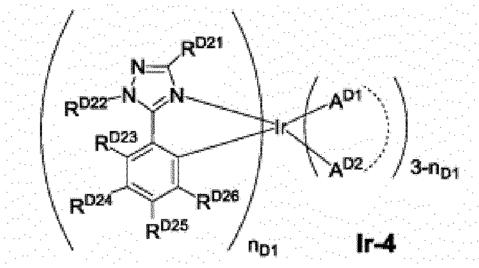

Ir-4

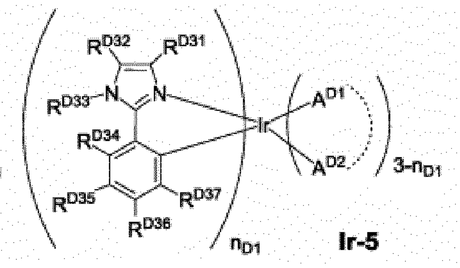

Ir-5

,

wobei

$R^{D1}$ bis $R^{D8}$, $R^{D11}$ bis $R^{D20}$, $R^{D21}$ bis $R^{D26}$ und $R^{D31}$ bis $R^{D37}$ jeweils unabhängig voneinander ein Wasserstoffatom, eine Alkylgruppe, eine Cycloalkylgruppe, eine Alkoxygruppe, eine Cycloalkoxygruppe, eine Arylgruppe, eine Aryloxygruppe, eine monovalente heterocyclische Gruppe oder ein Halogenatom darstellen und diese Gruppen jeweils optional einen Substituenten haben, und wenn eine Vielzahl von $R^{D1}$ bis $R^{D8}$, $R^{D11}$ bis $R^{D20}$, $R^{D21}$ bis $R^{D26}$ und $R^{D31}$ bis $R^{D37}$ vorhanden ist, diese bei jedem Auftreten gleich oder verschieden sein können,
$-A^{D1}---A^{D2}-$ einen zweizähnigen anionischen Liganden darstellt, und $A^{D1}$ und $A^{D2}$ jeweils unabhängig voneinander ein Kohlenstoffatom, ein Sauerstoffatom oder ein Stickstoffatom, verbunden mit einem Iridiumatom, darstellen, und diese Atome jeweils ein aus einem Ring bestehendes Atom sein können, und wenn eine Vielzahl von $-A^{D1}---A^{D2}$-vorhanden ist, diese gleich oder verschieden sein können, wobei
$n_{D1}$ 1, 2 oder 3 darstellt und $n_{D2}$ 1 oder 2 darstellt, und
vorausgesetzt, dass zumindest eines von $R^{D1}$ bis $R^{D8}$ in der Formel Ir-1 eine Gruppe dargestellt durch die Formel (D-A) ist, zumindest eines von $R^{D11}$ bis $R^{D20}$ in der Formel Ir-2 eine Gruppe dargestellt durch die Formel (D-A) ist und zumindest eines von $R^{D1}$ bis $R^{D8}$ und $R^{D11}$ bis $R^{D20}$ in der Formel Ir-3 eine Gruppe dargestellt durch die Formel (D-A) ist:

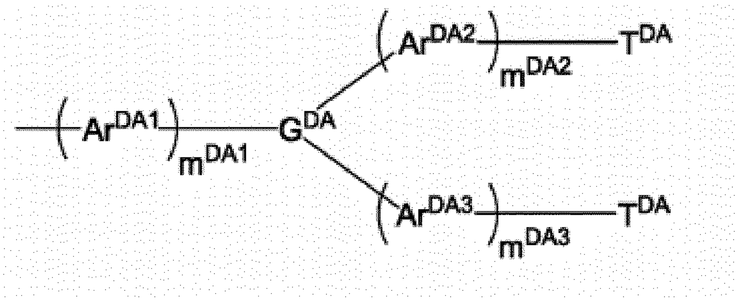

(D-A)

,

wobei

$m^{DA1}$, $m^{DA2}$ und $m^{DA3}$ jeweils unabhängig voneinander eine ganze Zahl von 0 oder mehr darstellen,
$G^{DA}$ ein Stickstoffatom, eine aromatische Kohlenwasserstoffgruppe oder eine heterocyclische Gruppe darstellt und diese Gruppen jeweils optional einen Substituenten haben,
$Ar^{DA1}$, $Ar^{DA2}$ und $Ar^{DA3}$ jeweils unabhängig voneinander eine Arylengruppe oder eine divalente heterocyclische Gruppe darstellen und diese Gruppen jeweils optional einen Substituenten haben, und wenn eine Vielzahl von $Ar^{DA1}$, $Ar^{DA2}$ und $Ar^{DA3}$ vorhanden ist, diese bei jedem Auftreten gleich oder verschieden sein können, und
$T^{DA}$ eine Arylgruppe oder eine monovalente heterocyclische Gruppe darstellt und diese Gruppen jeweils

optional einen Substituenten haben, und die Vielzahl von $T^{DA}$ gleich oder verschieden sein kann:

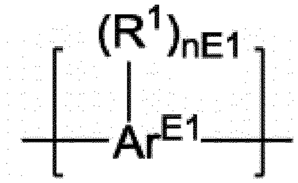

(ET-1)

,

wobei

$R^1$ eine Gruppe, dargestellt durch die Formel (2), die Formel (3) oder die Formel (4), darstellt, und wenn eine Vielzahl von $R^1$ vorhanden ist, diese gleich oder verschieden sein können,
nE1 eine ganze Zahl von 1 oder mehr darstellt,
$Ar^{E1}$ eine aromatische Kohlenwasserstoffgruppe oder eine heterocyclische Gruppe darstellt, und die Struktureinheit, die durch die Formel (ET-1) dargestellt wird, optional einen anderen Substituenten als $R^1$ hat:

$$-R^3-\{(Q^1)_{n1}-Y^1(M^1)_{a1}(Z^1)_{b1}\}_{m2} \qquad (2)$$

wobei

$R^3$ eine Einfachbindung, eine Kohlenwasserstoffgruppe, eine heterocyclische Gruppe oder $-O-R^{3'}$ darstellt, wobei $R^{3'}$ eine Kohlenwasserstoffgruppe oder eine heterocyclische Gruppe darstellt und diese Gruppen jeweils optional einen Substituenten haben,
$Q^1$ eine Alkylengruppe, eine Cycloalkylengruppe, eine Arylengruppe, ein Sauerstoffatom oder ein Schwefelatom darstellt und diese Gruppen jeweils optional einen Substituenten haben, und wenn eine Vielzahl von $Q^1$ vorhanden ist, diese gleich oder verschieden sein können,
$Y^1$ $-CO_2^-$, $-SO_3^-$, $-SO_2^-$ oder $-PO_3^{2-}$ darstellt, und wenn eine Vielzahl von $Y^1$ vorhanden ist, diese gleich oder verschieden sein können,
$M^1$ ein Alkalimetallkation, ein Erdalkalimetallkation oder ein Ammoniumkation darstellt und dieses Ammoniumkation optional einen Substituenten hat, und wenn eine Vielzahl von $M^1$ vorhanden ist, diese gleich oder verschieden sein können,
$Z^1$ $F^-$, $Cl^-$, $Br^-$, $I^-$, $OH^-$, $B(R^{aa})_4^-$, $R^{aa}SO_3^-$, $R^{aa}COO^-$, $NO_3^-$, $SO_4^{2-}$, $HSO_4^-$, $PO_4^{3-}$, $HPO_4^{2-}$, $H_2PO_4^-$, $BF_4^-$ oder $PF_6^-$ darstellt, und $R^{aa}$ eine Alkylgruppe, eine Cycloalkylgruppe oder eine Arylgruppe darstellt und diese Gruppen jeweils optional einen Substituenten haben, und wenn eine Vielzahl von $Z^1$ vorhanden ist, diese gleich oder verschieden sein können, und
n1 eine ganze Zahl von 0 oder mehr darstellt, a1 eine ganze Zahl von 1 oder mehr darstellt, b1 eine ganze Zahl von 0 oder mehr darstellt und m2 eine ganze Zahl von 1 oder mehr darstellt, und wenn eine Vielzahl von n1, a1 und b1 vorhanden ist, diese bei jedem Auftreten gleich oder verschieden sein können, und m2 1 ist, wenn $R^3$ eine Einfachbindung ist, und a1 und b1 in einer solchen Weise ausgewählt sind, dass die elektrische Ladung der Gruppe, dargestellt durch die Formel (2), 0 ist:

$$-R^4-\{(Q^2)_{n2}-Y^2(M^2)_{a2}(Z^2)_{b2}\}_{m3} \qquad (3)$$

wobei

$R^4$ eine Einfachbindung, eine Kohlenwasserstoffgruppe, eine heterocyclische Gruppe oder $-O-R^{4'}$ darstellt, wobei $R^{4'}$ eine Kohlenwasserstoffgruppe oder eine heterocyclische Gruppe darstellt, und diese Gruppen jeweils optional einen Substituenten haben,
$Q^2$ eine Alkylengruppe, eine Cycloalkylengruppe, eine Arylengruppe, ein Sauerstoffatom oder ein Schwefelatom darstellt und diese Gruppen jeweils optional einen Substituenten haben, und wenn eine Vielzahl von $Q^2$ vorhanden ist, diese gleich oder verschieden sein können,
$Y^2$ $-C^+R^c2$, $-N^+R^c_3$, $-P^+R^c_3$, $-S^+R^c_2$ oder $-I^+R^c_2$ darstellt, und $R^c$ eine Alkylgruppe, eine Cycloalkylgruppe oder eine Arylgruppe darstellt und diese Gruppen jeweils optional einen Substituenten haben, und die Vielzahl von $R^c$ gleich oder verschieden sein kann, und wenn eine

Vielzahl von $Y^2$ vorhanden ist, diese gleich oder verschieden sein können,
$M^2$ F-, Cl-, Br-, I-, OH-, $B(R^b)_4$-, $R^bSO_3$-, $R^bCOO$-, $BF_4$-, $SbCl_6$- oder $SbF_6$- darstellt, und $R^b$ eine Alkylgruppe, eine Cycloalkylgruppe oder eine Arylgruppe darstellt und diese Gruppen optional einen Substituenten haben, und wenn eine Vielzahl von $R^b$ vorhanden ist, diese gleich oder verschieden sein können, und wenn eine Vielzahl von $M^2$ vorhanden ist, diese gleich oder verschieden sein können,
$Z^2$ ein Alkalimetallkation oder ein Erdalkalimetallkation darstellt, und wenn eine Vielzahl von $Z^2$ vorhanden ist, diese gleich oder verschieden sein können, und
n2 eine ganze Zahl von 0 oder mehr darstellt, a2 eine ganze Zahl von 1 oder mehr darstellt, b2 eine ganze Zahl von 0 oder mehr darstellt und m3 eine ganze Zahl von 1 oder mehr darstellt, und wenn eine Vielzahl von n2, a2 und b2 vorhanden ist, diese bei jedem Auftreten gleich oder verschieden sein können, und m3 1 ist, wenn $R^4$ eine Einfachbindung ist, und a2 und b2 in einer solchen Weise ausgewählt sind, dass die elektrische Ladung der Gruppe, dargestellt durch die Formel (3), 0 ist:

$$-R^5-\{(Q^3)_{n3}-Y^3\}_{m4} \qquad (4)$$

wobei

$R^5$ eine Einfachbindung, eine Kohlenwasserstoffgruppe, eine heterocyclische Gruppe oder $-O-R^{5'}$ darstellt, wobei $R^{5'}$ eine Kohlenwasserstoffgruppe oder eine heterocyclische Gruppe darstellt, und diese Gruppe jeweils optional einen Substituenten haben,
$Q^3$ eine Alkylengruppe, eine Cycloalkylengruppe, eine Arylengruppe, ein Sauerstoffatom oder ein Schwefelatom darstellt und diese Gruppen jeweils optional einen Substituenten haben, und wenn eine Vielzahl von $Q^3$ vorhanden ist, diese gleich oder verschieden sein können,
$Y^3$ eine Gruppe, dargestellt durch die Formel (5) oder die Formel (6), darstellt, und wenn eine Vielzahl von $Y^3$ vorhanden ist, diese gleich oder verschieden sein können, und
n3 eine ganze Zahl von 0 oder mehr darstellt, und m4 eine ganze Zahl von 1 oder mehr darstellt, und wenn eine Vielzahl von n3 vorhanden ist, diese gleich oder verschieden sein können, und wenn $R^5$ eine Einfachbindung ist, m4 1 ist:

$$-O-(R'O)_{a3}-R'' \qquad (5)$$

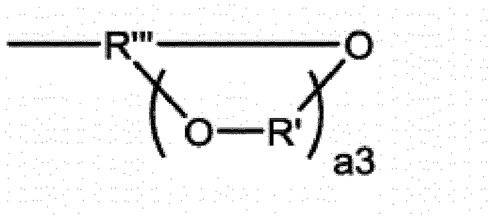

(6)

,

wobei

R' eine Alkylengruppe, eine Cycloalkylengruppe oder eine Arylgruppe darstellt und diese Gruppen jeweils optional einen Substituenten haben, und wenn eine Vielzahl von R' vorhanden ist, diese gleich oder verschieden sein können,
R" ein Wasserstoffatom, eine Alkylgruppe, eine Cycloalkylgruppe oder eine Arylgruppe darstellt und diese Gruppen jeweils optional einen Substituenten haben,
R'" eine Kohlenwasserstoffgruppe darstellt und diese Kohlenwasserstoffgruppe optional einen Substituenten hat, und
a3 eine ganze Zahl von 1 oder mehr darstellt:

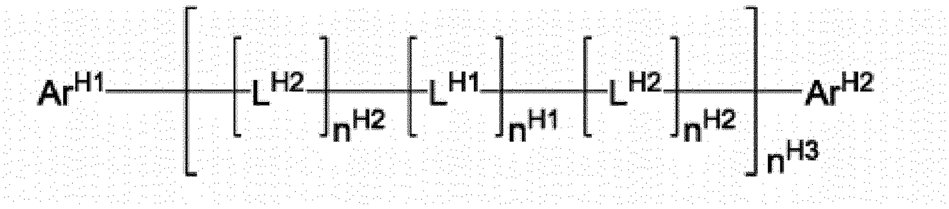 (H-1)

,

wobei

$Ar^{H1}$ und $Ar^{H2}$ jeweils unabhängig voneinander eine Arylgruppe oder eine monovalente heterocyclische Gruppe darstellen und diese Gruppen jeweils optional einen Substituenten haben,
$n^{H1}$ und $n^{H2}$ jeweils unabhängig voneinander 0 oder 1 darstellen, und wenn eine Vielzahl von $n^{H1}$ vorhanden ist, diese gleich oder verschieden sein können, und die Vielzahl von $n^{H2}$ gleich oder verschieden sein kann,
$n^{H3}$ eine ganze Zahl von 0 oder mehr darstellt,
$L^{H1}$ eine Arylengruppe, eine divalente heterocyclische Gruppe oder eine Gruppe, dargestellt durch $-[C(R^{H11})_2]n^{H11}-$, darstellt, und diese Gruppen jeweils optional einen Substituenten haben, und wenn eine Vielzahl von $L^{H1}$ vorhanden ist, diese gleich oder verschieden sein können,
$n^{H11}$ eine ganze Zahl von 1 oder mehr und 10 oder weniger darstellt, und $R^{H11}$ ein Wasserstoffatom, eine Alkylgruppe, eine Cycloalkylgruppe, eine Alkoxygruppe, eine Cycloalkoxygruppe, eine Arylgruppe oder eine monovalente heterocyclische Gruppe darstellt und diese Gruppen jeweils optional einen Substituenten haben, und die Vielzahl von $R^{H11}$ gleich oder verschieden sein kann und zusammen mit den Kohlenstoffatomen, an die sie gebunden sind, zu einem Ring kombiniert werden können,
$L^{H2}$ eine Gruppe, dargestellt durch $-N(-L^{H21}-R^{H21})-$, darstellt, und wenn eine Vielzahl von $L^{H2}$ vorhanden ist, diese gleich oder verschieden sein können, und
$L^{H21}$ eine Einfachbindung, eine Arylengruppe oder eine divalente heterocyclische Gruppe darstellt und diese Gruppen jeweils optional einen Substituenten haben, und $R^{H21}$ ein Wasserstoffatom, eine Alkylgruppe, eine Cycloalkylgruppe, eine Arylgruppe oder eine monovalente heterocyclische Gruppe darstellt und diese Gruppen jeweils optional einen Substituenten haben.

2. Lichtemittierende Vorrichtung nach Anspruch 1, wobei RB (eV) und RA (eV) der folgenden Formel (5A) genügen:

$$RB - RA \geq 0,2 \qquad (5A).$$

3. Lichtemittierende Vorrichtung nach Anspruch 1 oder 2, wobei Q (eV) und RA (eV) der folgenden Formel (6A) genügen:

$$RA - Q \geq 0,2 \qquad (6A).$$

4. Lichtemittierende Vorrichtung nach Anspruch 1, wobei die Gruppe, dargestellt durch die Formel (2), eine Gruppe, dargestellt durch die Formel (2'), ist:

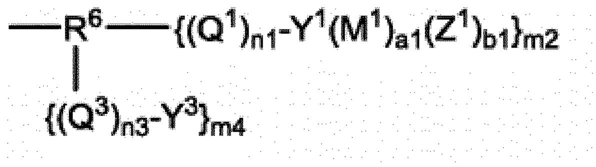 (2')

,

wobei

$R^6$ eine aromatische Kohlenwasserstoffgruppe oder eine heterocyclische Gruppe darstellt und diese Gruppen jeweils optional einen Substituenten haben, und
n1, a1, b1, m2, $Q^1$, $Y^1$, $M^1$, $Z^1$, n3, m4, $Q^3$ und $Y^3$ dieselbe Bedeutung wie oben beschrieben darstellen.

**5.** Lichtemittierende Vorrichtung nach Anspruch 1, wobei die Gruppe, dargestellt durch die Formel (3), eine Gruppe, dargestellt durch die Formel (3'), ist:

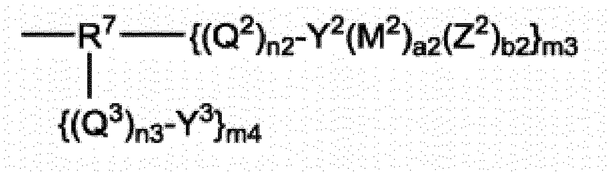

(3')

,

wobei

$R^7$ eine aromatische Kohlenwasserstoffgruppe oder eine heterocyclische Gruppe darstellt und diese Gruppen jeweils optional einen Substituenten haben, und
n2, a2, b2, m3, $Q^2$, $Y^2$, $M^2$, $Z^2$, n3, m4, $Q^3$ und $Y^3$ dieselbe Bedeutung wie oben beschrieben darstellen.

**6.** Lichtemittierende Vorrichtung nach Anspruch 1, wobei die Verbindung, dargestellt durch die Formel (H-1), eine Verbindung, dargestellt durch die Formel (H-2), ist:

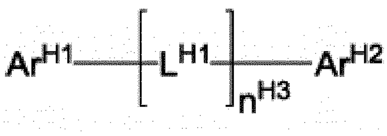

(H-2)

,

wobei $Ar^{H1}$, $Ar^{H2}$, $n^{H3}$ und $L^{H1}$ dieselbe Bedeutung wie oben beschrieben darstellen.

**7.** Produktionsverfahren der lichtemittierenden Vorrichtung nach Anspruch 1, umfassend einen Schritt des Bildens zumindest eines, ausgewählt aus der Gruppe bestehend aus einer Elektronentransportschicht (A), einer Elektronentransportschicht (B) und einer Kathode, durch Auftragen.

**Revendications**

**1.** Dispositif émetteur de lumière comprenant :

une anode,
une cathode,
une couche émettrice de lumière phosphorescente disposée entre l'anode et la cathode,
une couche de transport d'électrons (B) disposée entre la cathode et la couche émettrice de lumière et adjacente à la cathode, et
une couche de transport d'électrons (A) disposée entre la couche émettrice de lumière et la couche de transport d'électrons (B),
dans lequel
la couche de transport d'électrons (B) comprend un composé organique,
la cathode contient une matière métallique dans une quantité de 1 % en poids ou plus, dans lequel ladite matière métallique est Al, Au, Ag, Cu, ZnO, ITO ou IZO,
au moins l'un d'un composé contenu dans une quantité de 5 % en poids ou plus dans la couche de transport d'électrons (A) et d'un composé contenu dans une quantité de 5 % en poids ou plus dans la couche de transport d'électrons (B) est :

(a) un composé polymère aromatique comprenant un motif constitutif représenté par la formule (ET-1) suivante ; ou
(b) un composé ayant un cycle hétérocyclique représenté par la formule (H-1) suivante ;

P (eV) qui la plus petite fonction de travail de la matière métallique contenue dans une quantité de 1 % en poids ou plus dans la cathode satisfait la formule (1A),
Q (eV) qui est la plus petite affinité électronique du composé contenu dans une quantité de 5 % en poids ou plus dans la couche émettrice de lumière satisfait la formule (2A),
P (eV), Q (eV), RA (eV) qui est la plus petite affinité électronique du composé contenu dans une quantité de 5 % en poids ou plus dans la couche de transport d'électrons (A) et RB (eV) qui est la plus petite affinité électronique du composé contenu dans une quantité de 5 % ou plus dans la couche de transport d'électrons (B) satisfont la formule (3A) et la formule (4A),
dans lequel l'affinité électronique d'un composé est déterminée par soustraction de la valeur d'énergie (eV) du front d'absorption au niveau du côté de longueur d'onde plus longue de la longueur d'onde d'absorption du composé de la valeur de potentiel d'ionisation (eV) du composé,
la longueur d'onde d'absorption d'un composé est obtenue par mesure avec un spectromètre ultraviolet•visible•proche infrarouge,
le potentiel d'ionisation (eV) d'un composé est mesuré par un spectromètre photoélectronique dans l'air, et
la fonction de travail d'un métal est mesurée par un spectromètre photoélectronique dans l'air, et
la couche émettrice de lumière phosphorescente comprend un complexe d'iridium représenté par la formule Ir-1, Ir-2, Ir-3, Ir-4 ou Ir-5 :

$$P > 3,5 \qquad (1A)$$

$$Q < 2,7 \qquad (2A)$$

$$P > RB > Q \qquad (3A)$$

$$RB > RA \qquad (4A) :$$

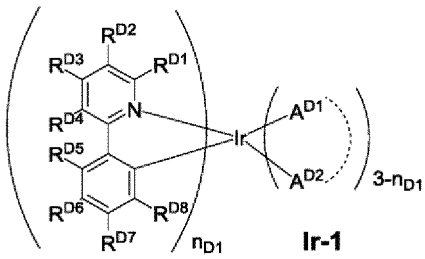

Ir-1

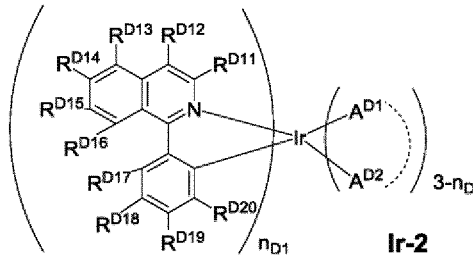

Ir-2

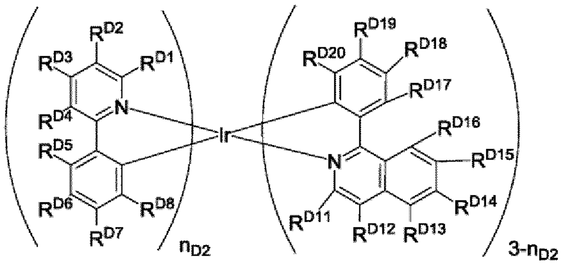

Ir-3

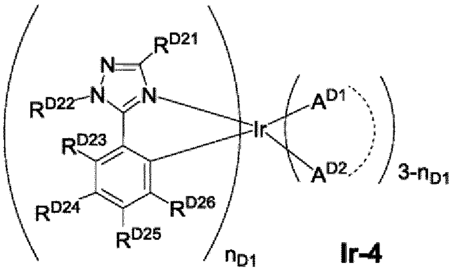

**Ir-4**

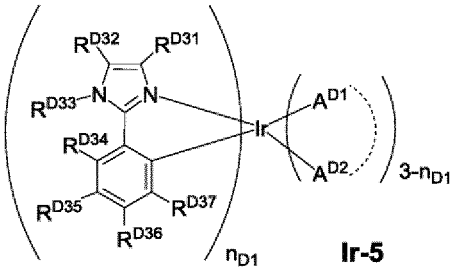

**Ir-5**

où

$R^{D1}$ à $R^{D8}$, $R^{D11}$ à $R^{D20}$, $R^{D21}$ à $R^{D26}$ et $R^{D31}$ à $R^{D37}$ représentent chacun indépendamment un atome d'hydrogène, un groupe alkyle, un groupe cycloalkyle, un groupe alcoxy, un groupe cycloalcoxy, un groupe aryle, un groupe aryloxy, un groupe hétérocyclique monovalent ou un atome d'halogène et ces groupes ont chacun éventuellement un substituant, et lorsqu'une pluralité de $R^{D1}$ à $R^{D8}$, $R^{D11}$ à $R^{D20}$, $R^{D21}$ à $R^{D26}$ et $R^{D31}$ à $R^{D37}$ sont présents ; ils peuvent être identiques ou différents à chaque occurrence,

$-A^{D1}$---$A^{D2}$- représente un ligand bidentate anionique, et $A^{D1}$ et $A^{D2}$ représentent chacun indépendamment un atome de carbone, un atome d'oxygène ou un atome d'azote se liant à un atome d'iridium et ces atomes peuvent chacun être un atome constitué par un cycle, et lorsqu'une pluralité de $-A^{D1}$---$A^{D2}$- sont présents, ils peuvent être identiques ou différents,

$n^{D1}$ représente 1, 2 ou 3, et $n^{D2}$ représente 1 ou 2, et

à condition qu'au moins l'un de $R^{D1}$ à $R^{D8}$ dans la formule Ir-1 soit un groupe représenté par la formule (D-A), qu'au moins l'un de $R^{D11}$ à $R^{D20}$ dans la formule Ir-2 soit un groupe représenté par la formule (D-A), et qu'au moins l'un de $R^{D1}$ à $R^{D8}$ et $R^{D11}$ à $R^{D20}$ dans la formule Ir-3 soit un groupe représenté par la formule (D-A) :

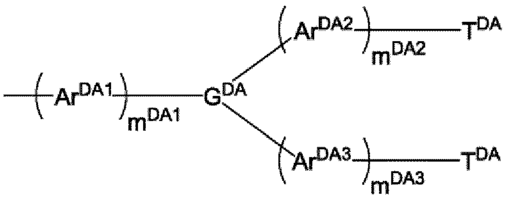

**(D-A)**

où

$m^{DA1}$, $m^{DA2}$ et $m^{DA3}$ représentent chacun indépendamment un entier de 0 ou plus,

$G^{DA}$ représente un atome d'azote, un groupe hydrocarboné aromatique ou un groupe hétérocyclique et ces groupes ont chacun éventuellement un substituant,

$Ar^{DA1}$, $Ar^{DA2}$ et $Ar^{DA3}$ représentent chacun indépendamment un groupe arylène ou un groupe hétérocyclique divalent et ces groupes ont chacun éventuellement un substituant, et lorsqu'une pluralité de $Ar^{DA1}$, $Ar^{DA2}$ et $Ar^{DA3}$ sont présents, ils peuvent être identiques ou différents à chaque occurrence, et

$T^{DA}$ représente un groupe aryle ou un groupe hétérocyclique monovalent et ces groupes ont chacun éventuellement un substituant, et la pluralité de $T^{DA}$ peuvent être identiques ou différents :

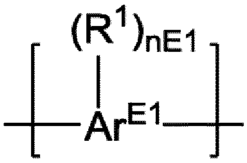

(ET-1)

où

$R^1$ représente un groupe représenté par la formule (2), la formule (3) ou la formule (4), et lorsqu'une pluralité de $R^1$ sont présents, ils peuvent être identiques ou différents,

nE1 représente un entier de 1 ou plus,

$Ar^{E1}$ représente un groupe hydrocarboné aromatique ou un groupe hétérocyclique, et
le motif constitutif représenté par la formule (ET-1) a éventuellement un substituant autre que R1 :

$$-R^3-\{(Q^1)_{n1}-Y^1(M^1)_{a1}(Z^1)_{b1}\}_{m2} \quad (2)$$

où

$R^3$ représente une liaison simple, un groupe hydrocarboné, un groupe hétérocyclique ou $-O-R^{3'}$, où $R^{3'}$ représente un groupe hydrocarboné ou un groupe hétérocyclique, et ces groupes ont chacun éventuellement un substituant,
$Q^1$ représente un groupe alkylène, un groupe cycloalkylène, un groupe arylène, un atome d'oxygène ou un atome de soufre et ces groupes ont chacun éventuellement un substituant, et lorsqu'une pluralité de $Q^1$ sont présents, ils peuvent être identiques ou différents,
$Y^1$ représente $-CO_2^-$, $-SO_3^-$, $-SO_2^-$ ou $-PO_3^{2-}$, et lorsqu'une pluralité de $Y^1$ sont présents, ils peuvent être identiques ou différents,
$M^1$ représente un cation de métal alcalin, un cation de métal alcalino-terreux ou un cation ammonium et ce cation ammonium a éventuellement un substituant, et lorsqu'une pluralité de $M^1$ sont présents, ils peuvent être identiques ou différents,
$Z^1$ représente $F^-$, $Cl^-$, $Br^-$, $I^-$, OH-, $B(R^{aa})_4^-$, $R^{aa}SO_3^-$, $R^{aa}COO^-$, $NO_3^-$, $SO_4^{2-}$, $HSO_4^-$, $PO_4^{3-}$, $HPO_4^{2-}$, $H_2PO_4^-$, $BF_4^-$ ou $PF_6^-$, et $R^{aa}$ représente un groupe alkyle, un groupe cycloalkyle ou un groupe aryle et ces groupes ont chacun éventuellement un substituant, et lorsqu'une pluralité de $Z^1$ sont présents, ils peuvent être identiques ou différents, et
n1 représente un entier de 0 ou plus, a1 représente un entier de 1 ou plus, b1 représente un entier de 0 ou plus et m2 représente un entier de 1 ou plus, et lorsqu'une pluralité de n1, a1 et b1 sont présents, ils peuvent être identiques ou différents à chaque occurrence, et m2 vaut 1 lorsque $R^3$ est une liaison simple, et a1 et b1 sont choisis de telle sorte que la charge électrique du groupe représenté par la formule (2) soit égale à 0 :

$$-R^4-\{(Q^2)_{n2}-Y^2(M^2)_{a2}(Z^2)_{b2}\}_{m3} \quad (3)$$

où

$R^4$ représente une liaison simple, un groupe hydrocarboné, un groupe hétérocyclique ou $-O-R^{4'}$, où $R^{4'}$ représente un groupe hydrocarboné ou un groupe hétérocyclique, et ces groupes ont chacun éventuellement un substituant,
$Q^2$ représente un groupe alkylène, un groupe cycloalkylène, un groupe arylène, un atome d'oxygène ou un atome de soufre et ces groupes ont chacun éventuellement un substituant, et lorsqu'une pluralité de $Q^2$ sont présents, ils peuvent être identiques ou différents,
$Y^2$ représente $-C^+R^c_2$, $-N^+R^c_3$, $-P^+R^c_3$, $-S^+R^c_2-$ ou $-I^+R^c_2$, et $R^c$ représente un groupe alkyle, un groupe cycloalkyle ou un groupe aryle et ces groupes ont chacun éventuellement un substituant, et la pluralité de $R^c$ peuvent être identiques ou différents, et lorsqu'une pluralité de $Y^2$ sont présents, ils peuvent être identiques ou différents,
$M^2$ représente $F^-$, $Cl^-$, $Br^-$, $I^-$, $OH^-$, $B(R^b)_4^-$, $R^bSO_3^-$, $R^bCOO^-$, $BF_4^-$, $SbCl_6^-$ ou $SbF_6^-$, et $R^b$ représente un groupe alkyle, un groupe cycloalkyle ou un groupe aryle et ces groupes ont éventuellement un substituant, et lorsqu'une pluralité de $R^b$ sont présents, ils peuvent être identiques ou différents, et lorsqu'une pluralité de $M^2$ sont présents, ils peuvent être identiques ou différents,
$Z^2$ représente un cation de métal alcalin ou un cation de métal alcalino-terreux, et lorsqu'une pluralité de $Z^2$ sont présents, ils peuvent être identiques ou différents, et
n2 représente un entier de 0 ou plus, a2 représente un entier de 1 ou plus, b2 représente un entier de 0 ou plus et m3 représente un entier de 1 ou plus, et lorsqu'une pluralité de n2, a2 et b2 sont présents, ils peuvent être identiques ou différents à chaque occurrence, et m3 vaut 1 lorsque $R^4$ est une liaison simple, et a2 et b2 sont choisis de telle sorte que la charge électrique du groupe représenté par la formule (3) soit égale à 0 :

$$-R^5-\{(Q^3)_{n3}-Y^3\}_{m4} \quad (4)$$

où

$R^5$ représente une liaison simple, un groupe hydrocarboné, un groupe hétérocyclique ou -O-$R^{5'}$, où $R^{5'}$ représente un groupe hydrocarboné ou un groupe hétérocyclique, et ces groupes ont chacun éventuellement un substituant,
$Q^3$ représente un groupe alkylène, un groupe cycloalkylène, un groupe arylène, un atome d'oxygène ou un atome de soufre et ces groupes ont chacun éventuellement un substituant, et lorsqu'une pluralité de $Q^3$ sont présents, ils peuvent être identiques ou différents,
$Y^3$ représente un groupe représenté par la formule (5) ou la formule (6), et lorsqu'une pluralité $Y^3$ sont présents, ils peuvent être identiques ou différents, et
n3 représente un entier de 0 ou plus, et m4 représente un entier de 1 ou plus, et lorsqu'une pluralité de n3 sont présents, ils peuvent être identiques, et lorsque $R^5$ est une liaison simple, m4 vaut 1 :

$$-O-(R'O)_{a3}-R'' \qquad (5)$$

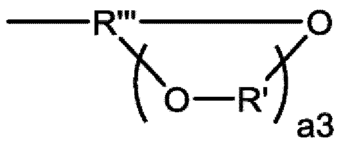

(6)

où

R' représente un groupe alkylène, un groupe cycloalkylène ou un groupe arylène et ces groupes ont chacun éventuellement un substituant, et lorsqu'une pluralité de R' sont présentes, ils peuvent être identiques ou différents,
R" représente un atome d'hydrogène, un groupe alkyle, un groupe cycloalkyle ou un groupe aryle et ces groupes ont chacun éventuellement un substituant,
R"' représente un groupe hydrocarboné et ce groupe hydrocarboné a éventuellement un substituant, et
a3 représente un entier de 1 ou plus :

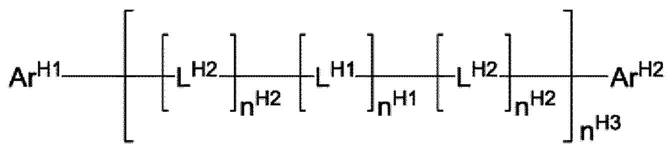

(H-1)

où

$Ar^{H1}$ et $Ar^{H2}$ représentent chacun indépendamment un groupe aryle ou un groupe hétérocyclique monovalent et ces groupes ont chacun éventuellement un substituant,
$n^{H1}$ et $n^{H2}$ représentent chacun indépendamment 0 ou 1, et lorsqu'une pluralité de $n^{H1}$ sont présents, ils peuvent être identiques ou différents, et la pluralité de $n^{H2}$ peuvent être identiques ou différents,
$n^{H3}$ représente un entier de 0 ou plus,
$L^{H1}$ représente un groupe arylène, un groupe hétérocyclique divalent ou un groupe représenté par $-[C(R^{H11})_2]n^{H11}-$ et ces groupes ont chacun éventuellement un substituant, et lorsqu'une pluralité de $L^{H1}$ sont présents, ils peuvent être identiques ou différents,
$n^{H11}$ représente un entier de 1 ou plus et de 10 ou moins, et $R^{H11}$ représente un atome d'hydrogène, un groupe alkyle, un groupe cycloalkyle, un groupe alcoxy, un groupe cycloalcoxy, un groupe aryle ou un groupe hétérocyclique monovalent et ces groupes ont chacun éventuellement un substituant, et la pluralité de $R^{H11}$ peuvent être identiques ou différents et peuvent combinés ensemble pour former un cycle conjointement aux atomes de carbone auxquels ils sont attachés,
$L^{H2}$ représente un groupe représenté par -N(-$L^{H21}$-$R^{H21}$)-, et lorsqu'une pluralité de $L^{H2}$ sont présents, ils peuvent être identiques ou différents, et
$L^{H21}$représente une liaison simple, un groupe arylène ou un groupe hétérocyclique divalent et ces groupes peuvent chacun éventuellement avoir un substituant, et $R^{H21}$ représente un atome d'hydrogène, un groupe cycloalkyle, un groupe aryle ou un groupe hétérocyclique monovalent et ces groupes ont chacun éventuellement un substituant.

**2.** Dispositif émetteur de lumière selon la revendication 1, dans lequel RB (eV) et RA (eV) satisfont la formule (5A) suivante :

$$RB - RA \geq 0{,}2 \qquad (5A).$$

**3.** Dispositif émetteur de lumière selon la revendication 1 ou 2, dans lequel Q (eV) et RA (eV) satisfont la formule (6A) suivante :

$$RA - Q \geq 0{,}2 \qquad (6A).$$

**4.** Dispositif émetteur de lumière selon la revendication 1, dans lequel le groupe représenté par la formule (2) est un groupe représenté par la formule (2') :

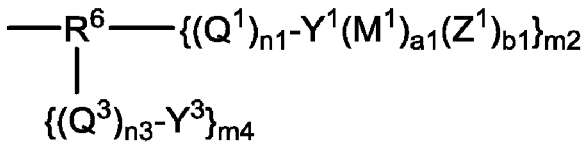

(2')

où

$R^6$ représente un groupe hydrocarboné aromatique ou un groupe hétérocyclique et ces groupes ont chacun éventuellement un substituant, et
n1, a1, b1, m2, $Q^1$, $Y^1$, $M^1$, $Z^1$, n3, m4, $Q^3$ et $Y^3$ représentent le même sens que décrit plus haut.

**5.** Dispositif émetteur de lumière selon la revendication 1, dans lequel le groupe représenté par la formule (3) est un groupe représenté par la formule (3') :

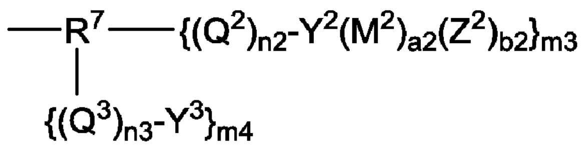

(3')

où

$R^7$ représente un groupe hydrocarboné aromatique ou un groupe hétérocyclique et ces groupes ont chacun éventuellement un substituant, et
n2, a2, b2, m3, $Q^2$, $Y^2$, $M^2$, $Z^2$, n3, m4, $Q^3$ et $Y^3$ représentent le même sens que décrit plus haut.

**6.** Dispositif émetteur de lumière selon la revendication 1, dans lequel le composé représenté par la formule (H-1) est un groupe représenté par la formule (H-2) :

$$Ar^{H1} - \left[ L^{H1} \right]_{n^{H3}} - Ar^{H2} \qquad \textbf{(H-2)}$$

où $Ar^{H1}$, $Ar^{H2}$, $n^{H3}$ et $L^{H1}$ représentent le même sens que décrit plus haut.

**7.** Procédé de production du dispositif émetteur de lumière selon la revendication 1, comprenant l’étape consistant à former au mois un élément choisi dans le groupe constitué par une couche de transport d’électrons (A), une couche de transport d’électrons (B) et une cathode par application.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2003530676 W
- JP 2006173588 A
- EP 2592671 A1
- JP 2012033845 A
- WO 2009131255 A
- JP 2013147551 A
- JP 2010189630 A
- WO 2013191088 A
- WO 2012086671 A
- JP 2011174061 A
- WO 2002045184 A
- JP 2008106241 A
- JP 2003226744 A
- JP 2012036381 A


### Non-patent literature cited in the description


- *Chemical Review (Chem. Rev.),* 2009, vol. 109, 897-1091
- *Chem. Rev.,* 2009, vol. 109, 897-1091
- *The Journal of Physical Chemistry C,* 2004, vol. 118, 2375-2384
- *Journal of Materials Chemistry,* 2011, vol. 21, 14604-10609